# EUROPEAN PATENT APPLICATION

(11) **EP 4 848 959 A1**
(43) Date of publication of application: **02.12.2026**
(21) Application number: 25878853.8
(22) Date of filing: 04.09.2025
(51) Int. Cl.: H10K 59/131, H10K 71/00

(54) **DISPLAY SUBSTRATE AND PREPARATION METHOD THEREFOR, AND DISPLAY APPARATUS**

(30) Priority: 15.10.2024 CN 202411441730
(71) Applicant: BOE Technology Group Co., Ltd., Beijing 100015 (CN); Beijing BOE Technology Development Co., Ltd., Daxing District Beijing 100176 (CN)
(72) Inventor: TAO, Xuan, Beijing 100176 (CN); WANG, Yanli, Beijing 100176 (CN); LIU, Lang, Beijing 100176 (CN); GAO, Zihan, Beijing 100176 (CN); HAO, Xueguang, Beijing 100176 (CN); WANG, Jingquan, Beijing 100176 (CN); QIAO, Yong, Beijing 100176 (CN)
(74) Representative: Durán-Corretjer, S.L.P.
(86) International application number: PCT/CN2025/119066
(87) International publication number: WO 2026/081715

(57) **Abstract**

A display substrate and a preparation method therefor, and a display apparatus. The display substrate comprises a driving structure layer. The driving structure layer comprises a plurality of repeating units (Q), wherein an insertion column is disposed between adjacent columns of repeating units; and at least one repeating unit (Q) comprises a plurality of circuit units, and at least one circuit unit comprises a pixel driving circuit and a data signal line (70). The driving structure layer further comprises first connecting lines (81), second connecting lines (82), first constant-voltage traces (91) and second constant-voltage traces (92), wherein first ends of the first connecting lines (81) are connected to the data signal lines (70), second ends of the first connecting lines (81) are connected to the second connecting lines (82), and at least one second constant-voltage trace (92) is connected to at least one first constant-voltage trace (91), so as to form a mesh-connected structure for transmitting a constant-voltage signal; and the second connecting lines (82) and the second constant-voltage traces (92) are disposed in the insertion columns.

## Description

The present application claims the priority to Chinese Patent Application No. 202411441730.5 filed to the CNIPA on October 15, 2024 and entitled "Display Substrate and Preparation Method Therefor, and Display Apparatus", contents of which should be construed as being incorporated into the present application by reference.

### Technical Field

The present disclosure relates to, but is not limited to, the field of display technologies, and particularly to a display substrate and a preparation method therefor, and a display apparatus.

### Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, flexibility, and a low cost, etc. With constant development of display technologies, a flexible display apparatus (Flexible Display) in which an OLED or a QLED is used as a light emitting device and signal control is performed through a Thin Film Transistor (TFT) has become a mainstream product in the field of display at present.

### Summary

The following is a summary of subject matters described herein in detail. This summary is not intended to limit the protection scope of claims.

In one aspect, the present disclosure provides a display substrate including a drive structure layer disposed on a base substrate; the drive structure layer includes a plurality of repeating units forming a plurality of repeating unit rows and a plurality of repeating unit columns, and an insertion column is disposed between adjacent repeating unit columns; at least one repeating unit includes a plurality of circuit units disposed sequentially along a first direction, and at least one circuit unit includes a pixel drive circuit and a data signal line extending along a second direction, the data signal line is connected with the pixel drive circuit and is configured to supply a data signal to the pixel drive circuit, and the first direction intersects with the second direction; the drive structure layer further includes at least one first connection line and at least one first constant voltage trace that extend along the first direction, and at least one second connection line and at least one second constant voltage trace that extend along the second direction, a first end of the first connection line is connected with the data signal line, a second end of the first connection line is connected with the second connection line, and at least one second constant voltage trace is connected with at least one first constant voltage trace to form a mesh-like communication structure for transmitting a constant voltage signal; and the second connection line and the second constant voltage trace are disposed in the insertion column.

In an exemplary implementation mode, the at least one repeating unit includes three circuit units.

In an exemplary implementation mode, the pixel drive circuit at least includes: a storage capacitor, a first transistor serving as a first initialization transistor, and a second transistor serving as a compensation transistor, the first transistor at least includes a first gate electrode and a first active layer, the second transistor at least includes a second gate electrode and a second active layer, and the storage capacitor includes a first electrode plate and a second electrode plate, an orthographic projection of the second electrode plate on the base substrate is at least partially overlapped with an orthographic projection of the first electrode plate on the base substrate, the first electrode plate is connected with a second region of the first active layer and a first region of the second active layer, and the second electrode plate is connected with a first power supply line; the at least one circuit unit further includes a shield electrode connected with the second electrode plate, an orthographic projection of the shield electrode on the base substrate is at least partially overlapped with an orthographic projection of the first active layer between two gate electrodes of the first transistor on the base substrate, and is at least partially overlapped with an orthographic projection of the second active layer between two gate electrodes of the second transistor on the base substrate; and an orthographic projection of the at least one second connection line on the base substrate is at least partially overlapped with the orthographic projection of the shield electrode on the base substrate.

In an exemplary implementation mode, the pixel drive circuit further includes a third transistor serving as a drive transistor and a fourth transistor serving as a data writing transistor, the third transistor at least includes a third active layer, and the fourth transistor at least includes a fourth active layer, and a first region of the third active layer is connected with a second region of the fourth active layer; the at least one circuit unit further includes a compensation electrode connected with the second electrode plate, and an orthographic projection of the compensation electrode on the base substrate is at least partially overlapped with an orthographic projection of a connection region between the first region of the third active layer and the second region of the fourth active layer on the base substrate.

In an exemplary implementation mode, the pixel drive circuit further includes a fourth transistor serving as a data writing transistor, the second gate electrode is connected with a first scan signal line extending along the first direction, a gate electrode of the fourth transistor is connected with a second scan signal line extending along the first direction, a first electrode of the fourth transistor is connected with the data signal line, and the second scan signal line is disposed at a side of the first scan signal line away from the second electrode plate; and in the second direction, the first connection line and the first constant voltage trace are disposed between the first scan signal line and the second electrode plate, or between the first scan signal line and the second scan signal line.

In an exemplary implementation mode, the at least one circuit unit further includes a data connection electrode, the data signal line is connected with the data connection electrode through a via, and the data connection electrode is connected with the first electrode of the fourth transistor through a via; and the at least one repeating unit further includes a data connection block, the data connection block is connected with the first connection line and the data connection electrode in one circuit unit, respectively, and the data connection block is disposed at a side of the first scan signal line close to the second electrode plate.

In an exemplary implementation mode, the at least one repeating unit further includes a data connection block connected with the first connection line, the data connection block is connected with the first electrode of the fourth transistor in one circuit unit through a via, the data signal line is connected with the data connection block through a via, and the data connection block is disposed at a side of the first scan signal line away from the second electrode plate.

In an exemplary implementation mode, the pixel drive circuit further includes a fifth transistor serving as a first light emitting control transistor, a gate electrode of the fifth transistor is connected with a light emitting signal line, and a first electrode of the fifth transistor is connected with the first power supply line, the light emitting signal line is disposed at a side of the second electrode plate in the second direction; and in the second direction, the first connection line and the first constant voltage trace are disposed at a side of the light emitting signal line away from the second electrode plate.

In an exemplary implementation mode, the display substrate further includes a light emitting structure layer disposed at a side of the drive structure layer away from the base substrate, and the light emitting structure layer at least includes a red light emitting unit, a green light emitting unit, and a blue light emitting unit, the red light emitting unit at least includes a first anode, the green light emitting unit at least includes a second anode, and the blue light emitting unit at least includes a third anode; orthographic projections of at least one first anode and at least one second anode on the base substrate are at least partially overlapped with an orthographic projection of the second connection line or the second constant voltage trace on the base substrate, and an orthographic projection of at least one third anode on the base substrate is at least partially overlapped with an orthographic projection of the data signal line on the base substrate.

In an exemplary implementation mode, at least one third anode is provided with an anode groove, a shape of the anode groove is a strip portion extending along the second direction, and an orthographic projection of the anode groove on the base substrate is at least partially overlapped with an orthographic projection of the data signal line on the base substrate.

In an exemplary implementation mode, at least one insertion column is further provided with at least one constant voltage connection line extending along the second direction; and in the first direction, the constant voltage connection line is disposed between the second connection line and the data signal line, or between the second constant voltage trace and the data signal line.

In an exemplary implementation mode, the at least one circuit unit further includes a first initial signal line, a second initial signal line, and a third initial signal line that extend along the first direction, and the pixel drive circuit is connected with the first initial signal line, the second initial signal line, and the third initial signal line, respectively, the first initial signal line, the second initial signal line, and the third initial signal line are configured to supply a first initial signal, a second initial signal, and a third initial signal to the pixel drive circuit, respectively; and the at least one constant voltage connection line is connected with the first initial signal line, the second initial signal line, or the third initial signal line.

In an exemplary implementation mode, the display substrate further includes a light emitting structure layer disposed at a side of the drive structure layer away from the base substrate, the light emitting structure layer includes a plurality of light emitting units, and at least one light emitting unit includes a light emitting device connected with a second power supply line, the second power supply line is configured to supply a second power supply signal to the light emitting device; the at least one circuit unit further includes a first initial signal line, a second initial signal line, and a third initial signal line that extend along the first direction, and a first power supply line extending along the second direction, the pixel drive circuit is connected with the first initial signal line, the second initial signal line, the third initial signal line, and the first power supply line respectively, the first initial signal line, the second initial signal line, and the third initial signal line are configured to supply a first initial signal, a second initial signal, and a third initial signal to the pixel drive circuit respectively, and the first power supply line is configured to supply a first power supply signal to the pixel drive circuit; and the second constant voltage trace is connected with any one or more of following: the first initial signal line, the second initial signal line, the third initial signal line, the first power supply line, or the second power supply line.

In an exemplary implementation mode, the display substrate is divided into a plurality of sub-regions, the second constant voltage trace in one sub-region of the sub-regions is connected with the first initial signal line, the second constant voltage trace in another sub-region of the sub-regions is connected with the second initial signal line, and the second constant voltage trace in yet another sub-region of the sub-regions is connected with the third initial signal line, simultaneously forming a mesh-like communication structure for transmitting a first initial signal, a mesh-like communication structure for transmitting a second initial signal, and a mesh-like communication structure for transmitting a third initial signal.

In an exemplary implementation mode, a plurality of second constant voltage traces are connected with the first initial signal line, the second initial signal line, and the third initial signal line, respectively, and in the first direction, the second constant voltage trace connected with the first initial signal line, the second constant voltage trace connected with the second initial signal line, and the second constant voltage trace connected with the third initial signal line are arranged periodically.

In an exemplary implementation mode, a plurality of second constant voltage traces are connected with the first initial signal line, the second initial signal line, the third initial signal line, and the second power supply line respectively, and in the first direction, the second constant voltage trace connected with the first initial signal line, the second constant voltage trace connected with the second power supply line, the second constant voltage trace connected with the second initial signal line, the second constant voltage trace connected with the second power supply line, the second constant voltage trace connected with the third initial signal line, and the second constant voltage trace connected with the second power supply line are arranged periodically.

In an exemplary implementation mode, the second constant voltage trace located in a same insertion column as the second connection line is connected with the first power supply line or the second power supply line, and the second constant voltage trace separately disposed in the insertion column is connected with the first initial signal line, the second initial signal line, or the third initial signal line.

In an exemplary implementation mode, in a direction perpendicular to the base substrate, the display substrate includes a plurality of conductive layers, the second constant voltage trace, the first constant voltage trace, and at least one initial signal line are disposed in different conductive layers, one part of second constant voltage traces is connected with the first constant voltage trace, and the other part of the second constant voltage traces is connected with the initial signal line.

In another aspect, a display apparatus is further provided in the present disclosure, and the display apparatus includes the display substrate described above.

In yet another aspect, the present disclosure further provides a preparation method of a display substrate, including: forming a drive structure layer on a base substrate; wherein the drive structure layer includes a plurality of repeating units forming a plurality of repeating unit rows and a plurality of repeating unit columns, and an insertion column is disposed between adjacent repeating unit columns; at least one repeating unit includes a plurality of circuit units disposed sequentially along a first direction, and at least one circuit unit includes a pixel drive circuit and a data signal line extending along a second direction, the data signal line is connected with the pixel drive circuit and is configured to supply a data signal to the pixel drive circuit, and the first direction intersects with the second direction; the drive structure layer further includes at least one first connection line and at least one first constant voltage trace that extend along the first direction, and at least one second connection line and at least one second constant voltage trace that extend along the second direction, a first end of the first connection line is connected with the data signal line, a second end of the first connection line is connected with the second connection line, and at least one second constant voltage trace is connected with at least one first constant voltage trace to form a mesh-like communication structure for transmitting a constant voltage signal; and the second connection line and the second constant voltage trace are disposed in the insertion column.

After drawings and detailed description are read and understood, other aspects may be understood.

### Brief Description of Drawings

Accompanying drawings are used to provide an understanding of technical solutions of the present disclosure, and constitute a part of the specification. The accompanying drawings, together with embodiments of the present disclosure, are adopted to explain the technical solutions of the present disclosure, and do not constitute limitations on the technical solutions of the present disclosure.
FIG. 1 is a schematic diagram of a structure of a display apparatus.
FIG. 2 is a schematic diagram of a structure of a display substrate.
FIG. 3A and FIG. 3B are schematic diagrams of a planar structure of a display region in a display substrate.
FIG. 4 is a schematic diagram of a cross-sectional structure of a display region in a display substrate.
FIG. 5A and FIG. 5B are equivalent circuit diagrams of a pixel drive circuit.
FIG. 6 is a schematic diagram of a planar structure of a display substrate according to an exemplary embodiment of the present disclosure.
FIG. 7 is a schematic diagram of an arrangement of data connection lines according to an exemplary embodiment of the present disclosure.
FIG. 8 is a schematic diagram of a structure of a data connection line and a constant voltage trace according to an exemplary embodiment of the present disclosure.
FIG. 9A to FIG. 9D are schematic diagrams of a structure of a display substrate according to an exemplary embodiment of the present disclosure.
FIG. 10 is a schematic diagram of a display substrate after a pattern of a semiconductor layer is formed according to the present disclosure.
FIG. 11A and FIG. 11B are schematic diagrams of a display substrate after a pattern of a first conductive layer is formed according to the present disclosure.
FIG. 12A and FIG. 12B are schematic diagrams of a display substrate after a pattern of a second conductive layer is formed according to the present disclosure.
FIG. 13 is a schematic diagram of a display substrate after a pattern of a fourth insulation layer is formed according to the present disclosure.
FIG. 14A to FIG. 14D are schematic diagrams of a display substrate after a pattern of a third conductive layer is formed according to the present disclosure.
FIG. 15A and FIG.15B are schematic diagrams of a display substrate after a pattern of a first planarization layer is formed according to the present disclosure.
FIG. 16A to FIG. 16D are schematic diagrams of a display substrate after a pattern of a fourth conductive layer is formed according to the present disclosure.
FIG. 17 is a schematic diagram of a display substrate after a pattern of a second planarization layer is formed according to the present disclosure.
FIG. 18A and FIG. 18B are schematic diagrams of a display substrate after a pattern of an anode conductive layer is formed according to the present disclosure.
FIG. 19 is a schematic diagram of a structure of another display substrate according to an embodiment of the present disclosure.
FIG. 20 is a schematic diagram of a structure of yet another display substrate according to an embodiment of the present disclosure.
FIG. 21 is a schematic diagram of a structure of yet another display substrate according to an embodiment of the present disclosure.
FIG. 22 is a schematic diagram of a structure of yet another display substrate according to an embodiment of the present disclosure.
FIG. 23 is a schematic diagram of a structure of yet another display substrate according to an embodiment of the present disclosure.
FIG. 24 is a schematic diagram of a structure of yet another display substrate according to an embodiment of the present disclosure.
FIG. 25 is a schematic diagram of a structure of yet another display substrate according to an embodiment of the present disclosure.
FIG. 26 is a schematic diagram of a structure of yet another display substrate according to an embodiment of the present disclosure.
FIG. 27 is a schematic diagram of a structure of yet another display substrate according to an embodiment of the present disclosure.
FIG. 28 is a schematic diagram of another structure of a data connection line and a constant voltage trace according to an exemplary embodiment of the present disclosure.
FIG. 29 is a schematic diagram of yet another structure of a data connection line and a constant voltage trace according to an exemplary embodiment of the present disclosure.
FIG. 30 is a schematic diagram of yet another structure of a data connection line and a constant voltage trace according to an exemplary embodiment of the present disclosure.

Reference signs are described as follows.

| | | | | | |
|---|---|---|---|---|---|
| 10- | first active connection line; | 11- | first active layer; | 12- | second active layer; |
| 13- | third active layer; | 14- | fourth active layer; | 15- | fifth active layer; |
| 16- | sixth active layer; | 17- | seventh active layer; | 18- | eighth active layer; |
| 19- | active connection strip; | 21- | first gate electrode; | 22- | second gate electrode; |
| 24- | fourth gate electrode; | 25- | first electrode plate; | 26- | second electrode plate; |
| 27- | compensation electrode; | 28- | shield electrode; | 30- | third active connection line; |
| 31- | first scan signal line; | 32- | second scan signal line; | 33- | third scan signal line; |
| 34- | fourth scan signal line; | 35- | light emitting control line; | 36- | scan connection line; |
| 37- | repair line; | 41- | first initial signal line; | 42- | second initial signal line; |
| 43- | third initial signal line; | 51- | first connection electrode; | 52- | second connection electrode; |
| 53- | third connection electrode; | 54- | fourth connection electrode; | 55- | fifth connection electrode; |
| 56- | sixth connection electrode; | 57- | seventh connection electrode; | 58- | eighth connection electrode; |
| 61- | first power supply line; | 62- | power supply connection line; | 63- | anode connection electrode; |
| 70- | data signal line; | 80- | data connection line; | 81- | first connection line; |
| 82- | second connection line; | 83- | dummy connection block; | 84- | data connection block; |
| 90- | lateral trace; | 91- | first constant voltage trace; | 92- | second constant voltage trace; |
| 93- | constant voltage connection line; | 94- | fourth connection block; | 95- | fifth connection block; |
| 100- | display region; | 101- | base substrate; | 102- | drive structure layer; |
| 103- | light emitting structure layer; | 104- | encapsulation structure layer; | 110- | first region; |
| 120- | second region; | 200- | bonding region; | 300- | bezel region. |

### Detailed Description

To make objectives, technical solutions, and advantages of the present disclosure clearer, the embodiments of the present disclosure will be described in detail below with reference to the accompanying drawings. It is to be noted that implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third" and the like in the specification are set not to form limits in quantities but only to avoid confusion between constituent elements.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that a referred apparatus or element must have a specific orientation or be structured and operated in the specific orientation but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, hexagon, or the like in the specification is not strictly defined, and it may be an approximate triangle, rectangle, trapezoid, pentagon, hexagon, or the like. There may be some small deformations caused by tolerance, and there may be a chamfer, an arc edge, deformation, etc.

In the present disclosure, "about" means that a boundary is not defined so strictly and numerical values within process and measurement error ranges are allowed.

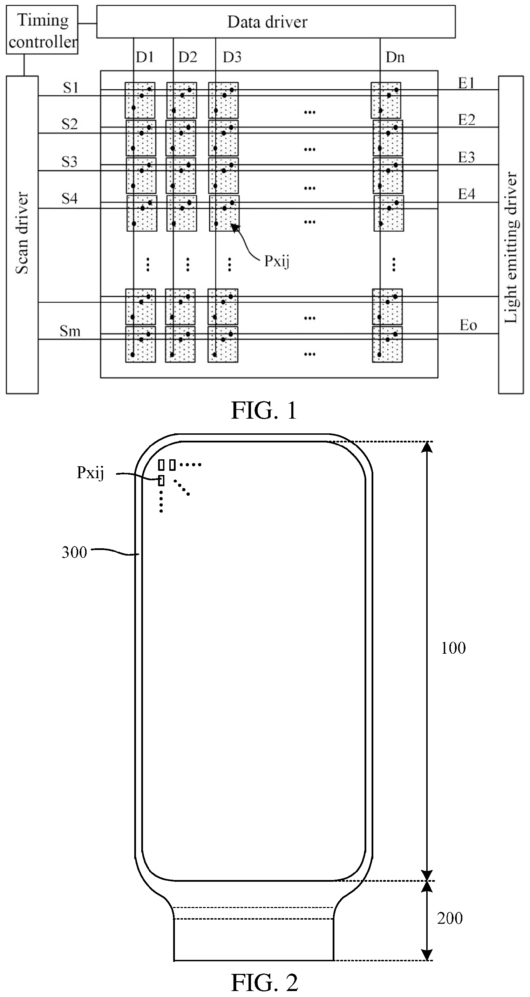

FIG. 1 is a schematic diagram of a structure of a display apparatus. As shown in FIG.1, the display apparatus may include a timing controller, a data driver, a scan driver, a light emitting driver, and a pixel array. The timing controller is connected with the data driver, the scan driver, and the light emitting driver, respectively, the data driver is connected with a plurality of data signal lines (D1 to Dn) respectively, the scan driver is connected with a plurality of scan signal lines (S1 to Sm) respectively, and the light emitting driver is connected with a plurality of light emitting signal lines (E1 to Eo) respectively. The pixel array may include a plurality of sub-pixels Pxij, i and j may be natural numbers, at least one sub-pixel Pxij may include a circuit unit and a light emitting unit, the circuit unit may include, at least, a pixel drive circuit connected with a scan signal line, a light emitting signal line, and a data signal line, respectively. The light emitting unit may include a light emitting device connected with the pixel drive circuit of the circuit unit. In an exemplary implementation mode, the timing controller may provide the data driver with a grayscale value and a control signal which are suitable for a specification of the data driver, provide the scan driver with a clock signal and a scan start signal and the like which are suitable for a specification of the scan driver, and provide the light emitting driver with a clock signal and an emission stop signal and the like which are suitable for a specification of the light emitting driver. The data driver may generate a data voltage to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal and the scan start signal and the like from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number. In an exemplary implementation mode, the pixel array may be disposed on a display substrate.

FIG. 2 is a schematic diagram of a structure of a display substrate. As shown in FIG. 2, the display substrate may include a display region 100, a bonding region 200 located at a side of the display region 100, and a bezel region 300 located at other sides of the display region 100. In an exemplary implementation mode, the display region 100 may be a flat region, including multiple sub-pixels Pxij that form a pixel array, wherein the multiple sub-pixels Pxij are configured to display a dynamic picture or a static image, and the display region 100 may be referred to as an Active Area (AA). In an exemplary implementation mode, the display substrate may be a flexible substrate, so that the display substrate may be deformable, for example, be curled, bent, folded, or rolled.

In an exemplary implementation mode, the bonding region 200 may include a leading-out line region, a bending region, a drive chip region, and a bonding pin region, which are sequentially disposed along a direction away from the display region, and the leading-out line region is connected to the display region 100, and at least includes a data leading-out line. The bending region is connected to the leading-out line region and may at least include a composite insulation layer provided with a groove, the groove is configured to enable the bonding region to be bent to a back of the display region. The drive chip region may include an Integrated Circuit (IC for short), and the Integrated Circuit is configured to be connected with a plurality of data leading-out lines. The bonding pin region may include a Bonding Pad, and the Bonding Pad is configured to be bonded and connected with an external Flexible Printed Circuit (FPC for short).

In an exemplary implementation mode, the bezel region 300 may include a circuit region, a power supply line region, a crack dam region, and a cutting region which are sequentially disposed along the direction away from the display region 100. The circuit region is connected to the display region100 and may at least include a gate drive circuit connected with scan signal lines and light emitting signal lines in the display region 100. The power supply line region is connected to the circuit region and may at least include a bezel power supply lead, wherein the bezel power supply lead extends along a direction parallel to an edge of the display region and is connected with a cathode in the display region 100. The crack dam region is connected to the power supply line region and may at least include a plurality of cracks disposed on the composite insulation layer. The cutting region is connected to the crack dam region and may at least include a cutting groove disposed on the composite insulation layer, wherein the cutting groove is configured for respectively cutting along the cutting groove by a cutting device after all film layers of the display substrate are prepared.

In an exemplary implementation mode, the leading-out line region in the bonding region 200 and the power supply line region in the bezel region 300 may be provided with a dam spacer, the dam spacer may extend along a direction parallel to an edge of the display region to form an annular structure surrounding the display region 100, wherein the edge of the display region is an edge of the display region at a side of the bonding region or the bezel region.

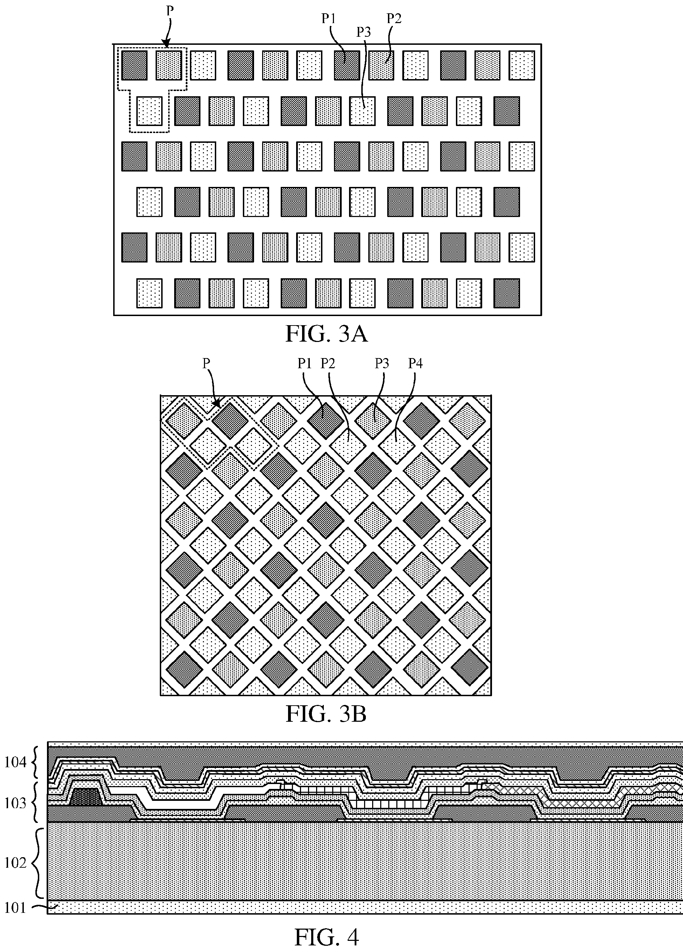

FIG. 3A is a schematic diagram of a planar structure of a display region in a display substrate. As shown in FIG. 3A, the display region may include a plurality of pixel units P arranged in a matrix, and at least one of the pixel units P may include a first sub-pixel P1, a second sub-pixel P2, and a third sub-pixel P3. Each sub-pixel may include a circuit unit and a light emitting unit. The circuit unit may at least include a pixel drive circuit, the pixel drive circuit is connected with a scan signal line, a light emitting signal line, and a data signal line respectively, and the pixel drive circuit is configured to receive a data voltage transmitted by the data signal line and output a corresponding current to the light emitting unit under control of the scan signal line and the light emitting signal line. The light emitting unit may include a light emitting device connected with a pixel drive circuit of a sub-pixel where the light emitting device is located, and the light emitting device is configured to emit light with corresponding brightness in response to a current output by the pixel drive circuit of the sub-pixel where the light emitting device is located.

In an exemplary implementation mode, the first sub-pixel P1 may be a red sub-pixel (R) emitting red light, the second sub-pixel P2 may be a green sub-pixel (G) emitting green light, and the third sub-pixel P3 may be a blue sub-pixel (B) emitting blue light. In an exemplary implementation mode, a sub-pixel may be in a shape of a rectangle, a diamond, a pentagon, or a hexagon, and three sub-pixels may be arranged in a Real RGB manner.

FIG. 3B is a schematic diagram of a planar structure of a display region in another display substrate. As shown in FIG. 3B, the pixel unit P may include four sub-pixels, wherein a first sub-pixel P1 may be a red sub-pixel that emits red light, a second sub-pixel P2 and a fourth sub-pixel P4 may be green sub-pixels (G) that emit green light, a third sub-pixel P3 may be a blue sub-pixel (B) that emits blue light, and the four sub-pixels may be arranged in an RGBG manner.

FIG. 4 is a schematic diagram of a cross-sectional structure of a display region in a display substrate, illustrating a structure of three sub-pixels in the display region. As shown in FIG. 4, on a plane perpendicular to the display substrate, the display region may include a drive structure layer 102 disposed on a base substrate 101, a light emitting structure layer 103 disposed at a side of the drive structure layer 102 away from the base substrate 101, and an encapsulation structure layer 104 disposed at a side of the light emitting structure layer 103 away from the base substrate 101. In some possible implementation modes, the display region may include other film layers, such as a touch structure layer, which is not limited here in the present disclosure.

In an exemplary implementation mode, the base substrate 101 may be a flexible base substrate, or may be a rigid base substrate. The drive structure layer 102 may include a plurality of circuit units, each circuit unit may at least include a pixel drive circuit formed by a plurality of transistors and a storage capacitor. The light emitting structure layer 103 may include a plurality of light emitting units. Each light emitting unit may include a light emitting device, and the light emitting device may at least include an anode, an organic emitting layer, and a cathode. The anode is connected with a pixel drive circuit. The organic emitting layer is connected with the anode. The cathode is connected with the organic emitting layer. The organic emitting layer emits light of a corresponding color under drive of the anode and the cathode. The encapsulation structure layer 104 may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer to form a stacked structure of an inorganic material/an organic material/an inorganic material, which may ensure that external moisture cannot enter the light emitting structure layer 103.

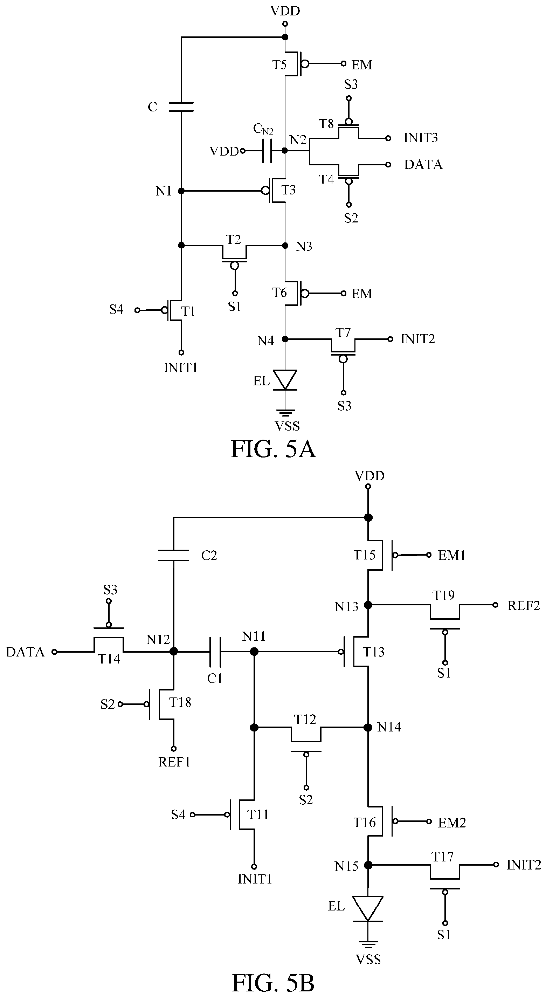

FIG. 5A is an equivalent circuit diagram of a pixel drive circuit. As shown in FIG. 5A, the pixel drive circuit may include eight transistors (a first transistor T1 to an eighth transistor T8) and one storage capacitor C, and the pixel drive circuit is connected with 10 signal lines (a first scan signal line S1, a second scan signal line S2, a third scan signal line S3, a fourth scan signal line S4, a light emitting signal line EM, a first initial signal line INIT1, a second initial signal line INIT2, a third initial signal line INIT3, a data signal line DATA, and a first power supply line VDD) respectively.

In an exemplary implementation mode, the pixel drive circuit may include a first node N1, a second node N2, a third node N3, and a fourth node N4. Herein, the first node N1 is connected with a second electrode of the first transistor, a first electrode of the second transistor T2, a gate electrode of the third transistor T3, and a first terminal of the storage capacitor C, respectively, the second node N2 is connected with a first electrode of the third transistor T3, a second electrode of the fourth transistor T4, a second electrode of the fifth transistor T5, and a second electrode of the eighth transistor T8, respectively, the third node N3 is connected with a second electrode of the second transistor T2, a second electrode of the third transistor T3, and a first electrode of the sixth transistor T6, respectively, and the fourth node N4 is connected with a second electrode of the sixth transistor T6 and a second electrode of the seventh transistor T7, respectively.

In an exemplary implementation mode, the first terminal of the storage capacitor C is connected with the first node N1, and a second terminal of the storage capacitor C is connected with the first power supply line VDD.

In an exemplary implementation mode, a gate electrode of the first transistor T1 is connected with the fourth scan signal line S4, a first electrode of the first transistor T1 is connected with the first initial signal line INIT1, and the second electrode of the first transistor is connected with the first node N1.

In an exemplary implementation mode, a gate electrode of the second transistor T2 is connected with the first scan signal line S1, the first electrode of the second transistor T2 is connected with the first node N1, and the second electrode of the second transistor T2 is connected with the third node N3.

In an exemplary implementation mode, the gate electrode of the third transistor T3 is connected with the first node N1, the first electrode of the third transistor T3 is connected with the second node N2, and the second electrode of the third transistor T3 is connected with the third node N3.

In an exemplary implementation mode, a gate electrode of the fourth transistor T4 is connected with the second scan signal line S2, a first electrode of the fourth transistor T4 is connected with the data signal line DATA, and the second electrode of the fourth transistor T4 is connected with the second node N2.

In an exemplary implementation mode, a gate electrode of the fifth transistor T5 is connected with the light emitting signal line EM, a first electrode of the fifth transistor T5 is connected with the first power supply line VDD, and the second electrode of the fifth transistor T5 is connected with the second node N2.

In an exemplary implementation mode, a gate electrode of the sixth transistor T6 is connected with the light emitting signal line EM, the first electrode of the sixth transistor T6 is connected with the third node N3, and the second electrode of the sixth transistor T6 is connected with the fourth node N4.

In an exemplary implementation mode, a gate electrode of the seventh transistor T7 is connected with the third scan signal line S3, a first electrode of the seventh transistor T7 is connected with the second initial signal line INIT2, and the second electrode of the seventh transistor T7 is connected with the fourth node N4.

In an exemplary implementation mode, a gate electrode of the eighth transistor T8 is connected with the third scan signal line S3, a first electrode of the eighth transistor T8 is connected with the third initial signal line INIT3, and the second electrode of the eighth transistor T8 is connected with the second node N2.

In an exemplary implementation mode, the pixel drive circuit may further include a second node capacitor C_{N2}, one terminal of the second node capacitor C_{N2} is connected with the second node N2, and the other terminal of the second node capacitor C_{N2} is connected with the first power supply line VDD. In an exemplary implementation mode, the second node capacitor C_{N2} may have an effect of stabilizing a voltage of the second node N2.

In an exemplary implementation mode, the pixel drive circuit may realize normal drive and low-frequency drive, and low-frequency refresh may be adopted in a scenario where a refresh rate is not required to be high to save power consumption. In normal drive, a drive timing of the pixel drive circuit may include following four stages: initialization, compensation, data writing, and light emission, and in low frequency drive, the drive timing of the pixel drive circuit may include following six stages: initialization, compensation, data writing, light emission, adjustment, and light emission again. In the adjustment stage, a third initial signal (bias voltage) is written into the first electrode of the third transistor T3 by using the eighth transistor T8, which may enable a bias state of the third transistor T3 to be maintained consistent with a bias state when a data signal is just written, which not only may improve stability of an operating state of a drive transistor and improve low-frequency flicker, but also may effectively improve hysteresis of the third transistor, which is beneficial for improvement of afterimage and improvement of a display effect.

In an exemplary implementation mode, a first electrode of a light emitting device EL is connected with the fourth node N4, and a second electrode of the light emitting device EL is connected with a second power supply line VSS. The light emitting device EL may be an OLED, including a first electrode (an anode), an organic emitting layer, and a second electrode (an cathode) which are stacked, or may be a QLED including a first electrode (an anode), a quantum dot emitting layer, and a second electrode (a cathode) which are stacked.

In an exemplary implementation mode, the first power supply line VDD is configured to provide a constant first power supply signal to the pixel drive circuit, the second power supply line VSS is configured to provide a constant second power supply signal to the light emitting device, wherein a voltage of the first power supply signal is higher than a voltage of the second power supply signal, the first power supply signal is a high-level signal and the second power supply signal is a low-level signal. The first initial signal line INIT1, the second initial signal line INIT2, and the third initial signal line INIT3 are configured to provide a constant first initial signal, a constant second initial signal, and a constant third initial signal to the pixel drive circuit, respectively, and the present disclosure is not limited thereto. In an exemplary implementation mode, the third initial signal may be referred to as a reference signal, and the third initial signal line INIT3 may be referred to as a reference signal line.

In an exemplary implementation mode, the first transistor T1 to the eighth transistors T8 in the pixel drive circuit may be P-type transistors or may be N-type transistors. Use of a same type of transistors in a pixel drive circuit may simplify a process flow, reduce a process difficulty of a display panel, and improve a product yield. In some possible implementation modes, the first transistor T1 to the eighth transistor T8 may include a P-type transistor and an N-type transistor.

In an exemplary implementation mode, for the first transistor T1 to the eighth transistor T8, a low temperature poly-silicon transistor may be adopted, or an oxide transistor may be adopted, or a low temperature poly silicon transistor and an oxide transistor may be adopted. An active layer of a low temperature poly silicon transistor is made of Low Temperature Poly Silicon (LTPS), and an active layer of an oxide transistor is made of an oxide semiconductor (Oxide). The low temperature poly silicon transistor has advantages such as a high migration rate and fast charging, and the oxide transistor has advantages such as a low leakage current. The low temperature poly silicon transistor and the oxide transistor are integrated on one display substrate to form a Low Temperature Polycrystalline + Oxide (LTPO) display substrate, so that advantages of the low temperature poly silicon transistor and the oxide transistor may be utilized, low-frequency drive may be achieved, power consumption may be reduced, and display quality may be improved.

FIG. 5B is an equivalent circuit diagram of another pixel drive circuit. As shown in FIG. 5B, the pixel drive circuit may have a structure of 9T2C, and may include nine transistors (an eleventh transistor T11 to a nineteenth transistor T19) and two storage capacitors (a first capacitor C1 and a second capacitor C2), and the pixel drive circuit is connected with twelve signal lines (a first scan signal line S1, a second scan signal line S2, a third scan signal line S3, a fourth scan signal line S4, a first light emitting signal line EM1, a second light emitting signal line EM2, a first initial signal line INIT1, a second initial signal line INIT2, a first reference signal line REF1, a second reference signal line REF2, a data signal line D, and a first power supply line VDD), respectively.

In an exemplary implementation mode, the pixel drive circuit may include an eleventh node N11, a twelfth node N12, a thirteenth node N13, a fourteenth node N14, and a fifteenth N15. Herein, the eleventh node N11 is connected with a second electrode of the eleventh transistor T11, a first electrode of the twelfth transistor T12, a gate electrode of the thirteenth transistor T13, and a first terminal of the first capacitor C1, respectively. The twelfth node N12 is connected with a second electrode of the fourteenth transistor T14, a second electrode of the eighteenth transistor T18, a second terminal of the first capacitor C1, and a second terminal of the second capacitor C2 respectively. The thirteenth node N13 is connected with a first electrode of the thirteenth transistor T13, a second electrode of the fifteenth transistor T15, and a second electrode of the nineteenth transistor T19 respectively. The fourteenth node N14 is connected with a second electrode of the twelfth transistor T12, a second electrode of the thirteenth transistor T13, and a first electrode of the sixteenth transistor T16 respectively. The fifteenth node N15 is connected with a second electrode of the sixteenth transistor T16 and a second electrode of the seventeenth transistor T17 respectively.

In an exemplary implementation mode, the first terminal of the first capacitor C1 is connected with the eleventh node N11, the second terminal of the first capacitor C1 is connected with the twelfth node N12, a first terminal of the second capacitor C2 is connected with the first power supply line VDD, and the second terminal of the second capacitor C2 is connected with the twelfth node N12.

In an exemplary implementation mode, a gate electrode of the eleventh transistor T11 is connected with the fourth scan signal line S4, a first electrode of the eleventh transistor T11 is connected with the first initial signal line INIT1, and the second electrode of the eleventh transistor T11 is connected with the eleventh node N11.

In an exemplary implementation mode, a gate electrode of the twelfth transistor T12 is connected with the second scan signal line S2, the first electrode of the twelfth transistor T12 is connected with the eleventh node N11, and the second electrode of the twelfth transistor T12 is connected with the fourteenth node N14.

In an exemplary implementation mode, the gate electrode of the thirteenth transistor T13 is connected with the eleventh node N11, the first electrode of the thirteenth transistor T13 is connected with the thirteenth node N13, and the second electrode of the thirteenth transistor T13 is connected with the fourteenth node N14.

In an exemplary implementation mode, a gate electrode of the fourteenth transistor T14 is connected with the third scan signal line S3, a first electrode of the fourteenth transistor T14 is connected with the data signal line DATA, and the second electrode of the fourteenth transistor T14 is connected with the twelfth node N12.

In an exemplary implementation mode, a gate electrode of the fifteenth transistor T15 is connected with the first light emitting signal line EM1, a first electrode of the fifteenth transistor T15 is connected with the first power supply line VDD, and the second electrode of the fifteenth transistor T15 is connected with the thirteenth node N13.

In an exemplary implementation mode, a gate electrode of the sixteenth transistor T16 is connected with the second light emitting signal line EM2, the first electrode of the sixteenth transistor T16 is connected with the fourteenth node N14, and the second electrode of the sixteenth transistor T16 is connected with the fifteenth node N15.

In an exemplary implementation mode, a gate electrode of the seventeenth transistor T17 is connected with the first scan signal line S1, a first electrode of the seventeenth transistor T17 is connected with the second initial signal line INIT2, and the second electrode of the seventeenth transistor T17 is connected with the fifteenth node N15.

In an exemplary implementation mode, a gate electrode of the eighteenth transistor T18 is connected with the second scan signal line S2, a first electrode of the eighteenth transistor T18 is connected with the first reference signal line REF1, and the second electrode of the eighteenth transistor T18 is connected with the twelfth node N12.

In an exemplary implementation mode, a gate electrode of the nineteenth transistor T19 is connected with the first scan signal line S1, a first electrode of the nineteenth transistor T19 is connected with the second reference signal line REF2, and the second electrode of the nineteenth transistor T19 is connected with the thirteenth node N13.

In an exemplary implementation mode, a first electrode of a light emitting device EL is connected with the fifteenth node N15, and a second electrode of the light emitting device EL is connected with a second power supply line VSS.

In an exemplary implementation mode, the eleventh transistor T11 to the nineteenth transistor T19 may all be P-type transistors, or may all be N-type transistors, or may include a P-type transistor and an N-type transistor, and the pixel drive circuit may improve hysteresis of a drive transistor, which is beneficial for improving a display effect.

With development of OLED display technologies, consumers have higher and higher requirements on display effects and display quality. Extremely narrow bezels have become a new trend in development of display products, hence narrowing a bezel or even a borderless design has attracted more and more attention in designs of OLED display products. In a display substrate, a data signal of an integrated circuit in a bonding region needs to be introduced into a relatively wide display region in a fanout manner through a data leading-out line, so that a leading-out line region occupies relatively large space, resulting in a relatively large width of a lower bezel, the lower bezel being always maintained at about 2.0 mm.

In order to reduce a width of a lower bezel, an exemplary embodiment of the present disclosure provides a display substrate, and a Fanout in Panel (FIP) structure is adopted, a plurality of data connection lines are disposed in a display region, one ends of the plurality of data connection lines are correspondingly connected with a plurality of data signal lines in the display region, and the other ends of the plurality of data connection lines extend to a bonding region, and are correspondingly connected with an integrated circuit through a plurality of data leading-out lines in a leading-out line region. Since there is no need to dispose a fan-shaped oblique line in the leading-out line region, a width of the leading-out line region is reduced, and thus the width of the lower bezel is reduced.

An exemplary embodiment of the present disclosure provides a display substrate including a drive structure layer disposed on a base substrate; the drive structure layer includes a plurality of repeating units forming a plurality of repeating unit rows and a plurality of repeating unit columns, and an insertion column is disposed between adjacent repeating unit columns; at least one repeating unit includes a plurality of circuit units disposed sequentially along a first direction, and at least one circuit unit includes a pixel drive circuit and a data signal line extending along a second direction, the data signal line is connected with the pixel drive circuit and is configured to supply a data signal to the pixel drive circuit, and the first direction intersects with the second direction; the drive structure layer further includes at least one first connection line and at least one first constant voltage trace that extend along the first direction, and at least one second connection line and at least one second constant voltage trace that extend along the second direction, a first end of the first connection line is connected with the data signal line, a second end of the first connection line is connected with the second connection line, and at least one second constant voltage trace is connected with at least one first constant voltage trace to form a mesh-like communication structure for transmitting a constant voltage signal; and the second connection line and the second constant voltage trace are disposed in the insertion column.

In an exemplary implementation mode, at least one repeating unit includes three circuit units.

In an exemplary implementation mode, the display substrate further includes a light emitting structure layer disposed at a side of the drive structure layer away from the base substrate, the light emitting structure layer includes a plurality of light emitting units, and at least one light emitting unit includes a light emitting device connected with a second power supply line, the second power supply line being configured to supply a second power supply signal to the light emitting device; the at least one circuit unit further includes a first initial signal line, a second initial signal line, and a third initial signal line that extend along the first direction, and a first power supply line extending along the second direction, the pixel drive circuit is connected with the first initial signal line, the second initial signal line, the third initial signal line, and the first power supply line respectively, the first initial signal line, the second initial signal line, and the third initial signal line are configured to supply a first initial signal, a second initial signal, and a third initial signal to the pixel drive circuit respectively, and the first power supply line is configured to supply a first power supply signal to the pixel drive circuit; and the second constant voltage trace is connected with any one or more of following: the first initial signal line, the second initial signal line, the third initial signal line, the first power supply line, or the second power supply line.

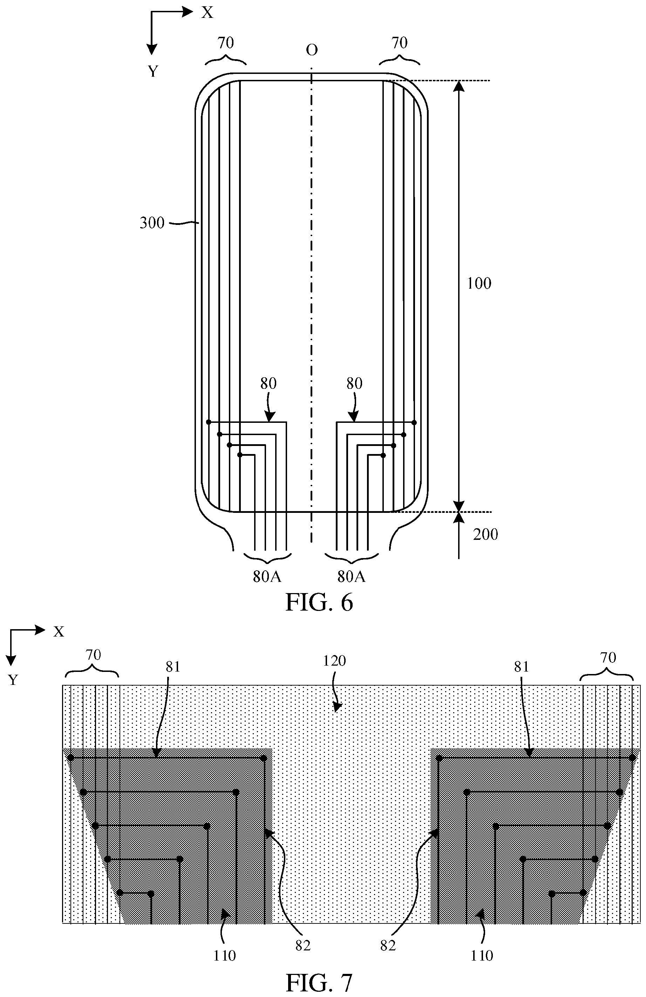

FIG. 6 is a schematic diagram of a planar structure of a display substrate according to an exemplary embodiment of the present disclosure. As shown in FIG. 6, in a plane parallel to a display substrate, the display substrate may at least include a display region 100, a bonding region 200 located at a side of the display region 100, and a bezel region 300 located at other sides of the display region 100. In a plane perpendicular to the display substrate, the display substrate may include a drive structure layer disposed on a base substrate, a light emitting structure layer disposed at a side of the drive structure layer away from the base substrate, and an encapsulation structure layer disposed at a side of the light emitting structure layer away from the base substrate.

In an exemplary implementation mode, the drive structure layer of the display region 100 may include a plurality of pixel drive circuit, a plurality of data signal lines 70, and a plurality of data connection lines 80, wherein a pixel drive circuit is configured to output a corresponding current to a connected light emitting device. The light emitting structure layer of the display region 100 may include a plurality of light emitting devices, a light emitting device is connected with a corresponding pixel drive circuit and is configured to emit light with corresponding brightness in response to a current outputted from the connected pixel drive circuit.

In an exemplary implementation mode, at least one data signal line 70 is connected with at least one pixel drive circuit, and the data signal line 70 is configured to provide a data signal to the connected pixel drive circuit. One end of at least one data connection line 80 is correspondingly connected with the data signal line 70, and the other end of the at least one data connection line 80 is connected with a data leading-out line 80A in the bonding region 200 to realize a connection between the data signal line 70 and the data leading-out line 80A.

In an exemplary implementation mode, the bonding region 200 may include a lead line region, a bending region, a drive chip region, and a bonding pin region which are sequentially disposed along a direction away from the display region, wherein the lead line region is connected to the display region 100, and the bending region is connected to the lead line region. The lead line region may be provided with a plurality of data leading-out lines 80A extending along a direction away from the display region, first ends of one part of the data leading-out lines 80A are connected correspondingly with data connection lines 80 in the display region 100, first ends of the other part of the data leading-out lines are connected correspondingly with data signal lines 70 in the display region 100, and second ends of all data leading-out lines 80A extend along a second direction Y and then cross the bending region to be connected with an integrated circuit of the drive chip region, so that data signals of the integrated circuit are applied to the data signal lines 70 through the data leading-out lines 80A and the data connection lines 80. Since the data connection lines 80 are disposed in the display region, a length of the lead line region in the second direction Y may be effectively reduced, which greatly shortens a width of a lower bezel, increases a screen-to-body ratio, and is beneficial to achieve full-screen display.

In an exemplary implementation mode, the plurality of data signal lines 70 in the display region may be divided into a first data signal line group and a second data signal line group according to whether a data signal line is connected with a data connection line 80 or not, wherein a data signal line 70 in the first data signal line group is connected with a data connection line 80, and a data signal line 70 in the second data signal line group is not connected with a data connection line 80. The plurality of data leading-out lines 80A in the lead line region may be divided into a first leading-out line group and a second leading-out line group according to whether a data leading-out line is connected with a data connection line 80 or not, wherein a data leading-out line 80A in the first leading-out line group is connected with a data connection line 80, and a data leading-out line 80A in the second leading-out line group is not connected with a data connection line 80. A plurality of data signal lines 70 in the first data signal line group are connected correspondingly with one ends of a plurality of data connection lines 80, and the other ends of the plurality of data connection lines 80 are connected correspondingly with a plurality of data leading-out lines 80A in the first leading-out line group. A plurality of data signal lines 70 in the second data signal line group are connected correspondingly with a plurality of data leading-out lines 80A in the second leading-out line group.

In an exemplary implementation mode, the display region 100 may have a center line O, wherein the plurality of data signal lines 70 and the plurality of data connection lines 80 in the display region 100, and the plurality of data leading-out lines 80A in the lead line region 201 may be symmetrically disposed with respect to the center line O, and the center line O may be a straight line bisecting the display region 100 in a first direction X and extending along the second direction Y.

FIG. 7 is a schematic diagram of an arrangement of data connection lines according to an exemplary embodiment of the present disclosure. As shown in FIG. 7, a data connection line 80 may at least include a first connection line 81 and a second connection line 82, wherein the first connection line 81 may be in a shape of a straight line or a polyline extending along the first direction X, and a data signal line 70 and the second connection line 82 each may be in a shape of a straight line or a polyline extending along the second direction Y, the first direction X intersecting with the second direction Y. A first end of the first connection line 81 may be connected with the data signal line 70 through a first connection hole, a second end of the first connection line 81 may be connected with a first end of the second connection line 82 through a second connection hole after extending along the first direction X or an opposite direction of the first direction X, and a second end of the second connection line 82 is connected with a data leading-out line after extending toward a direction of the lead line region along the second direction Y.

In an exemplary implementation mode, a data leading-out line may be connected with the data signal line 70 directly or through a connection hole, and a data leading-out line may be connected with the data connection line 80 directly or through a connection hole, and the present disclosure is not limited thereto.

In an exemplary implementation mode, since the data connection line includes a first connection line 81 extending along the first direction X and a second connection line 82 extending along the second direction Y, and is disposed in a partial region of the display region, the display region may be divided into a first region 110 and a second region 120 according to presence or absence of a data connection line. The first region 110 may be a region provided with the first connection line 81 or the second connection line 82, and may be referred to as a FIP region, and the second region 120 may be a region in which no first connection line 81 or second connection line 82 is disposed, and may be referred to as a non-FIP region.

In the present disclosure, by disposing a data connection line in the display region, a data leading-out line of the bonding region is enabled to be connected with a data signal line through the data connection line, so that a fan-shaped oblique line does not need to be disposed in the lead line region, which effectively reduces a length of the lead line region, greatly reduces a width of a lower bezel, and increases a screen-to-body ratio, which is beneficial to achieve full-screen display.

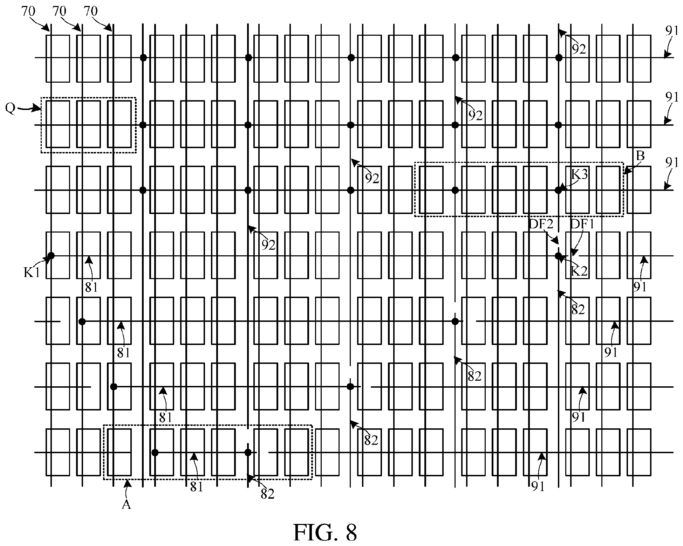

FIG. 8 is a schematic diagram of a structure of a data connection line and a constant voltage trace according to an exemplary embodiment of the present disclosure. As shown in FIG. 8, in an exemplary implementation mode, the drive structure layer of the display region 100 may include a plurality of repeating units Q forming a plurality of repeating unit rows and a plurality of repeating unit columns, wherein the repeating units Q are basic units constituting the drive structure layer, and the drive structure layer may be constituted by repeatedly and continuously disposing the repeating units Q along the first direction X and the second direction Y. At least one repeating unit Q may include a plurality of circuit units sequentially disposed along the first direction X, and at least one circuit unit may include a pixel drive circuit. A light emitting structure layer of the display region 100 may include a plurality of light emitting units, and at least one light emitting unit may include a light emitting device, which is connected with a pixel drive circuit of a corresponding circuit unit.

In an exemplary implementation mode, circuit units mentioned in the present disclosure refer to regions divided according to pixel drive circuits, and light emitting units mentioned in the present disclosure refer to regions divided according to light emitting devices. In an exemplary implementation mode, a position of an orthographic projection of a light emitting unit on the base substrate may correspond to a position of an orthographic projection of a circuit unit on the base substrate, or the position of the orthographic projection of the light emitting unit on the base substrate may not correspond to the position of the orthographic projection of the circuit unit on the base substrate.

In an exemplary implementation mode, a plurality of repeating units sequentially disposed along the first direction X may be referred to as a repeating unit row, and a plurality of repeating units sequentially disposed along the second direction Y may be referred to as a repeating unit column. A plurality of circuit units sequentially disposed along the first direction X may be referred to as a unit row, and a plurality of circuit units sequentially disposed along the second direction Y may be referred to as a unit column.

In an exemplary implementation mode, one repeating unit row may include one unit row, that is, one unit row is a same concept as one repeating unit row, and one repeating unit column may include three unit columns.

In an exemplary implementation mode, the drive structure layer of the display region 100 may further include a plurality of insertion columns, the plurality of insertion columns are respectively disposed between adjacent repeating unit columns, and the insertion columns is configured for disposing a vertical trace, such as a second connection line or a second constant voltage trace. Herein, an insertion column according to the present disclosure may be that a distance between two circuit units having an insertion column is greater than a distance between two circuit units without an insertion column.

In an exemplary implementation mode, the drive structure layer of the display region 100 may further include a plurality of data signal lines 70, a plurality of first connection lines 81, a plurality of second connection lines 82, a plurality first constant voltage traces 91, and a plurality second constant voltage traces 92. A first connection line 81 and a first constant voltage trace 91 each may be in a shape of a straight line or a polyline extending along the first direction X, and a data signal line 70, a second connection line 82, and a second constant voltage trace 92 each may be in a shape of a straight line or a polyline extending along the second direction Y.

In an exemplary implementation mode, the plurality of data signal lines 70 may be respectively disposed in each unit column and be sequentially arranged along the first direction X, and a data signal line 70 is connected with pixel drive circuits of a plurality of circuit units in a unit column in which the data signal line 70 is located. The plurality of first connection lines 81 and the plurality of second connection lines 82 may be disposed in the first region 110, wherein the plurality of first connection lines 81 may be respectively disposed in a corresponding repeating unit row and be sequentially arranged along the second direction Y, and the plurality of second connection lines 82 may be respectively disposed in a corresponding insertion column and be sequentially arranged along the first direction X. The plurality of first constant voltage traces 91 and the plurality of second constant voltage traces 92 may be disposed in the second region 120, wherein the plurality of first constant voltage traces 91 may be respectively disposed in a corresponding repeating unit row and be sequentially arranged along the second direction Y, and the plurality of second constant voltage traces 92 may be respectively disposed in a corresponding insertion column and be sequentially arranged along the first direction X. In an exemplary implementation mode, some of the first constant voltage traces 91 and some of the second constant voltage traces 92 may extend into the first region 110.

In an exemplary implementation mode, one repeating unit (three circuit units) may be spaced between two second connection lines 82 adjacent in the first direction X, and one repeating unit (three circuit units) may be spaced between two second constant voltage traces 92 adjacent in the first direction X, that is, the second connection line 82 and the second constant voltage trace 92 each has a three-inserting-one structure.

In an exemplary implementation mode, there may be three data signal lines 70 disposed between two second connection lines 82 adjacent in the first direction X, and there may be three data signal lines 70 disposed between two second constant voltage traces 92 adjacent in the first direction X.

In an exemplary implementation mode, the drive structure layer of the display substrate may include a plurality of conductive layers in a direction perpendicular to the display substrate. The first connection line 81 and the second connection line 82 may be disposed in different conductive layers, and the first connection line 81 and the data signal line 70 may be disposed in different conductive layers. A first end of the first connection line 81 may be connected with the data signal line 70 through a first connection hole K1, and a second end of the first connection line 81 may be connected with a first end of the second connection line 82 through a second connection hole K2 after extending along the first direction X or an opposite direction of the first direction X. A second end of the second connection line 82 is connected with a data leading-out line after extending toward a direction of the lead line region along the second direction Y.

In an exemplary implementation mode, the first constant voltage trace 91 and the second constant voltage trace 92 may be disposed in different conductive layers, and at least one second constant voltage trace 92 may be connected with at least one first constant voltage trace 91 through a third connection hole K3 to form a mesh-like communication structure for transmitting a constant voltage signal in the display region.

In an exemplary implementation mode, the first constant voltage trace 91 and the first connection line 81 may be disposed in a same layer and formed synchronously through a same patterning process, and the data signal line 70, the second connection line 82, and the second constant voltage trace 92 may be disposed in a same layer and formed synchronously through a same patterning process.

In an exemplary implementation mode, at least one first connection line 81 and at least one first constant voltage trace 91 may be disposed in at least one repeating unit row, wherein a first fracture DF1 may be disposed between the first connection line 81 and the first constant voltage trace 91, and the first fracture DF1 is configured to achieve mutual insulation between the first connection line 81 and the first constant voltage trace 91. In an exemplary implementation mode, this unit row may be a unit row containing the first region 110 and the second region 120.

In an exemplary implementation mode, in at least one repeating unit row, only one first constant voltage trace 91 may be disposed, and no first connection line 81 is disposed in this unit row. In an exemplary implementation mode, this unit row may be a unit row of the second region 120.

In an exemplary implementation mode, in at least one insertion column, at least one second connection line 82 and at least one second constant voltage trace 92 may be disposed, wherein a second fracture DF2 may be disposed between the second connection line 82 and the second constant voltage trace 92, and the second fracture DF2 is configured to achieve mutual insulation between the second connection line 82 and the second constant voltage trace 92. In an exemplary implementation mode, this insertion column may be an insertion column containing the first region 110 and the second region 120.

In an exemplary implementation mode, in at least one insertion column, only one second constant voltage trace 92 may be disposed, and no second connection line 82 is disposed in this insertion column. In an exemplary implementation mode, this insertion column may be an insertion column of the second region120.

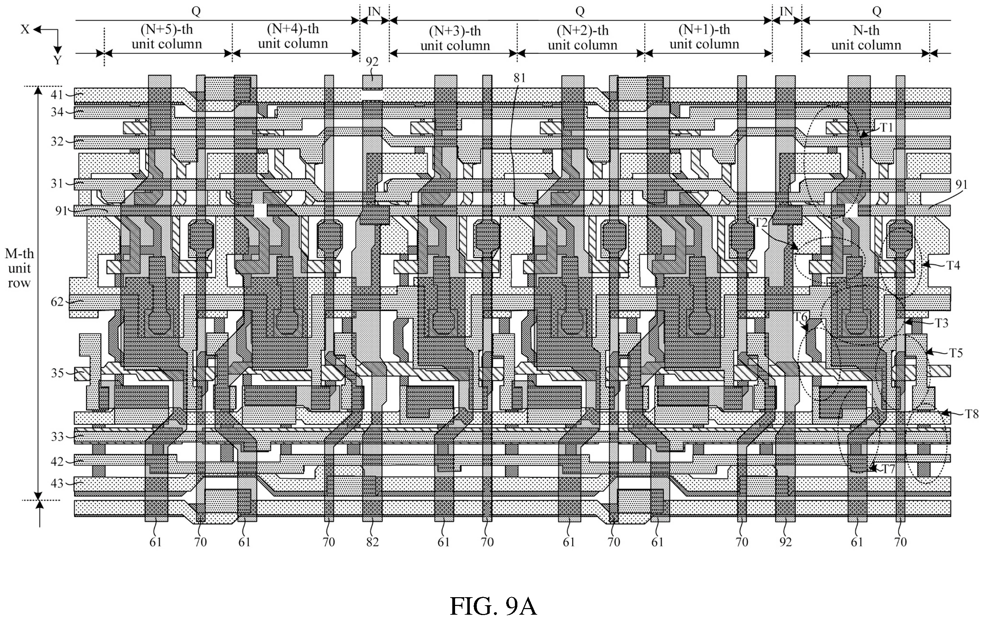

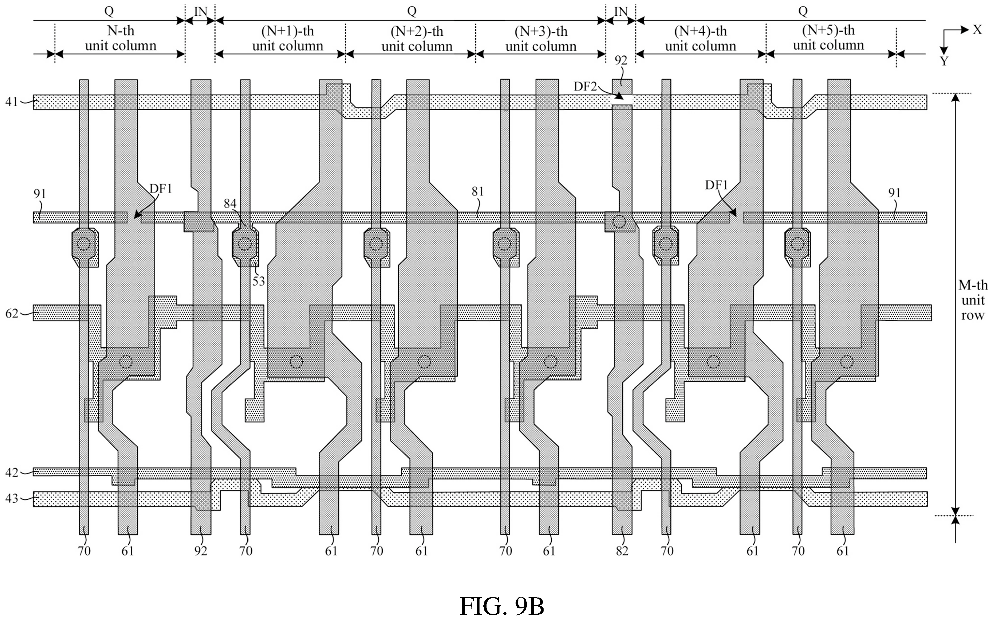

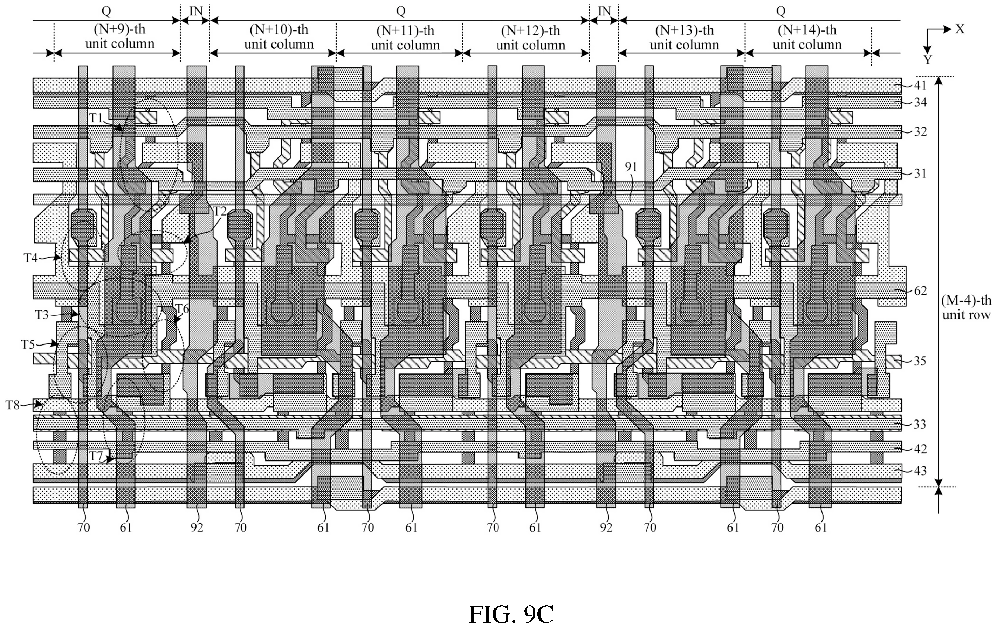

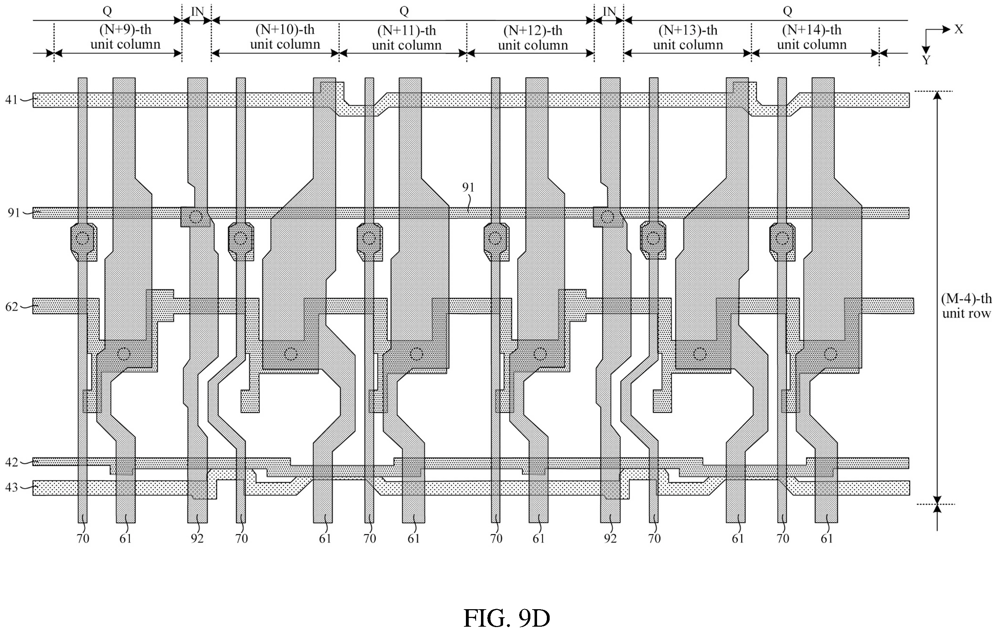

FIGs. 9A, 9B, 9C, and 9D are schematic diagrams of a structure of a display substrate according to an exemplary embodiment of the present disclosure, wherein FIG. 9A is a schematic diagram of a structure of a region A in FIG. 8, FIG. 9B is a schematic diagram of a first connection line and a second connection line in FIG. 9A, FIG. 9C is a schematic diagram of a structure of a region B in FIG. 8, and FIG. 9D is a schematic diagram of a first constant voltage trace and a second constant voltage trace in FIG. 9C. Herein, FIG. 9A and FIG. 9B illustrate a structure of six circuit units in one unit row (an M-th unit row) and six unit columns (an N-th unit column to an (N+5)-th unit column) in a first region, and FIGs. 9C and 9D illustrate a structure of six circuit units in one unit row (an (M-4)-th unit row) and six unit columns (an (N+9)-th unit column to an (N+14)-th unit column) in a second region.

In an exemplary implementation mode, in a direction perpendicular to the display substrate, the display substrate may at least include a drive structure layer disposed on a base substrate, and a light emitting structure layer disposed at a side of the drive structure layer away from the base substrate. In a plane parallel to the base substrate, the drive structure layer may include a plurality of repeating units Q forming a plurality of repeating unit rows and a plurality of repeating unit columns, wherein an insertion column IN is disposed between adjacent repeating unit columns. At least one repeating unit Q may include three circuit units disposed sequentially along a first direction X, at least one circuit unit may include a pixel drive circuit, and the pixel drive circuit may be connected with a first scan signal line 31, a second scan signal line 32, a third scan signal line 33, a fourth scan signal line 34, a light emitting signal line 35, a first initial signal line 41, a second initial signal line 42, a third initial signal line 43, a first power supply line 61, and a data signal line 70, respectively.

In an exemplary implementation mode, the first scan signal line 31, the second scan signal line 32, the third scan signal line 33, and the fourth scan signal line 34 are configured to provide a first scan signal, a second scan signal, a third scan signal, and a fourth scan signal to the pixel drive circuit, respectively, the light emitting signal line 35 is configured to provide a light emitting control signal to the pixel drive circuit, the first initial signal line 41, the second initial signal line 42, and the third initial signal line 43 are configured to provide a first initial signal, a second initial signal, and a third initial signal to the pixel drive circuit, respectively, the first power supply line 61 is configured to provide a first power supply signal to the pixel drive circuit, and the data signal line 70 is configured to provide a data signal to the pixel drive circuit. Herein, a plurality of signal lines connected with the pixel drive circuit may be located in the circuit unit.

In an exemplary implementation mode, main body portions of the first scan signal line 31, the second scan signal line 32, the third scan signal line 33, the fourth scan signal line 34, the light emitting signal line 35, the first initial signal line 41, the second initial signal line 42, and the third initial signal line 43 may be in a shape of a straight line or a polyline extending along the first direction X, and main body portions of the first power supply line 61 and the data signal line 70 may be in a shape of a straight line or a polyline extending along the second direction Y.

In the present disclosure, "A extends along a B direction" refers to that A may include a main body portion and a secondary portion connected with the main body portion, wherein the main body portion is a line, a line segment, or a strip-shaped body, the main body portion extends along the B direction, and a length of the main body portion extending along the B direction is greater than a length of the secondary portion extending along another direction. In following description, "A extends along a B direction" means "a main body portion of A extends along the B direction".

In an exemplary implementation mode, the pixel drive circuit may include a storage capacitor and eight transistors. The storage capacitor may include a first electrode plate and a second electrode plate that are stacked, an orthographic projection of the second electrode plate on the base substrate is at least partially overlapped with an orthographic projection of the first electrode plate on the base substrate. The eight transistors may include a first transistor T1 serving as a first initialization transistor, a second transistor T2 serving as a compensation transistor, a third transistor T3 serving as a drive transistor, a fourth transistor T4 serving as a data writing transistor, a fifth transistor T5 serving as a first light emitting control transistor, a sixth transistor T6 serving as a second light emitting control transistor, a seventh transistor T7 serving as a second initialization transistor, and an eighth transistor T8 serving as a third initialization transistor. In an exemplary implementation mode, the eight transistors may all be low temperature poly silicon transistors (P-type transistors).

In an exemplary implementation mode, a gate electrode of the first transistor T1 is connected with the fourth scan signal line 34, a first electrode of the first transistor T1 is connected with the first initial signal line 41, and a second electrode of the first transistor T1 is respectively connected with a first electrode of the second transistor T2 and the first electrode plate (which is also a gate electrode of the third transistor T3). A gate electrode of the second transistor T2 is connected with the first scan signal line 31, and a second electrode of the second transistor T2 is respectively connected with a second electrode of the third transistor T3 and a first electrode of the sixth transistor T6. A gate electrode of the fourth transistor T4 is connected with the second scan signal line 32, a first electrode of the fourth transistor T4 is connected with the first data signal line 70, and a second electrode of the fourth transistor T4 is respectively connected with a first electrode of the third transistor T3, a second electrode of the fifth transistor T5, and a second electrode of the eighth transistor T8. A gate electrode of the fifth transistor T5 is connected with the light emitting signal line 35, and a first electrode of the fifth transistor T5 is connected with the first power supply line 61. A gate electrode of the sixth transistor T6 is connected with the light emitting signal line 35, and a second electrode of the sixth transistor T6 is connected with a second electrode of the seventh transistor T7. A gate electrode of the seventh transistor T7 is connected with the third scan signal line 33, and a first electrode of the seventh transistor T7 is connected with the second initial signal line 42. A gate electrode of the eighth transistor T8 is connected with the third scan signal line 33, and a first electrode of the seventh transistor T8 is connected with the third initial signal line 43.

In an exemplary implementation mode, in at least one circuit unit, the first scan signal line 31 may be disposed at a side of the storage capacitor in an opposite direction of the second direction Y, the second scan signal line 32 may be disposed at a side of the first scan signal line 31 away from the storage capacitor, the fourth scan signal line 34 may be disposed at a side of the second scan signal line 32 away from the storage capacitor, and the first initial signal line 41 may be disposed at a side of the fourth scan signal line 34 away from the storage capacitor. The light emitting signal line 35 may be disposed at a side of the storage capacitor in the second direction Y, the third scan signal line 33 may be disposed at a side of the light emitting signal line 35 away from the storage capacitor, the second initial signal line 42 may be disposed at a side of the third scan signal line 33 away from the storage capacitor, and the third initial signal line 43 may be disposed at a side of the second initial signal line 42 away from the storage capacitor.

In an exemplary implementation mode, the drive structure layer may further include at least one power supply connection line 62. The power supply connection line 62 may be in a shape of a polyline extending along the first direction X, and may be disposed between the first scan signal line 31 and the light emitting signal line 35. The power supply connection line 62 is connected with the second electrode plate through a via, and the first power supply line 61 is connected with the power supply connection line 62 through a via, and the first power supply line 61 and the power supply connection line 62 form a mesh-like communication structure for transmitting a first power supply signal.

In an exemplary implementation mode, the drive structure layer may further include at least one first connection line 81, at least one second connection line 82, at least one first constant voltage trace 91, and at least one second constant voltage trace 92. The first connection line 81 and the first constant voltage trace 91 each may be in a shape of a straight line or a polyline extending along the first direction X, and the second connection line 82 and the second constant voltage trace 92 each may be in a shape of a straight line or a polyline extending along the second direction Y. The first connection line 81 is configured to be connected with the data signal line 70 and the second connection line 82, respectively, forming a structure in which a data connection line is located in the display region. The first constant voltage trace 91 and the second constant voltage trace 92 are configured to be connected with each other, forming a mesh-like communication structure for transmitting a constant voltage signal.

In an exemplary implementation mode, in a direction perpendicular to the display substrate, the display substrate may include a plurality of conductive layers disposed on the base substrate. The first connection line 81 and the second connection line 82 may be disposed in different conductive layers, the first connection line 81 and the first constant voltage trace 91 may be disposed in a same layer, and the second connection line 82 and the second constant voltage trace 92 may be disposed in a same layer.

As shown in FIG. 9A and FIG. 9B, in the first region, the first connection line 81 may be disposed between the first scan signal line 31 and the second electrode plate, and the second connection line 82 may be disposed in the insertion column IN. There may be three first power supply lines 61 and three data signal lines 70 disposed between two adjacent second connection lines 82, that is, three circuit units (one repeating unit Q) may be spaced between two adjacent second connection lines 82.

In an exemplary implementation mode, in the first direction X, there may be at least one first power supply line 61 disposed between the data signal line 70 and the second connection line 82.

In an exemplary implementation mode, at least one repeating unit row may be provided with at least one first connection line 81 and at least one first constant voltage trace 91, wherein a first fracture DF1 may be disposed between the first connection line 81 and the first constant voltage trace 91, and the first fracture DF1 is configured to achieve mutual insulation between the first connection line 81 and the first constant voltage trace 91. At least one insertion column IN may be provided with at least one second connection line 82 and at least one second constant voltage trace 92, wherein a second fracture DF2 may be disposed between the second connection line 82 and the second constant voltage trace 92, and the second fracture DF2 is configured to achieve mutual insulation between the second connection line 82 and the second constant voltage trace 92.

In an exemplary implementation mode, each circuit unit in the first region may be provided with a third connection electrode 53 serving as a data connection electrode of the present disclosure, and the data signal line 70 may be connected with the third connection electrode 53 through a via. At least one circuit unit in the first region may be provided with a data connection block 84 which may be disposed between the first connection line 81 and the third connection electrode 53, wherein two ends of the data connection block 84 are respectively connected with the first connection line 81 and the third connection electrode 53, thus realizing a connection between a first end of the first connection line 81 and the data signal line 70. For example, the data connection block 84 may be disposed in a circuit unit in an M-th unit row and an (N+1)-th unit column, to realize a connection between a first connection line 81 in the M-th unit row and a data signal line 70 in the (N+1)-th unit column.

In an exemplary implementation mode, in at least one repeating unit row, the data connection block 84 may be disposed at a side of the first scan signal line 31 close to the second electrode plate, and third connection electrodes 53 of a plurality of circuit units may be disposed at the side of the first scan signal line 31 close to the second electrode plate, and located on a same straight line extending along the first direction X.

In an exemplary implementation mode, in at least one insertion column of the first region, the second connection line 82 may be connected with the first connection line 81 through a via, thus realizing a connection between a second end of the first connection line 81 and the second connection line 82. For example, in an insertion column between an (N+3)-th unit column and an (N+4)-th unit column, a second connection line 82 is connected with the first connection line 81 in the M-th unit row through a via.

As shown in FIG. 9C and FIG. 9D, in the second region, the first constant voltage trace 91 may be disposed between the first scan signal line 31 and the second electrode plate, and the second constant voltage trace 92 may be disposed in the insertion column IN. There may be three first power supply lines 61 and three data signal lines 70 disposed between two adjacent second constant voltage traces 92, that is, three circuit units (one repeating unit Q) may be spaced between two adjacent second constant voltage traces 92.

In an exemplary implementation mode, in the first direction X, there may be at least one first power supply line 61 disposed between the data signal line 70 and the second constant voltage trace 92.

In an exemplary implementation mode, at least one repeating unit row may include only the first constant voltage trace 91, and no first connection line is disposed. At least one insertion column IN may include only the second constant voltage trace 92, and no second connection line 82 is disposed.

In an exemplary implementation mode, in at least one insertion column of the second region, the second constant voltage trace 92 may be connected with the first constant voltage trace 91 through a via, thus realizing a connection between the first constant voltage trace 91 and the second constant voltage trace 92 and forming a mesh-like communication structure for transmitting a constant voltage signal. For example, in an insertion column between an (N+9)-th unit column and an (N+10)-th unit column, a second constant voltage trace 92 is connected with a first constant voltage trace 91 in an (M-4)-th unit row through a via. For another example, in an insertion column between an (N+12)-th unit column and an (N+13)-th unit column, a second constant voltage trace 92 is connected with a first constant voltage trace 91 in an (M-4)-th unit row through a via.

In an exemplary implementation mode, in a direction perpendicular to the display substrate, the display substrate may include a first conductive layer disposed on the base substrate, a second conductive layer disposed at a side of the first conductive layer away from the base substrate, a third conductive layer disposed at a side of the second conductive layer away from the base substrate, and a fourth conductive layer disposed at a side of the third conductive layer away from the base substrate. The first connection line 81 and the first constant voltage trace 91 may be disposed in the third conductive layer, and the second connection line 82 and the second constant voltage trace 92 may be disposed in the fourth conductive layer.

Exemplary description is made below through a preparation process of a display substrate. A "patterning process" mentioned in the present disclosure includes film layer deposition, photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in an entire manufacturing process, the "thin film" may also be called a "layer". If the "thin film" need to be processed through the patterning process in the entire manufacturing process, the "thin film" is called a "thin film" before the patterning process is performed and is called a "layer" after the patterning process is performed. At least one "pattern" is contained in the "layer" after the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation mode of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A is overlapped with the boundary of the orthographic projection of B.

In an exemplary implementation mode, taking 6 circuit units in one repeating unit row as an example, a preparing process of the display substrate in this embodiment may include following operations. Herein, one repeating unit Q includes three circuit units.

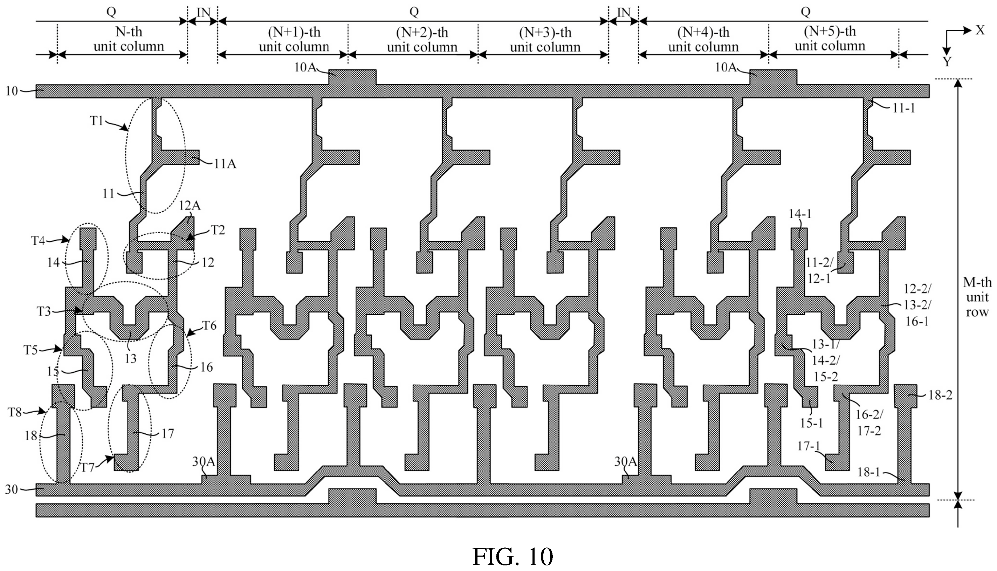

(11) Forming a pattern of a semiconductor layer. In an exemplary implementation mode, forming the pattern of the semiconductor layer may include: sequentially depositing a first insulation thin film and a semiconductor thin film on a base substrate, and patterning the semiconductor thin film through a patterning process to form a first insulation layer that covers the base substrate and form the semiconductor layer disposed on the first insulation layer, as shown in FIG. 10. FIG. 10 is a schematic diagram of a structure of a region A in FIG. 8, and the pattern of the semiconductor layer of a region B in FIG. 8 is substantially the same as that of the region A in FIG. 8.

In an exemplary implementation mode, the semiconductor layer of each circuit unit in the display region may at least include a first active layer 11 of a first transistor T1 to an eighth active layer 18 of an eighth transistor T8, wherein the first active layer 11 to the seventh active layer 17 may be of an interconnected integral structure, and the eighth active layer 18 may be disposed separately.

In an exemplary implementation mode, the first active layer 11, the second active layer 12, and the fourth active layer 14 may be located at a side of the third active layer 13 of the present circuit unit in an opposite direction of the second direction Y, and the fifth active layer 15, the sixth active layer 16, the seventh active layer 17, and the eighth active layer 18 may be located at a side of the third active layer 13 of the present circuit unit in the second direction Y.

In an exemplary implementation mode, the first active layer 11, the fourth active layer 14, the fifth active layer 15, the seventh active layer 17, and the eighth active layer 18 each may be in a shape of a strip extending along the second direction Y, the second active layer 12 and the sixth active layer 16 each may be in a shape of a character "L", and the third active layer 13 may be in a shape of an inverted character "Ω".

In an exemplary implementation mode, an active layer of each transistor may include a first region, a second region, and a channel region located between the first region and the second region. In an exemplary implementation mode, a second region 11-2 of the first active layer and a first region 12-1 of the second active layer may be connected with each other, and the second region 11-2 of the first active layer may serve as the first region 12-1 of the second active layer. A first region 13-1 of the third active layer 13, a second region 14-2 of the fourth active layer, and a second region 15-2 of the fifth active layer may be connected with each other, and the first region 13-1 of the third active layer may simultaneously serve as the second region 14-2 of the fourth active layer and the second region 15-2 of the fifth active layer. A second region 12-2 of the second active layer, a second region 13-2 of the third active layer, and a first region 16-1 of the sixth active layer may be connected with each other, and the second region 12-2 of the second active layer may simultaneously serve as the second region 13-2 of the third active layer and the first region 16-1 of the sixth active layer. A second region 16-2 of the sixth active layer and a second region 17-2 of the seventh active layer may be connected with each other, and the second region 16-2 of the sixth active layer may serve as the second region 17-2 of the seventh active layer. A first region 11-1 of the first active layer, a first region 14-1 of the fourth active layer, a first region 15-1 of the fifth active layer, a first region 17-1 of the seventh active layer, a first region 18-1 of the eighth active layer, and a second region 18-2 of the eighth active layer may be disposed separately.

In an exemplary implementation mode, the eighth active layer 18 may be separately disposed at a side of the seventh active layer 17 in an opposite direction of the first direction X, the first region 18-1 of the eighth active layer 18 may be disposed at a side of a channel region of the eighth active layer 18 away from the third active layer 13, and the second region 18-2 of the eighth active layer 18 may be disposed at a side of the channel region of the eighth active layer 18 close to the third active layer 13.

In an exemplary implementation mode, a first active block 11A may be disposed on the first active layer 11. The first active block 11A may be in a shape of a strip extending along the first direction X, may be disposed at a side of the first active layer 11 in the first direction X, and may be connected with the first active layer 11.

In an exemplary implementation mode, in at least one circuit unit, the first active layer 11 and the first active block 11A may be of an interconnected integral structure.

In an exemplary implementation mode, a second active block 12A may be disposed on the second active layer 12. The second active block 12 A may be in a shape of a block (such as a trapezoid), may be disposed at a corner of an "L" shape, and may be connected with the second active layer 12.

In an exemplary implementation mode, in at least one circuit unit, the second active layer 12 and the second active block 12A may be of an interconnected integral structure.

In an exemplary implementation mode, the semiconductor layer may further include a first active connection line 10 and a third active connection line 30.

In an exemplary implementation mode, the first active connection line 10 may be in a shape of a straight line or a polyline extending along the first direction X, may be disposed at a side of the first active layer 11 away from the third active layer 13, and may be connected with the first region 11-1 of the first active layer of each circuit unit. The first active connection line 10 may be multiplexed as a first initial trace extending along the first direction X, which may ensure that first regions of a plurality of first active layers in one unit row have a same potential.

In an exemplary implementation mode, in at least one repeating unit, a first active connection block 10A may be disposed on the first active connection line 10. The first active connection block 10A may be in a shape of a block (such as a rectangle), may be disposed at a side of the first active connection line 10 away from the third active layer 13, and may be connected with the first active connection line 10. The first active connection block 10A is configured to be connected with a first initial signal line through a sixth connection electrode formed subsequently, so that the first active connection line and the first initial signal line form a signal line with a double-layer structure.

In an exemplary implementation mode, the first active connection block 10A may be disposed in a boundary region between an (N+1)-th unit column and an (N+2)-th unit column, and may be disposed in a boundary region between an (N+4)-th unit column and an (N+5)-th unit column. In at least one repeating unit, the first active connection line 10 and the first active connection block 10A may be of an interconnected integral structure.

In an exemplary implementation mode, the third active connection line 30 may be in a shape of a straight line or a polyline extending along the first direction X, may be disposed at a side of the seventh active layer 17 away from the third active layer 13, and may be connected with the first region 17-1 of the seventh active layer of each circuit unit. The third active connection line 30 may be multiplexed as a third initial trace extending along the first direction X, which may ensure that first regions of a plurality of seventh active layers in one unit row have a same potential.

In an exemplary implementation mode, in at least one repeating unit, a third active connection block 30A may be disposed on the third active connection line 30. The third active connection block 30A may be in a shape of a block (such as a rectangle), may be disposed at a side of the third active connection line 30 close to the third active layer 13, and may be connected with the third active connection block 30A. The third active connection block 30A is configured to be connected with a third initial signal line through a seventh connection electrode formed subsequently, so that the third active connection line and the third initial signal line form a signal line with a double-layer structure.

In an exemplary implementation mode, the third active connection block 30A may be disposed in circuit units of the (N+1)-th unit column and the (N+4)-th unit column respectively. In at least one repeating unit, the third active connection line 30 and the third active connection block 30A may be of an interconnected integral structure.

In an exemplary implementation mode, in at least one repeating unit, the eighth active layer 18 may be disposed at a side of the third active connection block 30A close to the third active layer 13 and may be connected with the third active connection block 30A.

In an exemplary implementation mode, the second region 12-2 of the second active layer may serve as the second electrode of the second transistor T2, the second region 13-2 of the third active layer may serve as the second electrode of the third transistor (drive transistor) T3, and the first region 16-1 of the sixth active layer may serve as the first electrode of the sixth transistor T6, wherein a connection region where the second region 12-2 of the second active layer, the second region 13-2 of the third active layer, and the first region 16-1 of the sixth active layer are connected with each other is a third node N3 of a pixel drive circuit. The second region 16-2 of the sixth active layer may serve as the second electrode of the sixth transistor T6, and the second region 17-2 of the seventh active layer may serve as the second electrode of the seventh transistor T7, wherein a connection region where the second region 16-2 of the sixth active layer and the second region 17-2 of the seventh active layer are connected with each other is a fourth node N4 of the pixel drive circuit.

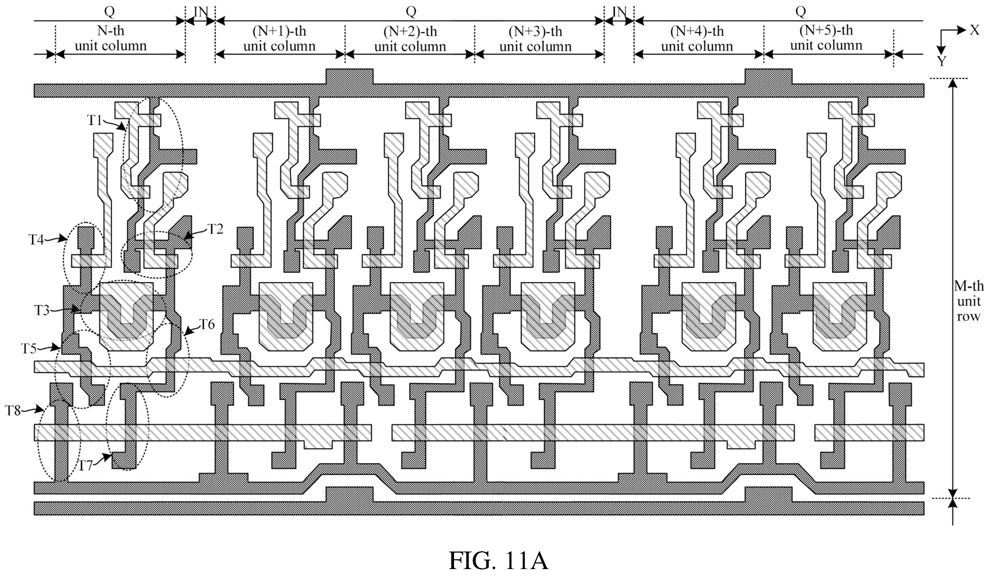

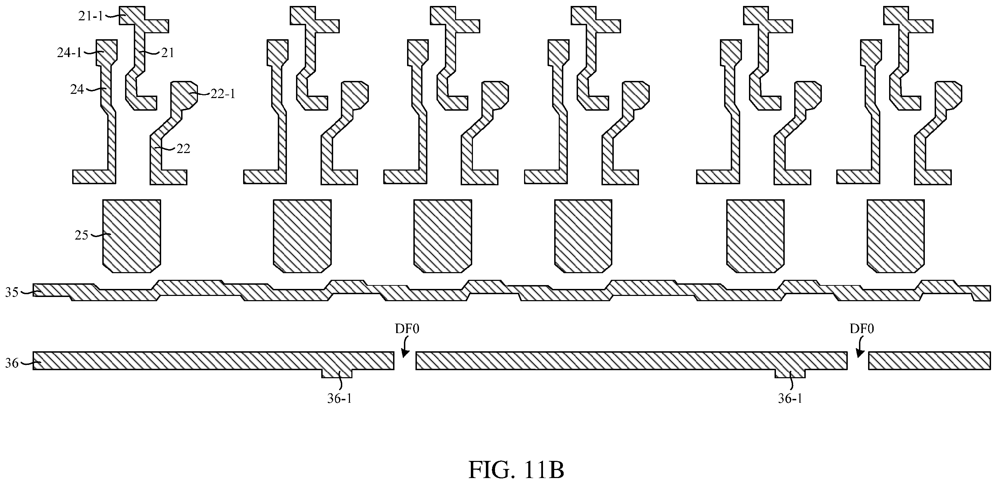

(12) Forming a pattern of a first conductive layer. In an exemplary implementation mode, forming the pattern of the first conductive layer may include: sequentially depositing a second insulation thin film and a first conductive thin film on the base substrate on which the aforementioned pattern is formed, and patterning the first conductive thin film through a patterning process to form a second insulation layer that covers the pattern of the semiconductor layer and form the pattern of the first conductive layer disposed on the second insulation layer, as shown in FIG. 11A and FIG. 11B, wherein FIG. 11B is a schematic plan diagram of the first conductive layer in FIG. 11A. FIG. 11A is a schematic diagram of a structure of a region A in FIG. 8, and the pattern of the first conductive layer of a region B in FIG. 8 is substantially the same as that of the region A in FIG. 8. In an exemplary implementation mode, the first conductive layer may be referred to as a first gate metal (GATE1) layer.

In an exemplary implementation mode, the pattern of the first conductive layer of each circuit unit in the display region at least includes: a first gate electrode 21, a second gate electrode 22, a fourth gate electrode 24, a first electrode plate 25 of a storage capacitor, a light emitting control line 35, and a scan connection line 36.

In an exemplary implementation mode, the first electrode plate 25 of the storage capacitor may be in a shape of a rectangle, a chamfer or a groove may be disposed at a corner of the rectangle, an orthographic projection of the first electrode plate 25 on the base substrate is at least partially overlapped with an orthographic projection of the third active layer 13 on the base substrate, and the first electrode plate 25 may simultaneously serve as one electrode plate of the storage capacitor and a gate electrode of the third transistor T3.

In an exemplary implementation mode, the first gate electrode 21 may be in a shape of a character "C", and may be disposed at a side of the first electrode plate 25 in an opposite direction of the second direction Y. An orthographic projection of the first gate electrode 21 on the base substrate is at least partially overlapped with an orthographic projection of the first active layer 11 on the base substrate, and two regions where the first gate electrode 21 is overlapped with the first active layer 11 may serve as two gate electrodes of the first transistor T1 with a double-gate structure.

In an exemplary implementation mode, the first active block 11A may be located between the two gate electrodes of the first transistor T1 in the second direction Y.

In an exemplary implementation mode, a first gate connection block 21-1 may be disposed on the first gate electrode 21. The first gate connection block 21-1 may be in a shape of a block (such as a rectangle), may be disposed at a side of the first gate electrode 21 away from the third active layer 13, and may be connected with the first gate electrode 21, and the first gate connection block 21-1 is configured to be connected with a fourth scan signal line formed subsequently.

In an exemplary implementation mode, in at least one circuit unit, the first gate electrode 21 and the first gate connection block 21-1 may be of an interconnected integral structure.

In an exemplary implementation mode, the second gate electrode 22 may be in a shape of a character "L", and may be disposed at a side of the first electrode plate 25 in an opposite direction of the second direction Y. An orthographic projection of the second gate electrode 22 on the base substrate is at least partially overlapped with an orthographic projection of the second active layer 12 on the base substrate, and two regions where the second gate electrode 22 is overlapped with the second active layer 12 may serve as two gate electrodes of the second transistor T2 with a double-gate structure.

In an exemplary implementation mode, the second active block 12A may be located between the two gate electrodes of the second transistor T2.

In an exemplary implementation mode, a second gate connection block 22-1 may be disposed on the second gate electrode 22. The second gate connection block 22-1 may be in a shape of a block (such as a rectangle), may be disposed at a side of the second gate electrode 22 away from the third active layer 13, and may be connected with the second gate electrode 22, and the second gate connection block 22-1 is configured to be connected with a first scan signal line formed subsequently.

In an exemplary implementation mode, in at least one circuit unit, the second gate electrode 22 and the second gate connection block 22-1 may be of an interconnected integral structure.

In an exemplary implementation mode, the fourth gate electrode 24 may be in a shape of a character "L", and may be disposed at a side of the first electrode plate 25 in an opposite direction of the second direction Y. An orthographic projection of the fourth gate electrode 24 on the base substrate is at least partially overlapped with an orthographic projection of the fourth active layer 14 on the base substrate, and a region where the fourth gate electrode 24 is overlapped with the fourth active layer 14 may serve as a gate electrode of the fourth transistor T4.

In an exemplary implementation mode, a fourth gate connection block 24-1 may be disposed on the fourth gate electrode 24. The fourth gate connection block 24-1 may be in a shape of a block (such as a rectangle), may be disposed at a side of the fourth gate electrode 24 away from the third active layer 13, and may be connected with the fourth gate electrode 24, and the fourth gate connection block 24-1 is configured to be connected with a second scan signal line formed subsequently.

In an exemplary implementation mode, in at least one circuit unit, the fourth gate electrode 24 and the fourth gate connection block 24-1 may be of an interconnected integral structure.

In an exemplary implementation mode, the light emitting control line 35 may be in a shape of a straight line or a polyline in which a main body portion extends along the first direction X, and may be disposed at a side of the first electrode plate 25 in the second direction Y. An orthographic projection of the light emitting control line 35 on the base substrate is at least partially overlapped with an orthographic projection of the fifth active layer 15 on the base substrate, wherein an overlapping region may serve as a gate electrode of the fifth transistor T5, and the orthographic projection of the light emitting control line 35 on the base substrate is at least partially overlapped with an orthographic projection of the sixth active layer 16 on the base substrate, wherein an overlapping region may serve as a gate electrode of the sixth transistor T6.

In an exemplary implementation mode, the scan connection line 36 may be in a shape of a straight line or a polyline in which a main body portion extends along the first direction X, and may be disposed at a side of the light emitting control line 35 away from the first electrode plate 25. An orthographic projection of the scan connection line 36 on the base substrate is at least partially overlapped with an orthographic projection of the seventh active layer 17 on the base substrate, wherein an overlapping region may serve as a gate electrode of the seventh transistor T7, and the orthographic projection of the scan connection line 36 on the base substrate is at least partially overlapped with an orthographic projection of the eighth active layer 18 on the base substrate, wherein an overlapping region may serve as a gate electrode of the eighth transistor T8.

In an exemplary implementation mode, in at least one repeating unit, a connection line fracture DF0 may be disposed on the scan connection line 36, and the connection line fracture DF0 cuts off the scan connection line 36 to reduce static electricity accumulation.

In an exemplary implementation mode, the connection line fracture DF0 may be disposed in circuit units of the (N+2)-th unit column and the (N+5)-th unit column.

In an exemplary implementation mode, in at least one repeating unit, a scan connection block 36-1 may be disposed on the scan connection line 36. The scan connection block 36-1 may be in a shape of a block (such as a rectangle), may be disposed at a side of the scan connection line 36 away from the first electrode plate 25, and may be connected with the scan connection line 36, and the scan connection block 36-1 is configured to be connected with a third scan signal line formed subsequently.

In an exemplary implementation mode, the first scan connection block 36-1 may be disposed in circuit units of the (N+1)-th unit column and the (N+4)-th unit column. In at least one repeating unit, the scan connection line 36 and the first scan connection block 36-1 may be of an interconnected integral structure.

In an exemplary implementation mode, after the pattern of the first conductive layer is formed, the semiconductor layer may be subjected to a conductive treatment by using the first conductive layer as a shield. A region of the semiconductor layer, which is shielded by the first conductive layer, forms channel regions of the first transistor T1 to the eighth transistor T8, and a region of the semiconductor layer, which is not shielded by the first conductive layer, is made to be conductive, that is, first regions and second regions of the first active layer to the eighth active layer, the first active connection line, and the third active connection line all are made to be conductive.

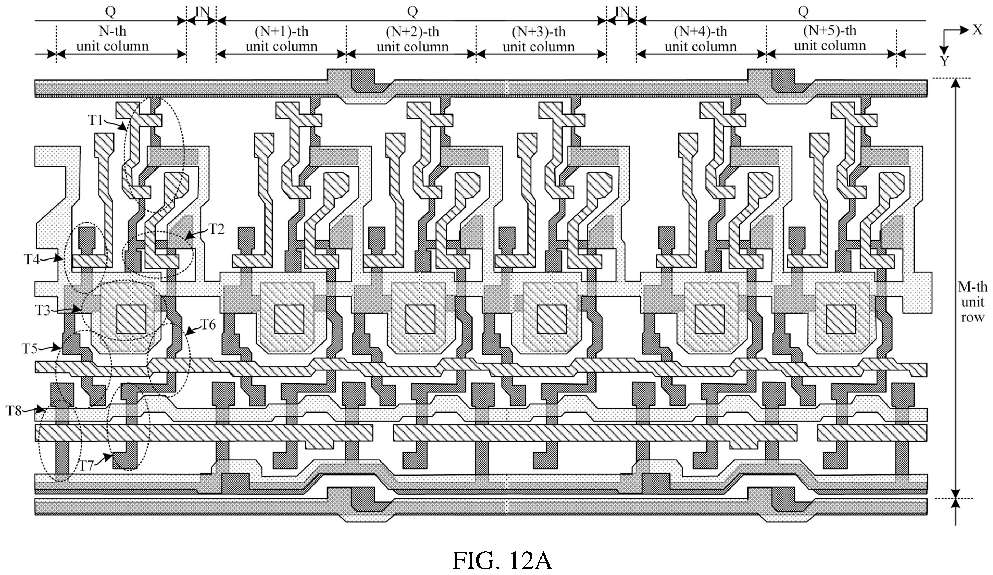

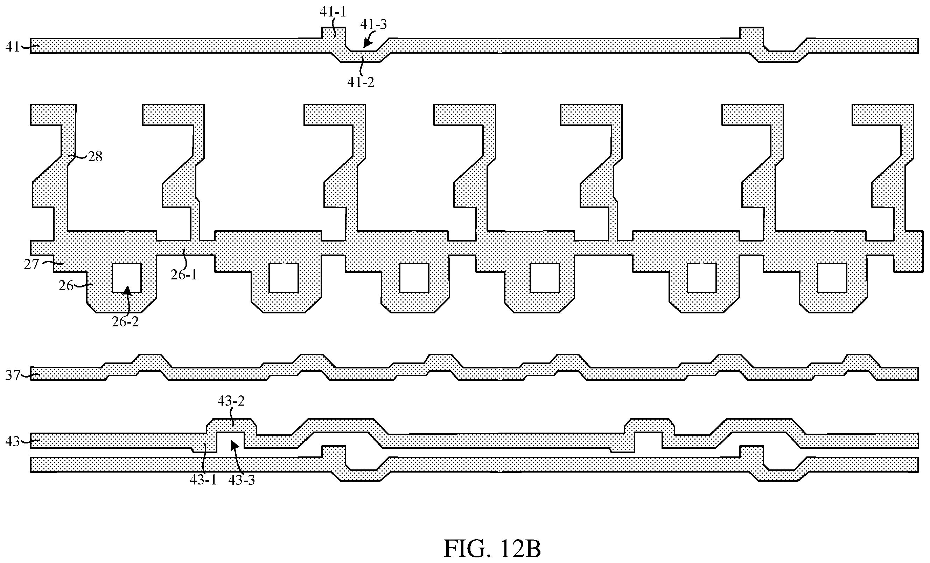

(13) Forming a pattern of a second conductive layer. In an exemplary implementation mode, forming the pattern of the second conductive layer may include: sequentially depositing a third insulation thin film and a second conductive thin film on the base substrate on which the aforementioned patterns are formed, and patterning the second conductive thin film through a patterning process to form a third insulation layer that covers the first conductive layer, and form the pattern of the second conductive layer disposed on the third insulation layer, as shown in FIG. 12A and FIG. 12B. FIG, wherein 12B is a schematic plan diagram of the second conductive layer in FIG. 12A. FIG. 12A is a schematic diagram of a structure of a region A in FIG. 8, and the pattern of the second conductive layer of a region B in FIG. 8 is substantially the same as that of the region A in FIG. 8. In an exemplary implementation mode, the second conductive layer may be referred to as a second gate metal (GATE2) layer.

In an exemplary implementation mode, the pattern of the second conductive layer of each circuit unit in the display region at least includes: a second electrode plate 26 of the storage capacitor, a compensation electrode 27, a shield electrode 28, a repair line 37, a first initial signal line 41, and a third initial signal line 43.

In an exemplary implementation mode, a profile of the second electrode plate 26 of the storage capacitor may be in a shape of a rectangle, a chamfer or a groove may be disposed at a corner of the rectangle, an orthographic projection of the second electrode plate 26 on the base substrate is at least partially overlapped with an orthographic projection of the first electrode plate 25 on the base substrate, and the second electrode plate 26 may serve as the other electrode plate of the storage capacitor, and the first electrode plate 25 and the second electrode plate 26 form the storage capacitor of the pixel drive circuit.

In an exemplary implementation mode, the compensation electrode 27 may be in a shape of a block (such as a rectangle), may be disposed at a side of the second electrode plate 26 in an opposite direction of the first direction X , and may be connected with the second electrode plate 26. An orthographic projection of the compensation electrode 27 on the base substrate is at least partially overlapped with an orthographic projection of a connection region between a first region of the third active layer and a second region of the fourth active layer (i.e., a second node N2 of the pixel drive circuit) on the base substrate. In an exemplary implementation mode, the connection region between the first region of the third active layer and the second region of the fourth active layer may serve as one electrode plate of a capacitor and may have a potential of the second node N2, and the compensation electrode 27 may serve as the other electrode plate of the capacitor. Since the second electrode plate 26 is configured to be connected with a first power supply line formed subsequently, the compensation electrode 27 has a potential of the first power supply line, and the compensation electrode 27 and the second node N2 of the pixel drive circuit form a second node capacitor C_{N2}, which may have a function of stabilizing a voltage of the second node N2.

In an exemplary implementation mode, in at least one circuit unit, the second electrode plate 26 and the compensation electrode 27 may be of an interconnected integral structure.

In an exemplary implementation mode, an electrode plate connection line 26-1 may be disposed on the second electrode plate 26. The electrode plate connection line 26-1 may be in a shape of a strip extending along the first direction X, and may be disposed at a side of the second electrode plate 26 in the first direction X. A first end of the electrode plate connection line 26-1 is connected with the second electrode plate 26 of the present circuit unit, and a second end of the electrode plate connection line 26-1 is connected with a compensation electrode 27 of an adjacent circuit unit after extending along the first direction X, so that second electrode plates 26 of adjacent circuit units in one unit row are connected with each other through compensation electrodes 27 and electrode plate connection lines 26-1.

In an exemplary implementation mode, in at least one unit row, second electrode plates 26, compensation electrodes 27, and electrode plate connection lines 26-1 of a plurality of circuit units may be of an interconnected integral structure. The integral structure of the second electrode plates 26, the compensation electrodes 27, and the electrode plate connection lines 26-1 may be multiplexed as a power supply signal connection line, which ensures that a plurality of second electrode plates in one unit row have a same potential, and is beneficial to improve uniformity of a panel, thus avoiding poor display of the display substrate, and ensuring a display effect of the display substrate.

In an exemplary implementation mode, an opening 26-2 may be disposed on the second electrode plate 26 and located in a middle part of the second electrode plate 26, and the opening 26-2 may be in a shape of a block (such as a rectangle), so that the second electrode plate 26 forms an annular structure. The opening 26-2 exposes the third insulation layer covering the first electrode plate 25, and an orthographic projection of the first electrode plate 25 on the base substrate contains an orthographic projection of the opening 26-2 on the base substrate. In an exemplary implementation mode, the opening 26-2 is configured to accommodate an eleventh via formed subsequently, the eleventh via is located within the opening 26-2 and exposes the first electrode plate 25, so that a first connection electrode formed subsequently is connected with the first electrode plate 25.

In an exemplary implementation mode, the shield electrode 28 may be in a shape of a character "L", and may be located at a side of the second electrode plate 26 in an opposite direction of the second direction Y. An orthographic projection of the shield electrode 28 on the base substrate is at least partially overlapped with an orthographic projection of the first active block 11A on the base substrate, and is at least partially overlapped with an orthographic projection of the second active block 12A on the base substrate. An end of the shield electrode 28 close to the second electrode plate 26 is connected with the second electrode plate 26. Since the first active block 11A is disposed between the two gate electrodes of the first transistor T1, the shield electrode 28 may effectively prevent data voltage jump from affecting a first active layer between the two gate electrodes of the first transistor T1, prevent the data voltage jump from affecting normal working of the pixel drive circuit, and improve a display effect. Since the second active block 12A is disposed between the two gate electrodes of the second transistor T2, the shield electrode 28 may effectively prevent data voltage jump from affecting a second active layer between the two gate electrodes of the second transistor T2, prevent the data voltage jump from affecting the normal working of the pixel drive circuit, reduce crosstalk, and improve a display effect.

In an exemplary implementation mode, in at least one circuit unit, the second electrode plate 26 and the shield electrode 28 may be of an interconnected integral structure, that is, the shield electrode 28 is a part of the second electrode plate 26 protruding along the second direction Y.

In an exemplary implementation mode, a length and a width of the shield electrode 28 may be adjusted according to a situation of layout space, and the shield electrode 28 may also be used to form a capacitor, etc., and the present disclosure is not limited thereto.

In an exemplary implementation mode, the repair line 37 may be in a shape of a straight line or a polyline in which a main body portion extends along the first direction X, and may be disposed between the light emitting control line 35 and the scan connection line 36. The repair line 37 is configured as a repair line for a large-sized display substrate, and in a case that a defect occurs in the pixel drive circuit, the repair line 37 may be connected to a light emitting device separated from the pixel drive circuit, to quickly repair the light emitting device that cannot be lit, which may effectively improve a yield.

In an exemplary implementation mode, the first initial signal line 41 may be in shape of a straight line or a polyline in which a main body portion extends along the first direction X, and may be disposed at a side of the first gate electrode 21 away from the first electrode plate 26, and an orthographic projection of the first initial signal line 41 on the base substrate is at least partially overlapped with an orthographic projection of the first active connection line 10 on the base substrate.

In an exemplary implementation mode, in at least one repeating unit, the first initial signal line 41 may include a first initial connection portion 41-1 and a first initial bending portion 41-2. The first initial connection block 41-1 may be in a shape of a block (such as a rectangle), and may be disposed at a side of the first initial signal line 41 away from the second electrode plate 26, an orthographic projection of the first initial connection block 41-1 on the base substrate is at least partially overlapped with an orthographic projection of the first active connection block 10A on the base substrate, and the first initial connection block 41-1 is configured to be connected with the first active connection block 10A through a sixth connection electrode formed subsequently. The first initial bending portion 41-2 may be in a shape of an arc protruding toward a direction close to the second electrode plate 26, and a first groove 41-3 exposing the first active connection block 10A is formed, the first groove 41-3 being configured to accommodate a thirteenth via formed subsequently.

In an exemplary implementation mode, the third initial signal line 43 may be in a shape of a straight line or a polyline in which a main body portion extends along the first direction X, and may be disposed at a side of the first connection line 81 away from the light emitting control line 35, and an orthographic projection of the third initial signal line 43 on the base substrate is at least partially overlapped with an orthographic projection of the third active connection line 30 on the base substrate .

In an exemplary implementation mode, in at least one repeating unit, the third initial signal line 43 may include a third initial connection portion 43-1 and a third initial bending portion 43-2. The third initial connection portion 43-1 may be in a shape of a block (such as a rectangle), and may be disposed at a side of the third initial signal line 43 away from the second electrode plate 26, an orthographic projection of the third initial connection portion 43-1 on the base substrate is at least partially overlapped with an orthographic projection of the third active connection block 30A on the base substrate, and the third initial connection portion 43-1 is configured to be connected with the third active connection block 30A through a seventh connection electrode formed subsequently. The third initial bending portion 43-2 may be in a shape of an arc protruding toward a direction close to the second electrode plate 26, and a third groove 43-3 exposing the third active connection block 30A is formed, the third groove 43-3 being configured to accommodate a fifteenth via formed subsequently.

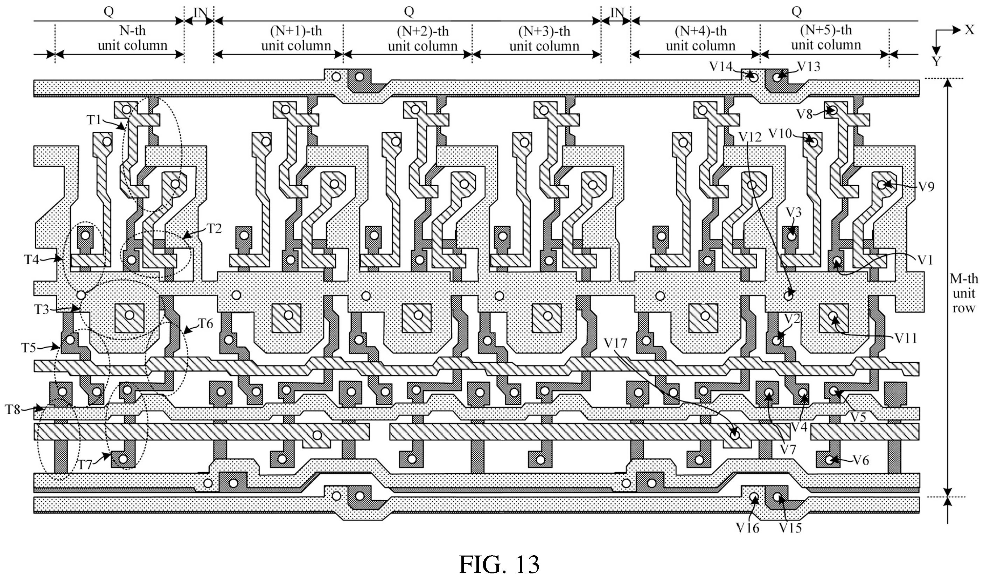

(14) Forming a pattern of a fourth insulation layer. In an exemplary implementation mode, forming the pattern of the fourth insulation layer may include: depositing a fourth insulation thin film on the base substrate on which the aforementioned patterns are formed, and patterning the fourth insulation thin film through a patterning process to form the fourth insulation layer that covers the second conductive layer, wherein each circuit unit is provided with a plurality of vias, as shown in FIG. 13. FIG. 13 is a schematic diagram of a structure of a region A in FIG. 8, and a via structure of a region B in FIG. 8 is substantially the same as that of the region A in FIG. 8.

In an exemplary implementation mode, the plurality of vias of each circuit unit in the display region at least include: a first via V1, a second via V2, a third via V3, a fourth via V4, a fifth via V5, a sixth via V6, a seventh via V7, an eighth via V8, a ninth via V9, a tenth via V10, an eleventh via V11, and a twelfth via V12.

In an exemplary implementation mode, an orthographic projection of the first via V1 on the base substrate is within a range of an orthographic projection of the second region of the first active layer (that is, the first region of the second active layer) on the base substrate. The fourth insulation layer, the third insulation layer, and the second insulation layer within the first via V1 are etched away to expose a surface of the second region of the first active layer (that is, the first region of the second active layer), and the first via V1 is configured such that a first connection electrode formed subsequently is connected with the second region of the first active layer (that is, the first region of the second active layer) through this via.

In an exemplary implementation mode, an orthographic projection of the second via V2 on the base substrate is within a range of an orthographic projection of the first region of the third active layer (which is also the second region of the fourth active layer and the second region of the fifth active layer) on the base substrate, the fourth insulation layer, the third insulation layer, and the second insulation layer within the second via V2 are etched away to expose a surface of the first region of the third active layer (which is also the second region of the fourth active layer and the second region of the fifth active layer), and the second via V2 is configured such that a subsequently formed second connection electrode is connected with the first region of the third active layer (which is also the second region of the fourth active layer and the second region of the fifth active layer) through this via.

In an exemplary implementation mode, an orthographic projection of the third via V3 on the base substrate is within a range of an orthographic projection of the first region of the fourth active layer on the base substrate, the fourth insulation layer, the third insulation layer, and the second insulation layer within the third via V3 are etched away to expose a surface of the first region of the fourth active layer, and the third via V3 is configured such that a third connection line formed subsequently is connected with the first region of the fourth active layer through this via.

In an exemplary implementation mode, an orthographic projection of the fourth via V4 on the base substrate is within a range of an orthographic projection of the first region of the fifth active layer on the base substrate, the fourth insulation layer, the third insulation layer, and the second insulation layer within the fourth via V4 are etched away to expose a surface of the first region of the fifth active layer, and the fourth via V4 is configured such that a fifth connection electrode formed subsequently is connected with the first region of the fifth active layer through this via.

In an exemplary implementation mode, an orthographic projection of the fifth via V5 on the base substrate is within a range of an orthographic projection of a second region of the sixth active layer (which is also a second region of the seventh active layer) on the base substrate, the fourth insulation layer, the third insulation layer, and the second insulation layer within the fifth via V5 are etched away to expose a surface of the second region of the sixth active layer (which is also the second region of the seventh active layer), and the fifth via V5 is configured such that a fourth connection electrode formed subsequently is connected with the second region of the sixth active layer (which is also the second region of the seventh active layer) through this via.

In an exemplary implementation mode, an orthographic projection of the sixth via V6 on the base substrate is within a range of an orthographic projection of the first region of the seventh active layer on the base substrate, the fourth insulation layer, the third insulation layer, and the second insulation layer within the sixth via V6 are etched away to expose a surface of the first region of the seventh active layer, and the sixth via V6 is configured such that a subsequently formed second initial signal line is connected with the first region of the seventh active layer through the via.

In an exemplary implementation mode, an orthographic projection of the seventh via V7 on the base substrate is within a range of an orthographic projection of the second region of the eighth active layer on the base substrate, the fourth insulation layer, the third insulation layer, and the second insulation layer within the seventh via V7 are etched away to expose a surface of the second region of the eighth active layer, and the seventh via V7 is configured such that a second connection electrode formed subsequently is connected with the second region of the eighth active layer through this via.

In an exemplary implementation mode, an orthographic projection of the eighth via V8 on the base substrate is within a range of an orthographic projection of the first gate connection block 21-1 of the first gate electrode 21 on the base substrate, the fourth insulation layer and the third insulation layer within the eighth via V8 are etched away to expose a surface of the first gate connection block 21-1, and the eighth via V8 is configured such that a fourth scan signal line formed subsequently is connected with the first gate connection block 21-1 through this via.

In an exemplary implementation mode, an orthographic projection of the ninth via V9 on the base substrate is within a range of an orthographic projection of the second gate connection block 22-1 of the second gate electrode 22 on the base substrate, the fourth insulation layer and the third insulation layer within the ninth via V9 are etched away to expose a surface of the second gate connection block 22-1, and the ninth via V9 is configured such that a first scan signal line formed subsequently is connected with the second gate connection block 22-1 through this via.

In an exemplary implementation mode, an orthographic projection of the tenth via V10 on the base substrate is within a range of an orthographic projection of the fourth gate connection block 24-1 of the fourth gate electrode 24 on the base substrate, the fourth insulation layer and the third insulation layer within the tenth via V10 are etched away to expose a surface of the fourth gate connection block 24-1, and the tenth via V10 is configured such that a second scan signal line formed subsequently is connected with the fourth gate connection block 24-1 through this via.

In an exemplary implementation mode, an orthographic projection of the eleventh via V11 on the base substrate is within a range of an orthographic projection of the opening 26-2 of the second electrode plate 26 on the base substrate, the fourth insulation layer and the third insulation layer within the eleventh via V11 are etched away to expose a surface of the first electrode plate 25, and the eleventh via V11 is configured such that a first connection electrode formed subsequently is connected with the first electrode plate 25 through this via.

In an exemplary implementation mode, an orthographic projection of the twelfth via V12 on the base substrate is within a range of an orthographic projection of the compensation electrode 27 on the base substrate, the fourth insulation layer within the twelfth via V12 is etched away to expose a surface of the compensation electrode 27, and the twelfth via V12 is configured such that a power supply connection line formed subsequently is connected with the compensation electrode 27 through this via.

In an exemplary implementation mode, a thirteenth via V13, a fourteenth via V14, a fifteenth via V15, a sixteenth via V16, and a seventeenth via V17 may be further included in at least one repeating unit.

In an exemplary implementation mode, an orthographic projection of the thirteenth via V13 on the base substrate is within a range of an orthographic projection of the first active connection block 10A of the first active connection line 10 on the base substrate, the fourth insulation layer, the third insulation layer, and the second insulation layer within the thirteenth via V13 are etched away to expose a surface of the first active connection block 10A, and the thirteenth via V13 is configured such that a sixth connection electrode formed subsequently is connected with the first active connection block 10A through this via.

In an exemplary implementation mode, an orthographic projection of the fourteenth via V14 on the base substrate is within a range of an orthographic projection of the first initial connection portion 41-1 of the first initial signal line 41 on the base substrate, the fourth insulation layer within the fourteenth via V14 is etched away to expose a surface of the first initial connection portion 41-1, and the fourteenth via V14 is configured such that a sixth connection electrode formed subsequently is connected with the first initial connection portion 41-1 through this via.

In an exemplary implementation mode, an orthographic projection of the fifteenth via V15 on the base substrate is within a range of an orthographic projection of the third active connection block 30A of the third active connection line 30 on the base substrate, the fourth insulation, the third insulation layer, and the second insulation layer within the fifteenth via V15 are etched away to expose a surface of the third active connection block 30A, and the fifteenth via V15 is configured such that a seventh connection electrode formed subsequently is connected with the third active connection block 30A through this via.

In an exemplary implementation mode, an orthographic projection of the sixteenth via V16 on the base substrate is within a range of an orthographic projection of the third initial connection portion 43-1 of the third initial signal line 43 on the base substrate, the fourth insulation layer within the sixteenth via V16 is etched away to expose a surface of the third initial connection portion 43-1, and the sixteenth via V16 is configured such that a seventh connection electrode formed subsequently is connected with the third initial connection portion 43-1 through this via.

In an exemplary implementation mode, an orthographic projection of the seventeenth via V17 on the base substrate is within a range of an orthographic projection of the first scan connection block 36-1 of the scan connection line 36 on the base substrate, the fourth insulation layer and the third insulation layer within the seventeenth via V17 are etched away to expose a surface of the first scan connection block 36-1, and the seventeenth via V17 is configured such that a third scan signal line formed subsequently is connected with the first scan connection block 36-1 through this via.

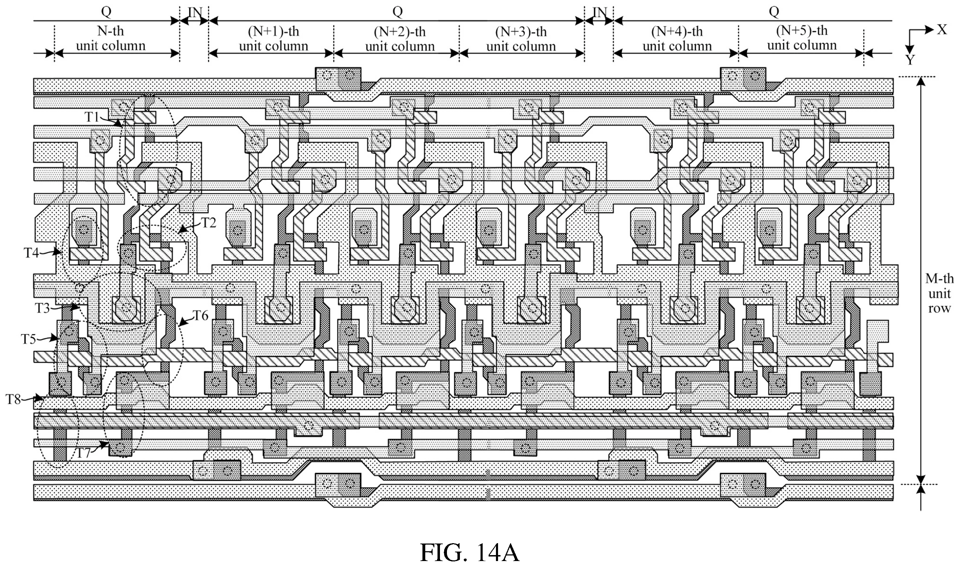

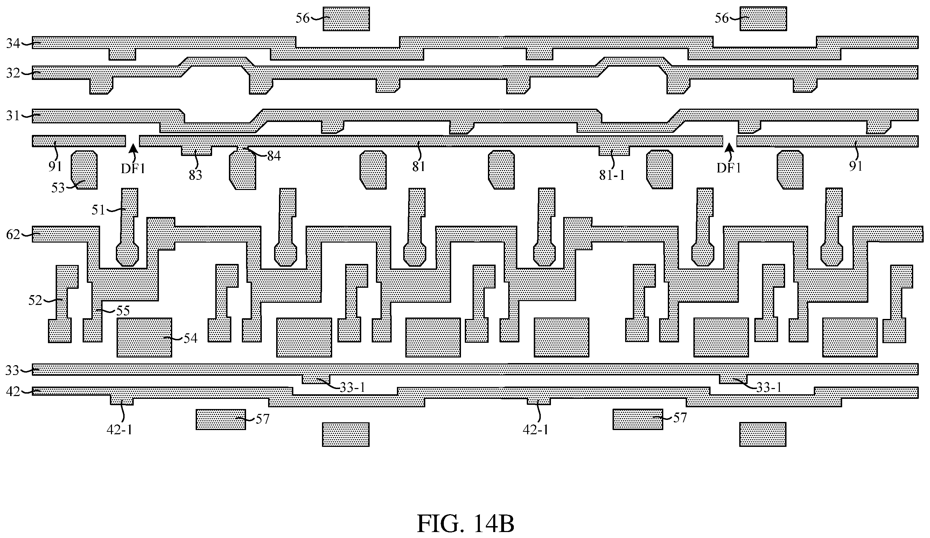

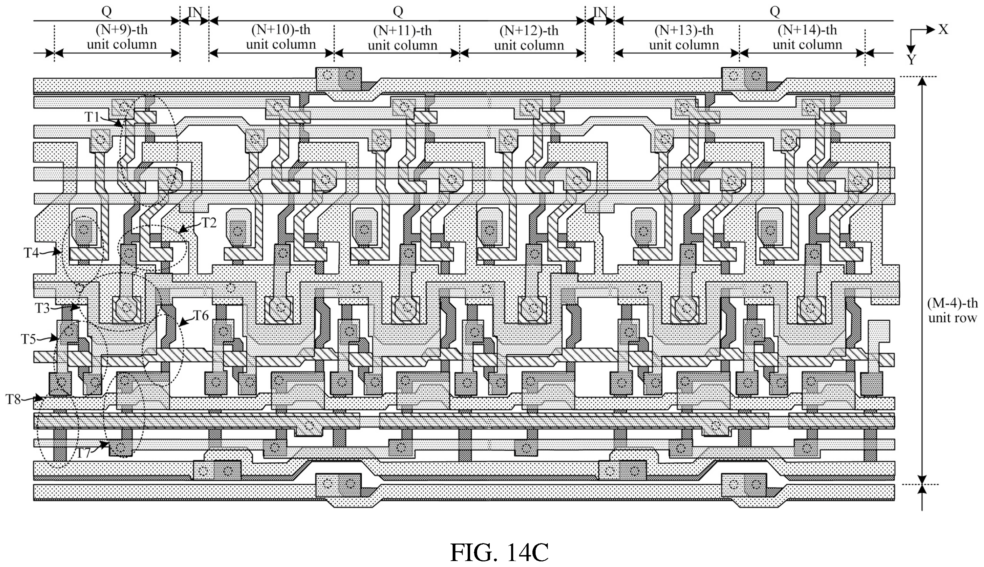

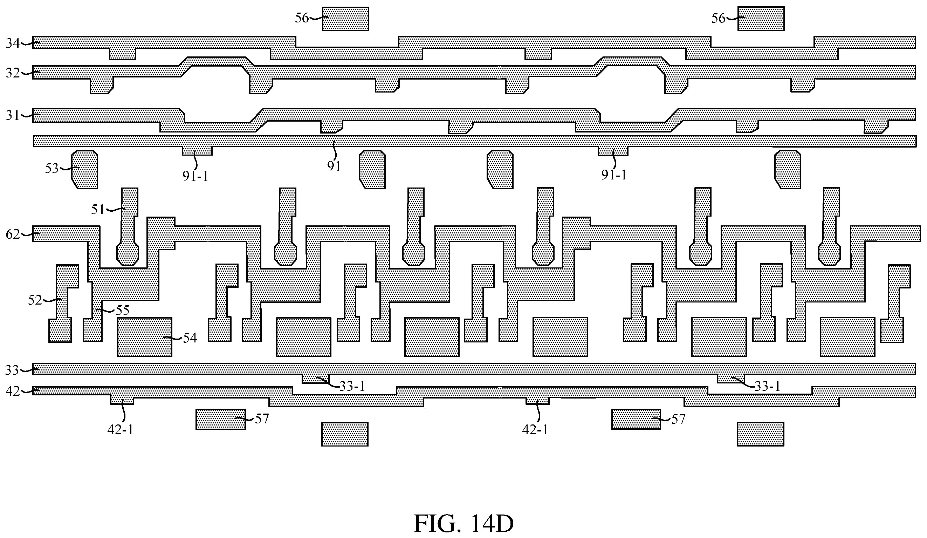

(15) Forming a pattern of a third conductive layer. In an exemplary implementation mode, forming the third conductive layer may include: depositing a third conductive thin film on the base substrate on which the afore-mentioned patterns are formed, and patterning the third conductive thin film through a patterning process, to form the third conductive layer disposed on the fourth insulation layer, as shown in FIGs. 14A, 14B, 14C, and 14D, wherein FIG. 14A is a schematic diagram of a structure of a region A in FIG. 8, FIG. 14B is a schematic plan diagram of the third conductive layer in FIG. 14A, FIG. 14C is a schematic diagram of a structure of a region B in FIG. 8, and FIG. 14D is a schematic plan diagram of the third conductive layer in FIG. 14C. In an exemplary implementation mode, the third conductive layer may be referred to as a first source-drain metal (SD1) layer.

In an exemplary implementation mode, the pattern of the third conductive layer of each circuit unit in the display region includes: a first scan signal line 31, a second scan signal line 32, a third scan signal line 33, a fourth scan signal line 34, a second initial signal line 42, a first connection electrode 51, a second connection electrode 52, a third connection electrode 53, a fourth connection electrode 54, a fifth connection electrode 55, and a power supply connection line 62.

In an exemplary implementation mode, the first scan signal line 31 may be in a shape of a straight line or a polyline in which a main body portion extends along the first direction X, and may be disposed at a side of the second electrode plate 26 in an opposite direction of the second direction Y, and the first scan signal line 31 is connected with the second gate connection block 22-1 in each circuit unit through the ninth via V9. Since the second gate connection block 22-1 is connected with the second gate electrode 22, it is achieved that the first scan signal line 31 is connected with the gate electrode of the second transistor T2 in each circuit unit, and the second gate electrode 22 located in the first conductive layer and the first scan signal line 31 located in the third conductive layer form a double-layer parallel structure, and the first scan signal line 31 may control turn-on or turn-off of the second transistor T2 in each circuit unit.

In an exemplary implementation mode, the second scan signal line 32 may be in a shape of a straight line or a polyline in which a main body portion extends along the first direction X, and may be disposed at a side of the first scan signal line 31 away from the second electrode plate 26, and the second scan signal line 32 is connected with the fourth gate connection block 24-1 through the tenth via V10. Since the fourth gate connection block 24-1 is connected with the fourth gate electrode 24, the fourth gate electrode 24 located in the first conductive layer and the second scan signal line 32 located in the third conductive layer form a double-layer parallel structure, therefore it is achieved that the second scan signal line 32 is connected with the gate electrode of the fourth transistor T4 in each circuit unit, and the second scan signal line 32 may control turn-on or turn-off of the fourth transistor T4 in each circuit unit.

In an exemplary implementation mode, the third scan signal line 33 may be in a shape of a straight line or a polyline in which a main body portion extends along the first direction X, and may be disposed at a side of the repair line 37 away from the second electrode plate 26, and an orthographic projection of the third scan signal line 33 on the base substrate is at least partially overlapped with an orthographic projection of the scan connection line 36 on the base substrate.

In an exemplary implementation mode, in at least one repeating unit, a second scan connection block 33-1 may be disposed on the third scan signal line 33. The second scan connection block 33-1 may be in a shape of a block (such as a rectangle), may be disposed at a side of the third scan signal line 33 away from the second electrode plate 26, and may be connected with the third scan signal line 33. An orthographic projection of the second scan connection block 33-1 on the base substrate is at least partially overlapped with an orthographic projection of the scan connection block 36-1 on the base substrate, and the second scan connection block 33-1 is connected with the scan connection block 36-1 through the seventeenth via V17. Since the scan connection block 36-1 is connected with the scan connection line 36 and the second scan connection block 33-1 is connected with the third scan signal line 33, it is achieved that the third scan signal line 33 is connected with the gate electrode of the seventh transistor T7 and the gate electrode of the eighth transistor T8 in each circuit unit, and the third scan signal line 33 may control turn-on or turn-off of the seventh transistor T7 and the eighth transistor T8 in each circuit unit.

In an exemplary implementation mode, the scan connection line 36 and the third scan signal line 33 form a scan signal line with a double-layer parallel structure, which may effectively reduce a resistance of the third scan signal line 33, reduce a voltage drop of a third scan signal, and improve performance of the pixel drive circuit.

In an exemplary implementation mode, the second scan connection block 33-1 may be disposed in circuit units of the (N+1)-th unit column and the (N+4)-th unit column. In at least one repeating unit, the third scan signal line 33 and the second scan connection block 33-1 may be of an interconnected integral structure.

In an exemplary implementation mode, the fourth scan signal line 34 may be in a shape of a straight line or a polyline in which a main body portion extends along the first direction X, and may be disposed at a side of the second scan signal line 32 away from the second electrode plate 26, and the fourth scan signal line 34 is connected with the first gate connection block 21-1 through the eighth via V8. Since the first gate connection block 21-1 is connected with the first gate electrode 21, the first gate electrode 21 located in the first conductive layer and the fourth scan signal line 34 located in the third conductive layer form a double-layer parallel structure, therefore it is achieved that the fourth scan signal line 34 is connected with the gate electrode of the first transistor T1 in each circuit unit, and the fourth scan signal line 34 may control turn-on or turn-off of the first transistor T1 in each circuit unit.

In the present disclosure, the first scan signal line 31, the second scan signal line 32, the third scan signal line 33, and the fourth scan signal line 34 are disposed in the third conductive layer, which may effectively reduce a resistance of a scan signal line, reduce a voltage drop of a scan signal, and improve performance of the pixel drive circuit.

In an exemplary implementation mode, the second initial signal line 42 may be in a shape of a straight line or a polyline in which a main body portion extends along the first direction X, and may be disposed at a side of the third scan signal line 33 away from the second electrode plate 26, and the second initial signal line 42 is connected with the first region of the seventh active layer in each circuit unit through the sixth via V6, so it is achieved that the second initial signal line 42 writes a second initial signal into the first electrode of the seventh transistor T7 in each circuit unit.

In an exemplary implementation mode, the power supply connection line 62 may be in a shape of a polyline extending along the first direction X, and may be disposed between the first scan signal line 31 and the third scan signal line 33. The power supply connection line 62 is connected with a compensation electrode 27 in each circuit unit through the twelfth via V12, and the power supply connection line 62 is configured to be connected with a first power supply line formed subsequently.

In an exemplary implementation mode, the first connection electrode 51 may be in a shape of a strip extending along the second direction Y, a first end of the first connection electrode 51 is connected with the first electrode plate 25 through the eleventh via V11, and a second end of the first connection electrode 51 is connected with the second region of the first active layer (which is also the first region of the second active layer) through the first via V1. In an exemplary implementation mode, since the first electrode plate 25 may serves as the gate electrode of the third transistor T3, the first connection electrode 51 achieves interconnections among the second electrode of the first transistor T1, the first electrode of the second transistor T2, the gate electrode of the third transistor T3, and the first electrode plate 25, forming a first node N1 of the pixel drive circuit.

In an exemplary implementation mode, the second connection electrode 52 may be in a shape of a strip extending along the second direction Y, a first end of the second connection electrode 52 is connected with the first region of the third active layer (which is also the second region of the fourth active layer and the second region of the fifth active layer) through the second via V2, and a second end of the second connection electrode 52 is connected with the second region of the eighth active layer through the seventh via V7. In an exemplary implementation mode, the second connection electrode 52 achieves interconnections among the first electrode of the third transistor T3, the second electrode of the fourth transistor T4, the second electrode of the fifth transistor T5, and the second electrode of the eighth transistor T8, forming a second node N2 of the pixel drive circuit.

In an exemplary implementation mode, the third connection electrode 53 may be in a shape of a block (such as a rectangle), the third connection electrode 53 is connected with the first region of the fourth active layer through the third via V3, and the third connection electrode 53 is configured to be connected with a data signal line formed subsequently. In an exemplary implementation mode, the third connection electrode 53 may serve as a data connection electrode of the present disclosure.

In an exemplary implementation mode, in at least one repeating unit, third connection electrodes 53 of a plurality of circuit units may all be disposed a side of the first scan signal line 31 close to the second electrode plate 26, and the plurality of third connection electrodes 53 may be located on a same straight line extending along the first direction X.

In an exemplary implementation mode, the fourth connection electrode 54 may be in a shape of a block (such as a rectangle), the fourth connection electrode 54 is connected with the second region of the sixth active layer (which is also the second region of the seventh active layer) through the fifth via V5, and the fourth connection electrode 54 is configured to be connected with an anode connection electrode formed subsequently.

In an exemplary implementation mode, the fifth connection electrode 55 may be in a shape of a strip extending along the second direction Y, and may be disposed at a side of the power supply connection line 62 away from the first scan signal line 31. A first end of the fifth connection electrode 55 is connected with the first region of the fifth active layer through the fourth via V4, and a second end of the fifth connection electrode 55 is connected with the power supply connection line 62. Since the power supply connection line 62 is connected with a first power supply line formed subsequently, the fifth connection electrode 55 achieves that the first power supply line writes a first power supply signal into the first electrode of the fifth transistor T5.

In an exemplary implementation mode, in at least one circuit unit, the fifth connection electrode 55 and the power supply connection line 62 may be of an interconnected integral structure.

In an exemplary implementation mode, in at least one repeating unit, the third conductive layer may further include a sixth connection electrode 56 and a seventh connection electrode 57.

In an exemplary implementation mode, the sixth connection electrode 56 may be in a shape of a strip extending along the first direction X, and may be disposed at a side the fourth scan signal line 34 away from the second electrode plate 26. A first end of the sixth connection electrode 56 is connected with the first active connection block 10A through the thirteenth via V13, and a second end of the sixth connection electrode 56 is connected with the first initial connection portion 41-1 through the fourteenth via V14. Since the first active connection block 10A is connected with the first active connection line 10, and the first initial connection portion 41-1 is connected with the first initial signal line 41, the sixth connection electrode 56 achieves a connection between the first initial signal line 41 and the first active connection line 10, and a first initial signal line with a double-layer parallel structure is formed, which may effectively reduce a resistance of the first initial signal line, reduce a voltage drop of the first initial signal, may effectively improve uniformity of the first initial signal, effectively improve display uniformity, and improve display attribute and display quality.

In an exemplary implementation mode, since the first active connection line 10 is connected with the first region of the first active layer in each circuit unit, it is achieved that the first initial signal line 41 writes a first initial signal into the first electrode of the first transistor T1 in each circuit unit.

In an exemplary implementation mode, the seventh connection electrode 57 may be in a shape of a strip extending along the first direction X, and may be disposed at a side of the second initial signal line 42 away from the second electrode plate 26. A first end of the seventh connection electrode 57 is connected with the third active connection block 30A through the fifteenth via V15, and a second end of the seventh connection electrode 57 is connected with the third initial connection portion 43-1 through the sixteenth via V16. Since the third active connection block 30A is connected with the third active connection line 30, and the third initial connection portion 43-1 is connected with the third initial signal line 43, the seventh connection electrode 57 achieves a connection between the third initial signal line 43 and the third active connection line 30 and a third initial signal line with a double-layer parallel structure is formed, which may effectively reduce a resistance of the third initial signal line, reduce a voltage drop of a third initial signal, may effectively improve uniformity of the third initial signal, effectively improve display uniformity, and improve display attribute and display quality.

In an exemplary implementation mode, since the third active connection line 30 is connected with the first region of the eighth active layer in each circuit unit, it is achieved that the third initial signal line 43 writes a third initial signal into the first electrode of the eighth transistor T8 in each circuit unit.

In an exemplary implementation mode, the sixth connection electrode 56 may be disposed in a boundary region between the (N+1)-th unit column and the (N+2)-th unit column, and in a boundary region between the (N+4)-th unit column and the (N+5)-th unit column, respectively, and the seventh connection electrode 57 may be disposed in circuit units of the (N+1)-th unit column and the (N+4)-th unit column, respectively.

As shown in FIG. 14A and FIG. 14B, the third conductive layer of the first region (FIP region) may further include a first connection line 81 and a first constant voltage trace 91.

In an exemplary implementation mode, the first connection line 81 and the first constant voltage trace 91 each may be in a shape of a straight line or a polyline extending along the first direction X, and may be disposed between the first scan signal line 31 and the second electrode plate 26 (that is, between the first scan signal line 31 and the power supply connection line 62).

In an exemplary implementation mode, a first connection block 81-1 may be disposed on the first connection line 81. The first connection block 81-1 may be in a shape of a block (such as a rectangle), may be disposed at a side of the first connection line 81 close to the second electrode plate 26, and may be connected with the first connection line 81, and the first connection block 81-1 is configured to be connected with a second connection line formed subsequently.

In an exemplary implementation mode, the first connection block 81-1 may be disposed in an insertion column, and the first connection line 81 and the first connection block 81-1 may be of an interconnected integral structure. For example, the first connection block 81-1 may be disposed in an insertion column between the (N+3)-th unit column and the (N+4)-th unit column.

In an exemplary implementation mode, at least one dummy connection block 83 may further be disposed on the first connection line 81. The dummy connection block 83 may be in a shape of a block (such as a rectangle), may be disposed at a side of the first connection line 81 close to the second electrode plate 26, and may be connected with the first connection line 81.

In an exemplary implementation mode, the dummy connection block 83 may be disposed in an insertion column, and the first connection line 81 and the dummy connection block 83 may be of an interconnected integral structure. For example, the dummy connection block 83 may be disposed in an insertion column between the N-th unit column and the (N+1)-th unit column.

In an exemplary implementation mode, a position and a shape of the dummy connection block 83 in one insertion column may be substantially the same as a position and a shape of the first connection block 81-1 in another insertion column, except that the first connection block 81-1 is configured to be connected with a second connection line formed subsequently, while the dummy connection block 83 is not connected with the second connection line or other traces. Through a same design of a transfer region, in the present disclosure, not only uniformity of a subsequent etching process may be improved, but also a same display effect may be achieved in different positions under transmitted and reflected light, display uniformity is improved and shadow elimination is achieved, which effectively avoids poor appearance and screen-off watermark (mura) of the display substrate, and improves display attribute and display quality.

In an exemplary implementation mode, a data connection block 84 may be further disposed in at least one circuit unit. The data connection block 84 may be in a shape of a block (such as a rectangle), and may be disposed between the first connection line 81 and the third connection electrode 53, wherein a first end of the data connection block 84 is connected with the first connection line 81, and a second end of the data connection block 84 is connected with the third connection electrode 53.

In an exemplary implementation mode, the data connection block 84 may be disposed in circuit unit of the M-th unit row and the (N+1)-th unit column, and the first connection line 81, the data connection block 84, and the third connection electrode 53 may be of an interconnected integral structure.

In an exemplary implementation mode, at least one repeating unit row may be provided with at least one first connection line 81 and at least one first constant voltage trace 91. A first fracture DF1 may be disposed between the first connection line 81 and the first constant voltage trace 91 to realize mutual insulation between the first connection line 81 and the first constant voltage trace 91.

In an exemplary implementation mode, a width of the first constant voltage trace 91 may be equal to a width of the first connection line 81. In another exemplary implementation mode, the width of the first connection line 81 may be different from the width of the first constant voltage trace 91. Herein, widths of the first connection line 81 and the first constant voltage trace 91 are dimensions in the second direction Y.

As shown in FIG. 14C and FIG.14D, the third conductive layer of the second region (non-FIP region) may further include a first constant voltage trace 91.

In an exemplary implementation mode, the first constant voltage trace 91 may be in a shape of a straight line or a polyline extending along the first direction X, and may be disposed between the first scan signal line 31 and the second electrode plate 26 (which is also between the first scan signal line 31 and the power supply connection line 62).

In an exemplary implementation mode, at least one repeating unit row may be provided with only a first constant voltage trace 91, with no first connection line being disposed in this repeating unit row.

In an exemplary implementation mode, at least one first constant voltage connection block 91-1 may be disposed on the first constant voltage trace 91. The first constant voltage connection block 91-1 may be in a shape of a block (such as a rectangle), may be disposed at a side of the first constant voltage trace 91 close to the second electrode plate 26, and may be connected with the first constant voltage trace 91, and the first constant voltage connection block 91-1 is configured to be connected with a second constant voltage trace formed subsequently.

In an exemplary implementation mode, the first constant voltage connection block 91-1 may be disposed in an insertion column, and the first constant voltage trace 91 and the first constant voltage connection block 91-1 may be of an interconnected integral structure. For example, the first constant voltage connection block 91-1 may be disposed in an insertion column between the (N+9)-th unit column and the (N+10)-th unit column, and an insertion column between the (N+12)-th unit column and the (N+13)-th unit column, respectively.

In an exemplary implementation mode, a bezel region may be provided with a bezel constant voltage lead line which may transmit a first power supply signal or a second power supply signal. At least one first constant voltage trace 91 may extend to the bezel region and then be connected with the bezel constant voltage lead line, therefore the first constant voltage trace 91 is a trace for transmitting a first power supply signal or a second power supply signal.

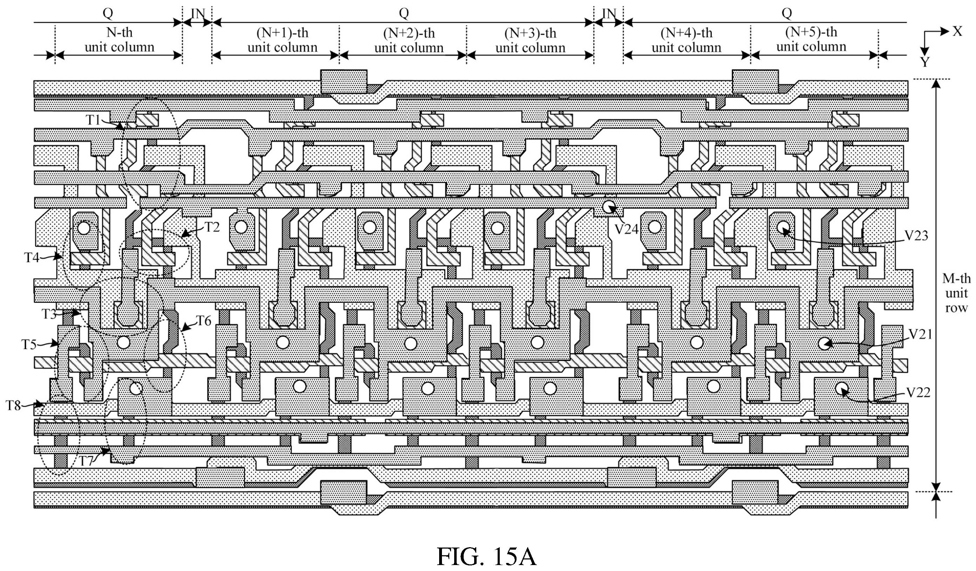

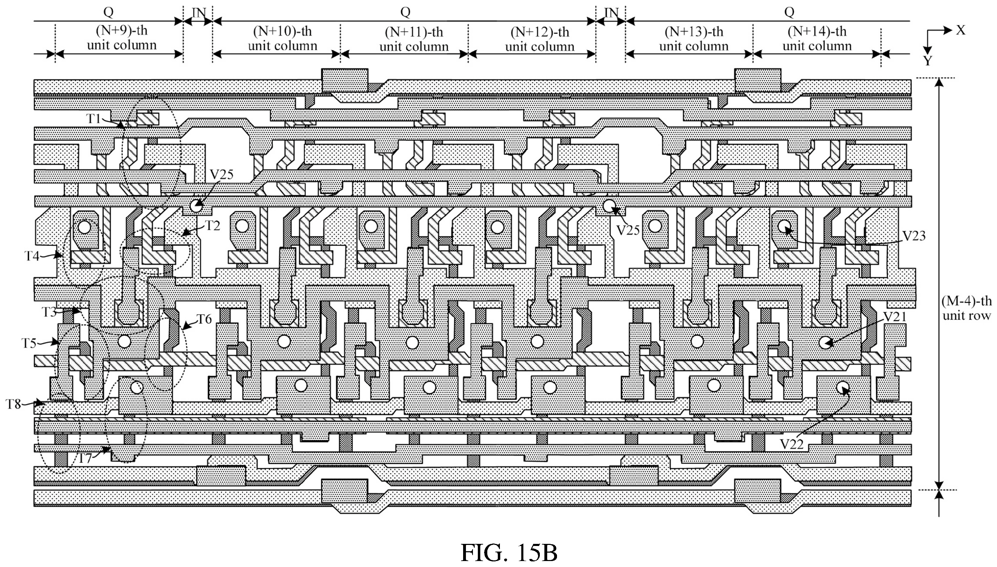

(16) Forming a pattern of a first planarization layer. In an exemplary implementation mode, forming the pattern of the first planarization layer may include: coating a first planarization thin film on the base substrate on which the abovementioned patterns are formed, and patterning the first planarization thin film through a patterning process to form the first planarization layer covering the third conductive layer, the first planarization layer being provided with a plurality of vias, as shown in FIG. 15A and FIG. 15B, wherein FIG. 15A is a schematic diagram of a structure of a region A in FIG. 8, and FIG. 15B is a schematic diagram of a structure of a region B in FIG. 8.

In an exemplary implementation mode, the plurality of vias of each circuit unit in the display region include: a twenty-first via V21, a twenty-second via V22, and a twenty-third via V23.

In an exemplary implementation mode, an orthographic projection of the twenty-first via V21 on the base substrate is within a range of an orthographic projection of the power supply connection line 62 on the base substrate, the first planarization layer within the twenty-first via V21 is removed to expose a surface of the power supply connection line 62, and the twenty-first via V21 is configured such that a first power supply line formed subsequently is connected with the power supply connection line 62 through this via.

In an exemplary implementation mode, an orthographic projection of the twenty-second via V22 on the base substrate is within a range of an orthographic projection of the fourth connection electrode 54 on the base substrate, the first planarization layer within the twenty-second via V22 is removed to expose a surface of the fourth connection electrode 54, and the twenty-second via V22 is configured such that an anode connection electrode formed subsequently is connected with the fourth connection electrode 54 through this via.

In an exemplary implementation mode, an orthographic projection of the twenty-third via V23 on the base substrate is within a range of an orthographic projection of the third connection electrode 53 on the base substrate, the first planarization layer within the twenty-third via V23 is removed to expose a surface of the third connection electrode 53, and the twenty-third via V23 is configured such that a data signal line formed subsequently is connected with the third connection electrode 53 through this via.

In an exemplary implementation mode, since a third connection electrode 53 in the circuit unit of the M-th unit row and the (N+1)-th unit column is connected with the first connection line 81 through the data connection block 84, a twenty-third via V23 in the circuit unit of the M-th unit row and the (N+1)-th unit column may serve as a first connection hole of the present disclosure.

As shown in FIG. 15A, the first planarization layer of the first region may further include a twenty-fourth via V24. In an exemplary implementation mode, an orthographic projection of the twenty-fourth via V24 on the base substrate is within a range of an orthographic projection of the first connection block 81-1 of the first connection line 81 on the base substrate, the first planarization layer within the twenty-fourth via V24 is removed to expose a surface of the first connection block 81-1, and the twenty-fourth via V24 is configured such that a second connection line formed subsequently is connected with the first connection block 81-1 through this via. In an exemplary implementation mode, the twenty-fourth via V24 may serve as a second connection hole of the present disclosure.

As shown in FIG. 15B, the first planarization layer of the second region may further include a twenty-fifth via V25. In an exemplary implementation mode, an orthographic projection of the twenty-fifth via V25 on the base substrate is within a range of an orthographic projection of the first constant voltage connection block 91-1 of the first constant voltage trace 91 on the base substrate, the first planarization layer within the twenty-fifth via V25 is removed to expose a surface of the first constant voltage connection block 91-1, and the twenty-fifth via V25 is configured such that a second constant voltage trace formed subsequently is connected with the first constant voltage connection block 91-1 through this via. In an exemplary implementation mode, the twenty-fifth via V25 may serve as a third connection hole of the present disclosure.

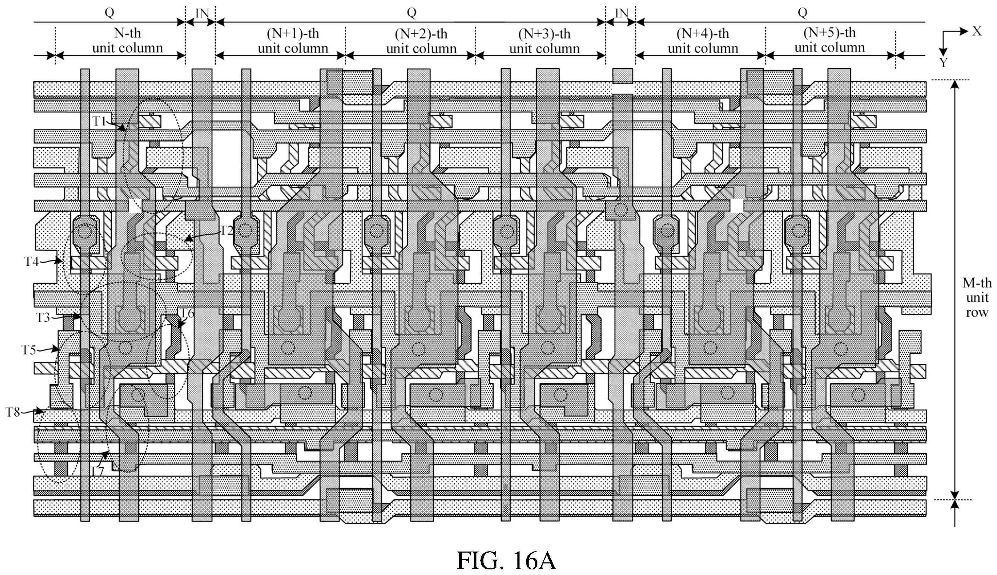

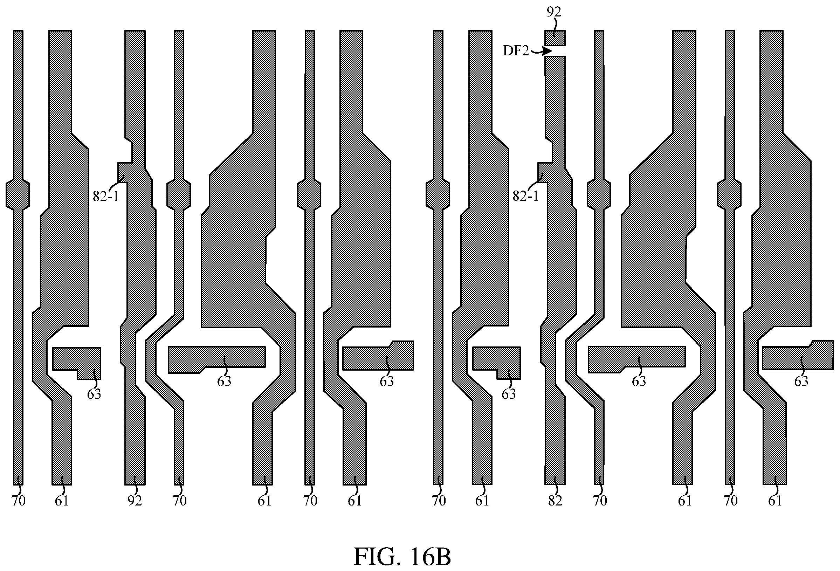

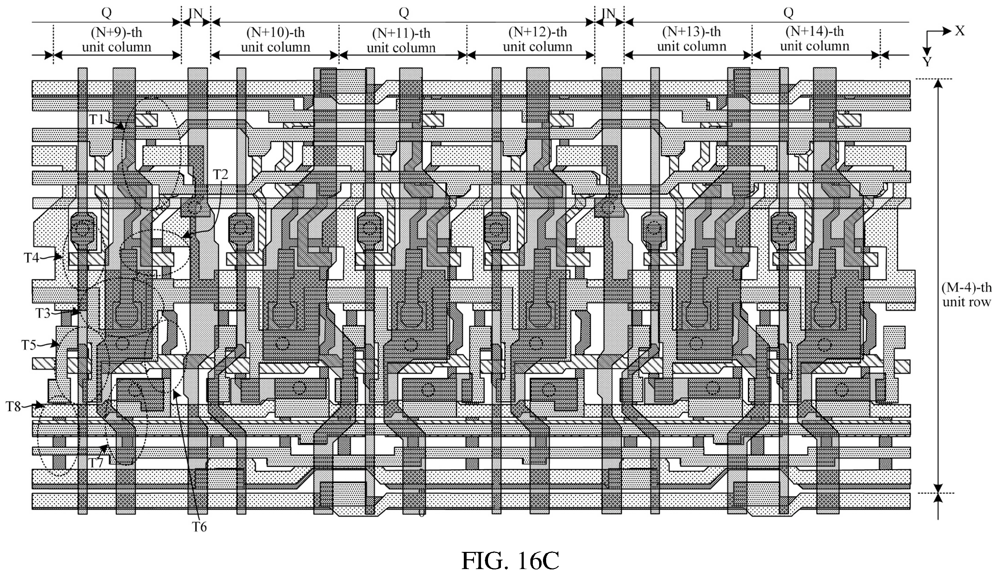

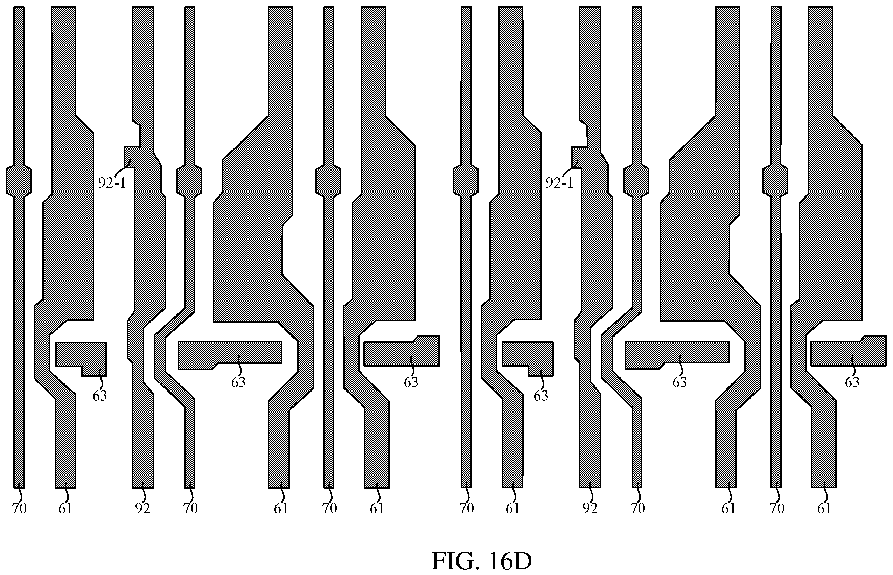

(17) Forming a pattern of a fourth conductive layer. In an exemplary implementation mode, forming the pattern of the fourth conductive layer may include: depositing a fourth conductive thin film on the base substrate on which the aforementioned patterns are formed, and patterning the fourth conductive thin film through a patterning process to form the fourth conductive layer disposed on the first planarization layer, as shown in FIGs. 16A, 16B, 16C, and 16D, wherein FIG. 16A is a schematic diagram of a structure of a region A in FIG. 8, FIG. 16B is a schematic plan diagram of the fourth conductive layer in FIG. 16A, FIG. 16C is a schematic diagram of a structure of a region B in FIG. 8, and FIG. 16D is a schematic plan diagram of the fourth conductive layer in FIG. 16C. In an exemplary implementation mode, the fourth conductive layer may be referred to as a second source-drain metal (SD2) layer.

In an exemplary implementation mode, the pattern of the fourth conductive layer of each circuit unit in the display region at least includes a first power supply line 61, an anode connection electrode 63, and a data signal line 70.

In an exemplary implementation mode, the first power supply line 61 may be in a shape of a straight line or a polyline in which a main body portion extends along the second direction Y, and the first power supply line 61 is connected with the power supply connection line 62 through the twenty-first via V21, thus achieving an interconnection between the power supply connection line 62 extending along the first direction X and the first power supply line 61 extending along the second direction Y, and the power supply connection line 62 and the first power supply line 61 form a mesh-like communication structure for transmitting a first power supply signal, which may effectively reduce a resistance of the first power supply line, effectively reduce a voltage drop of the first power supply signal, effectively improve uniformity of the first power supply signal, effectively improve display uniformity, and improve display attribute and display quality.

In an exemplary implementation mode, an orthographic projection of the first power supply line 61 on the base substrate is at least partially overlapped with an orthographic projection of the first connection electrode 51 on the base substrate. Since the first connection electrode 51 serves as the first node N1 in the pixel drive circuit, the first power supply line 61 with a constant voltage may effectively shield an influence of another signal in the pixel drive circuit on the first node N1, thereby avoiding an influence of another signal (such as data voltage jump) on a potential of the first node N1 in the pixel drive circuit, reducing crosstalk, and improving a display effect.

In an exemplary implementation mode, an orthographic projection of the first power supply line 61 on the base substrate may contain an orthographic projection of the first connection electrode 51 on the base substrate.

In an exemplary implementation mode, the first power supply line 61 may be of an unequal width design, and the first power supply line 61 with the unequal width design may not only facilitate a layout of a pixel structure, but also reduce a parasitic capacitance between the first power supply line and the data signal line.

In an exemplary implementation mode, an orthographic projection of the first power supply line 61 on the base substrate may contain an orthographic projection of the first fracture K1 of the first connection line 81 on the base substrate, so that the first power supply line 61 may shelter the first fracture DF1 from above, which may effectively eliminate a film layer difference in different regions, facilitate shadow elimination, and avoid poor appearance of the display substrate.

In an exemplary implementation mode, the anode connection electrode 63 may be in a shape of a strip extending along the first direction X, the anode connection electrode 63 is connected with the fourth connection electrode 54 through the twenty-second via V22, and is configured to be connected with an anode formed subsequently. Since the fourth connection electrode 54 is connected with the second region of the sixth active layer (which is also the second region of the seventh active layer) through a via, it is achieved that the pixel drive circuit drives a light emitting device to emit light.

In an exemplary implementation mode, the data signal line 70 may be in a shape of a straight line or a polyline in which a main body portion extends along the second direction Y, and the data signal line 70 is connected with the third connection electrode 53 through the twenty-third via V23. Since the third connection electrode 53 is connected with the first region of the fourth active layer through a via, it is achieved that a data signal is written into the first electrode of the fourth transistor T4 by the data signal line 70.

In an exemplary implementation mode, since the third connection electrode 53 in the circuit unit of the M-th unit row and the (N+1)-th unit column is connected with the first connection line 81 through the data connection block 84, it is achieved that a first connection line 81 in the M-th unit row is connected with a data signal line 70 in the (N+1)-th unit column.

As shown in FIGs. 16A and 16B, the fourth conductive layer of the first region may further include a second connection line 82 and a second constant voltage trace 92. The second connection line 82 and the second constant voltage trace 92 each may be in a shape of a straight line or a polyline in which a main body portion extends along the second direction Y, and may be disposed in an insertion column respectively.

In an exemplary implementation mode, a second connection block 82-1 may be disposed on the second connection line 82. The second connection block 82-1 may be in a shape of a block (such as a rectangle), may be disposed at a side of the second connection line 82 in an opposite direction of the first direction X, and may be connected with the second connection line 82, and the second connection block 82-1 is connected with the first connection block 81-1 through the twenty-fourth via V24. Since the first connection block 81-1 is connected with the first connection line 81 and the second connection block 82-1 is connected with the second connection line 82, it is achieved that a first connection line 81 in the M-th unit row is connected with a second connection line 82 located in an insertion column between the (N+3)-th unit column and the (N+4)-th unit column. Since the first connection line 81 in the M-th unit row is connected with the data signal line 70 in the (N+1)-th unit column, it is achieved that the second connection line 82 in the insertion column, the first connection line 81 in the M-th unit row, and the data signal line 70 in the (N+1)-th unit column are connected sequentially, and a data signal of the bonding region may be transmitted to the data signal line 70 through the first connection line 81 and the second connection line 82.

In an exemplary implementation mode, at least one insertion column may be provided with at least one second connection line 82 and at least one second constant voltage trace 92, and a second fracture DF2 may be disposed between the second connection line 82 and the second constant voltage trace 92, so that the second connection line 82 and the second constant voltage trace 92 located at two sides of the second fracture DF2 are insulated from each other.

In an exemplary implementation mode, an orthographic projection of the second fracture DF2 on the base substrate may be within a range of an orthographic projection of the first initial signal line 41 on the base substrate, so that the first initial signal line 41 may raise the second fracture DF2 from below, which may effectively eliminate a film layer difference in different regions, facilitate shadow elimination, and avoid poor appearance of the display substrate.

In some possible implementation modes, an orthographic projection of the second fracture DF2 on the base substrate may be within a range of an orthographic projection of the second initial signal line 42 on the base substrate, or may be within a range of an orthographic projection of the third initial signal line 43 on the base substrate, or may be within a range of an orthographic projection of the power supply connection line 62 on the base substrate.

In other possible implementation modes, an orthographic projection of the second fracture DF2 on the base substrate may be within a range of an orthographic projection of the first connection line 81 on the base substrate, and the present disclosure is not limited thereto.

In an exemplary implementation mode, in at least one repeating unit, an orthographic projection of the second connection block 82-1 on the base substrate is at least partially overlapped with an orthographic projection of the dummy connection block 83 on the base substrate.

In an exemplary implementation mode, a width of the second constant voltage trace 92 may be equal to a width of the second connection line 82. In another exemplary implementation mode, widths of the second connection line 82 and the second constant voltage trace 92 may be different. Herein, the widths of the second connection line 82 and the second constant voltage trace 92 are dimensions in the first direction X.

As shown in FIGs. 16C and 16D, the fourth conductive layer of the second region may further include a second constant voltage trace 92, and the second constant voltage trace 92 may be in a shape of a straight line or a polyline in which a main body portion extends along the second direction Y, and may be disposed in a corresponding insertion column.

In an exemplary implementation mode, at least one second constant voltage connection block 92-1 may be disposed on the second constant voltage trace 92. The second constant voltage connection block 92-1 may be in a shape of a block (such as a rectangle), may be disposed at a side of the second constant voltage trace 92 in an opposite direction of the first direction X, and may be connected with the second constant voltage trace 92, and the second constant voltage connection block 92-1 is connected with the first constant voltage connection block 91-1 through the twenty-fifth via V25. Since the first constant voltage connection block 91-1 is connected with the first constant voltage trace 91, and the second constant voltage connecting block 92-1 is connected with the second constant voltage trace 92, it is achieved that the first constant voltage trace 91 extending along the first direction X and the second constant voltage trace 92 extending along the second direction Y are connected with each other, and the first constant voltage trace 91 and the second constant voltage trace 92 form a mesh-like communication structure for transmitting a constant voltage signal, which may effectively reduce a resistance of a constant voltage signal line, effectively reduce a voltage drop of a constant voltage signal, effectively improve uniformity of the constant voltage signal, effectively improve display uniformity, and improve display attribute and display quality.

In an exemplary implementation mode, at least one insertion column may be provided with only a second constant voltage trace 92, and no second connection line is disposed in this insertion column.

In an exemplary implementation mode, in at least one repeating unit, an orthographic projection of the second constant voltage connection block 92-1 on the base substrate is at least partially overlapped with an orthographic projection of the dummy connection block 83 on the base substrate.

In an exemplary implementation mode, at least one first power supply line 61 may be disposed between the data signal line 70 and the second connection line 82, or at least one first power supply line 61 may be disposed between the data signal line 70 and the second constant voltage trace 92.

In an exemplary implementation mode, an orthographic projection of at least one second connection line 82 on the base substrate is at least partially overlapped with an orthographic projection of the shield electrode 28 on the base substrate, or an orthographic projection of at least one second constant voltage trace 92 on the base substrate is at least partially overlapped with the orthographic projection of the shield electrode 28 on the base substrate.

In an exemplary implementation mode, the bonding region may be provided with a bonding constant voltage lead line, and the bonding constant voltage lead line may transmit a first power supply signal or a second power supply signal. At least one second constant voltage trace 92 may extend to the bonding region and then be connected with the bonding constant voltage lead line, so that the second constant voltage trace 92 is a trace for transmitting a first power supply signal or a second power supply signal.

In an exemplary implementation mode, both the first constant voltage trace 91 and the second constant voltage trace 92 are traces for transmitting a first power supply signal, and form a mesh-like communication structure for transmitting the first power supply signal.

In an exemplary implementation mode, both the first constant voltage trace 91 and the second constant voltage trace 92 are traces for transmitting a second power supply signal, and form a mesh-like communication structure for transmitting the second power supply signal.

In some possible implementation modes, the second constant voltage trace 92 may be directly connected with the first power supply line 61 through a connection strip, and the present disclosure is not limited thereto.

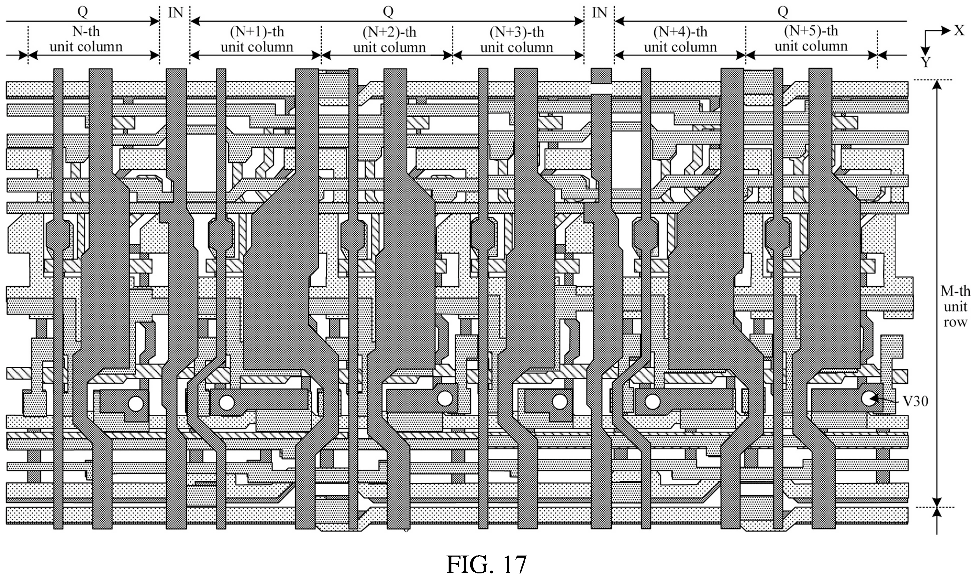

(18) Forming a pattern of a second planarization layer. In an exemplary implementation mode, forming the pattern of the second planarization layer may include: coating a second planarization thin film on the base substrate on which the above-mentioned patterns are formed, and patterning the second planarization thin film through a patterning process to form the second planarization layer covering the fourth conductive layer, the second planarization layer being provided with a plurality of vias, as shown in FIG. 17. FIG. 17 is a schematic diagram of a structure of a region A in FIG. 8, and a via structure of a region B in FIG. 8 is substantially the same as that of the region A in FIG. 8.

In an exemplary implementation mode, the plurality of vias of each circuit unit in the display region may include an anode via V30.

In an exemplary implementation mode, an orthographic projection of the anode via V30 on the base substrate is within a range of an orthographic projection of the anode connection electrode 63 on the base substrate, the second planarization layer within the anode via V30 is removed to expose a surface of the anode connection electrode 63, and the anode via V30 is configured such that an anode formed subsequently is connected with the anode connection electrode 63 through this via.

So far, the drive structure layer has been prepared on the base substrate. In a plane parallel to the display substrate, the drive structure layer may include a plurality of circuit units, and each circuit unit may include a pixel drive circuit, and a first scan signal line, a second scan signal line, a third scan signal line, a fourth scan signal line, a light emitting control line, a first initial signal line, a second initial signal line, a third initial signal line, a first power supply line, and a data signal line which are connected with the pixel drive circuit. In a plane perpendicular to the display substrate, the drive structure layer may at least include a first insulation layer, a semiconductor layer, a second insulation layer, a first conductive layer, a third insulation layer, a second conductive layer, a fourth insulation layer, a third conductive layer, a first planarization layer, a fourth conductive layer, and a second planarization layer which are stacked sequentially on the base substrate.

In an exemplary implementation mode, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer, the second conductive layer, the third conductive layer, and the fourth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first planarization layer and the second planarization layer may be made of an organic material, such as resin. The active layer may be made of a material such as amorphous Indium Gallium Zinc Oxide (a-IGZO), Zinc Oxynitride (ZnON), Indium Zinc Tin Oxide (IZTO), amorphous Silicon (a-Si), poly-crystalline Silicon (p-Si), hexathiophene, or polythiophene. That is, the present disclosure is applicable to a transistor that is manufactured based on an oxide technology, a silicon technology, or an organic matter technology.

In an exemplary implementation mode, after preparation of the drive structure layer is completed, a light emitting structure layer is prepared on the drive structure layer, and a preparation process of the light emitting structure layer may include following operations.

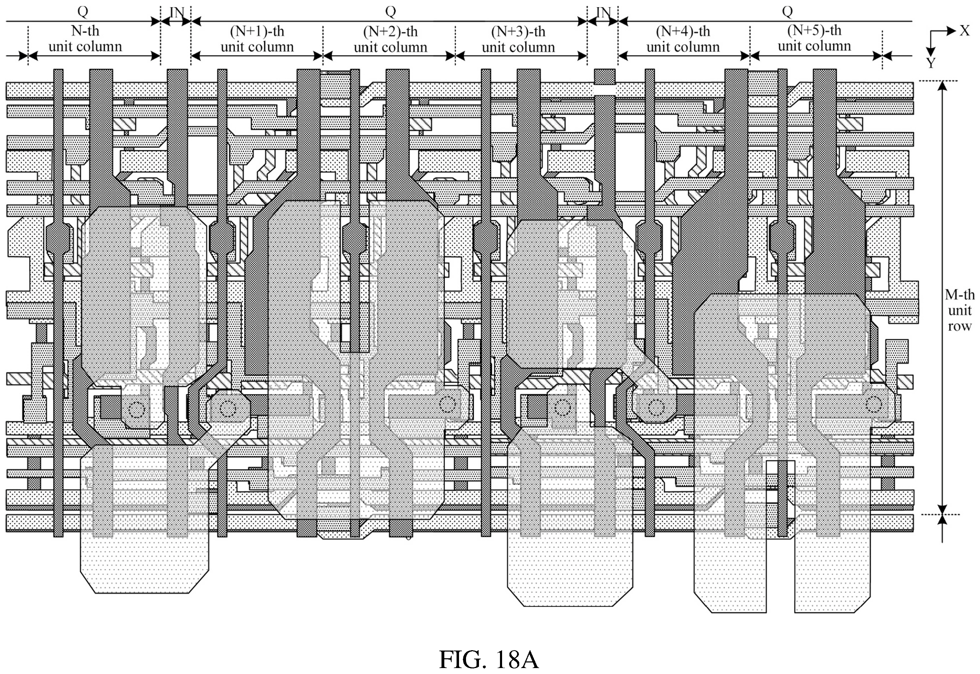

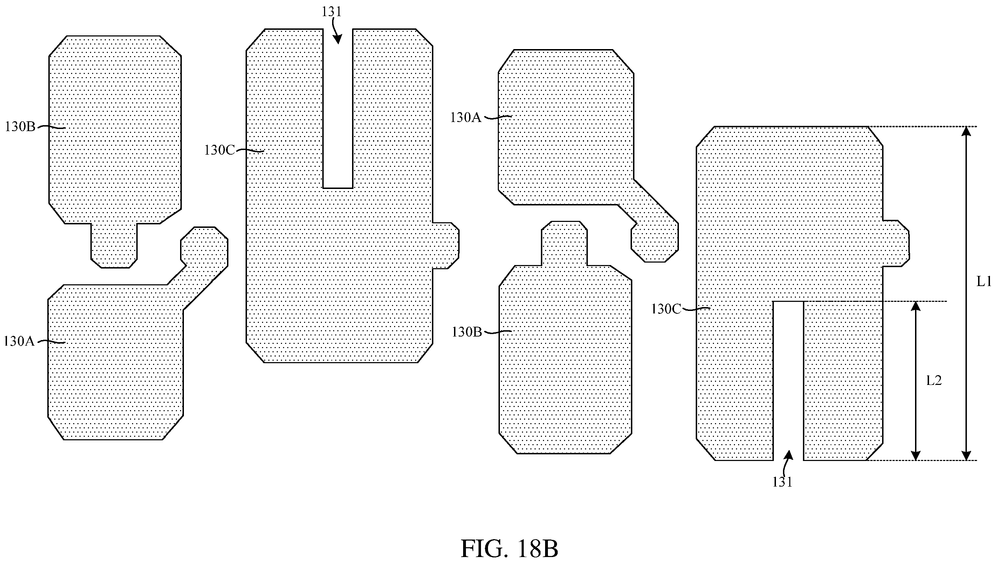

(19) Forming a pattern of an anode conductive layer. In an exemplary implementation mode, forming the pattern of the anode conductive layer may include: depositing an anode conductive thin film on the base substrate on which the aforementioned patterns are formed, and patterning the anode conductive thin film through a patterning process to form the anode conductive layer disposed on the second planarization layer, as shown in FIG. 18A and FIG. 18B, wherein FIG. 18B is a schematic plan diagram of the anode conductive layer in FIG. 18A. FIG. 18A is a schematic diagram of a structure of a region A in FIG. 8, and the pattern of the anode conductive layer of a region B in FIG. 8 is substantially the same as that of the region A in FIG. 8.

In an exemplary implementation mode, the anode conductive layer may at least include patterns of a plurality of anodes. The patterns of the plurality of anodes may include a first anode 130A of a red light emitting unit, a second anode 130B of a green light emitting unit, and a third anode 130C of a blue light emitting unit. The first anode 130A and the second anode 130B may be alternately disposed along the second direction Y, the third anode 130C may be disposed at a side of the second anode 130B in the first direction X, and the first anode 130A, the second anode 130B, and the third anode 130C each may be connected with an anode connection electrode 63 of a corresponding circuit unit through an anode via V30.

In an exemplary implementation mode, at least one of the first anode 130A, the second anode 130B, and the third anode 130C may include an anode main body portion and an anode connection portion connected with each other, the anode main body portion may be in a shape of a rectangle, a chamfer may be disposed at a corner of the rectangle, the anode connection portion may be in a shape of a block (such as a rectangle), and may be connected with the anode connection electrode 63 through the anode via V30.

In an exemplary implementation mode, orthographic projections of anode main body portions of at least one first anode 130A and at least one second anode 130B on the base substrate are at least partially overlapped with orthographic projections of the first power supply line 61 and the second connection line 82 on the base substrate, or are at least partially overlapped with orthographic projections of the first power supply line 61 and the second constant voltage trace 92 on the base substrate.

In an exemplary implementation mode, an orthographic projection of an anode main body portion of at least one third anode 130C on the base substrate is at least partially overlapped with orthographic projections of one data signal line 70 and two first power supply lines 61 on the base substrate, and the data signal line 70 is disposed between the two first power supply lines 61 in the first direction X.

In an exemplary implementation mode, an anode groove 131 may be disposed on an anode main body portion of at least one third anode 130C. The anode groove 131 may be in a shape of a strip extending along the second direction Y, and may be disposed in a middle region of the anode main body portion of the third anode 130C in the first direction X. An orthographic projection of the anode groove 131 on the base substrate is at least partially overlapped with an orthographic projection of the data signal line 70 on the base substrate, that is, the anode main body portion of the third anode 130C has a bifurcation structure, and a bifurcation position avoids the data signal line 70, which may effectively reduce an influence of data voltage jump on the data signal line on a potential of the anode, and improve a display effect.

In an exemplary implementation mode, the anode main body portion of the third anode 130C may have a first length L1, the anode groove 131 may have a second length L2, and a ratio of the second length L2 to the first length L1 may be 0.3 to 0.7. Herein, the first length L1 is an average dimension of the anode main body portion of the third anode 130C in the second direction Y, and the second length L2 is an average dimension of the anode groove 131 in the second direction Y.

In an exemplary implementation mode, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation mode, a subsequent preparation process may include: forming a pattern of a pixel definition layer first, then forming an organic emitting layer by using an evaporation process and inkjet printing process, then forming a cathode on the organic emitting layer, and then forming an encapsulation structure layer, herein the encapsulation structure layer may include a first encapsulation layer, a second encapsulation layer, and a third encapsulation layer which are stacked, the first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

In the display substrate according the embodiment of the present disclosure, by disposing a data connection line in a display region, a data leading-out line of the bonding region is connected with a data signal line through the data connection line, and a FIP structure is achieved, so that no fan-shaped oblique line needs to be disposed in a leading-out line region, which effectively reduces a length of the leading-out line region, greatly reduces a width of a lower bezel, increases a screen-to-body ratio, and is beneficial to achieve full-screen display. In the present disclosure, through a multi-inserting-one (such as three-inserting-one) design of FIP traces, a second connection line is disposed in an insertion column between repeating units, which may reduce a density of longitudinal traces while reducing a width of a lower bezel, so that defects may be reduced, and a yield may be improved.

In the present disclosure, a first constant voltage trace and a second constant voltage trace for transmitting a first power supply signal or a second power supply signal are disposed in the display region and a mesh-like communication structure for transmitting the first power supply signal or the second power supply signal is formed, which not only may effectively reduce a resistance of a first power supply signal or a second power supply line, effectively reduce a voltage drop of the first power supply signal or the second power supply signal, and achieve low power consumption, but also may effectively improve uniformity of the first power supply signal or the second power supply signal in the display substrate, effectively improve display uniformity, and improve display attribute and display quality.

In the present disclosure, a structure of VSS in pixel is achieved by forming a mesh-like communication structure for transmitting a second power supply signal in the display region, which may greatly reduce a width of a bezel constant voltage lead line, greatly reduce widths of left and right bezels, increase a screen-to-body ratio, and be beneficial to achieve full-screen display.

In the present disclosure, a data connection line is disposed in a first region, and a constant voltage trace is disposed in a second region, so that the first region and the second region have substantially a same trace structure, and different regions may achieve substantially a same display effect under transmitted light and reflected light, thus effectively avoiding poor appearance of the display substrate and improving display attribute and display quality.

In the present disclosure, a first initial signal line and a third initial signal line having a double-layer structure are disposed, which may effectively reduce resistances of the first initial signal line and the third initial signal line, reduce voltage drops of a first initial signal and a third initial signal, effectively improve uniformity of the first initial signal and the third initial signal, effectively improve display uniformity, and improve display attribute and display quality.

In the present disclosure, a plurality of scan signal lines are disposed in a third conductive layer, and a third scan signal line has a double-layer structure, which may effectively reduce a resistance of a scan signal line, reduce a voltage drop of a scan signal, and improve performance of a pixel drive circuit.

In the present disclosure, a repair line is disposed in a display region, when a defect occurs in a pixel drive circuit, the repair line may be connected to a light emitting device separated from the pixel drive circuit to quickly repair the light emitting device that cannot be lit, which may effectively improve a yield.

In the present disclosure, a third anode is disposed to have a bifurcation structure, and a bifurcation position avoids a data signal line, which may effectively reduce an influence of data voltage jump on the data signal line on a potential of an anode, and improve a display effect.

The preparation process of the present disclosure may be compatible well with an existing preparation process, is simple in process implementation, is easy to implement, and has a high production efficiency, a low production cost, and a high yield.

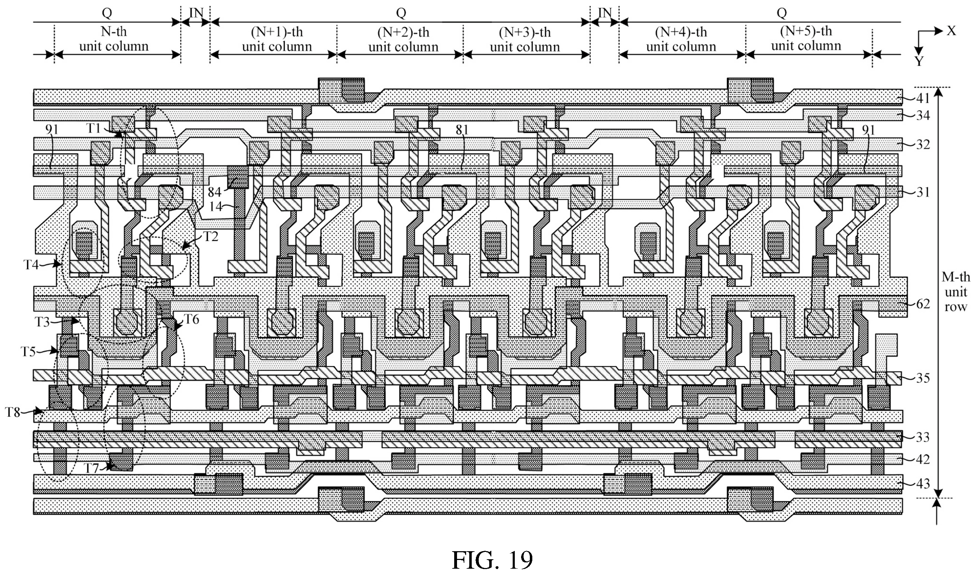

FIG. 19 is a schematic diagram of a structure of another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that the first connection line 81 may be disposed between the first scan signal line 31 and the second scan signal line 32.

In an exemplary implementation mode, in at least one repeating unit row of the first region, shapes of fourth active layers 14 of a plurality of circuit units have differentiated designs, wherein a first region of a fourth active layer of at least one circuit unit is disposed between the first scan signal line 31 and the second scan signal line 32, and a first region of a fourth active layer of another circuit unit is disposed between the first scan signal line 31 and the second electrode plate, and is located on a same straight line extending along the first direction X.

In an exemplary implementation mode, in at least one repeating unit row of the first region, the first connection line 81 may be disposed between the first scan signal line 31 and the second scan signal line 32. In one circuit unit, a data connection block 84 may be further disposed, the data connection block 84 may be in a shape of a block (such as a rectangle), may be disposed at a side of the first connection line 81 close to the first scan signal line 31, and may be connected with the first connection line 81, and the data connection block 84 may be connected with a first region of a fourth active layer in this circuit unit through a via. However, in other circuit units, a structure in which a third connection electrode is connected with a first region of a fourth active layer through a via is still adopted.

In an exemplary implementation mode, in at least one repeating unit row, the data connection block 84 may be disposed at a side of the first scan signal line 31 away from the second electrode plate, and the first connection line 81 and the data connection block 84 may be of an interconnected integral structure.

In an exemplary implementation mode, the data connection block 84 may be disposed in the circuit unit of the M-th unit row and the (N+1)-th unit column, and a data signal line in the (N+1)-th unit column may be connected with the data connection block 84 through a via, therefore it is achieved that a first connection line 81 in the M-th unit row is connected with a data signal line 70 in the (N+1)-th unit column.

In some possible embodiments, first regions of fourth active layers of a plurality of circuit units in one repeating unit row each may be disposed between the first scan signal line 31 and the second scan signal line 32, and the present disclosure is not limited thereto.

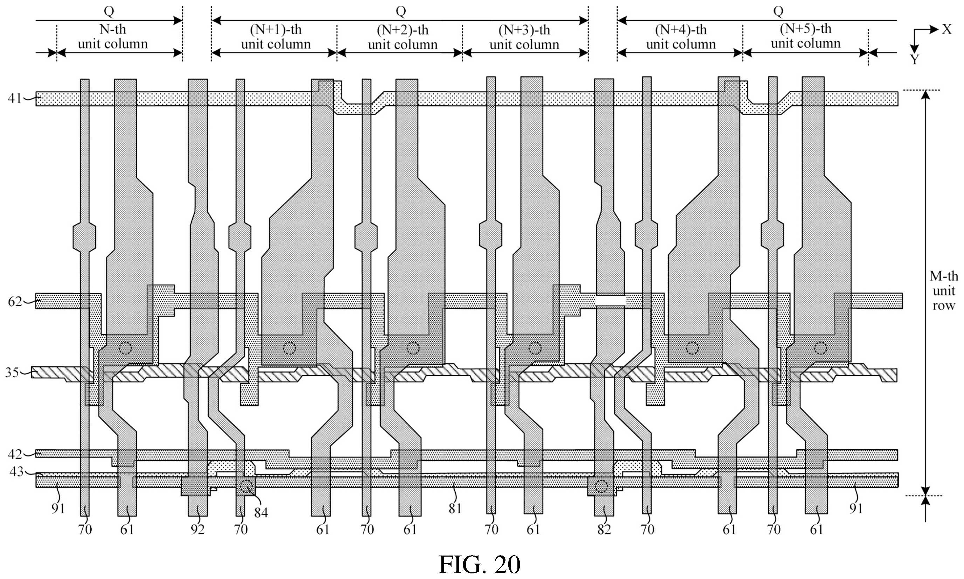

FIG. 20 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that the first connection line 81 and the first power supply trace 91 may be disposed at a side of the light emitting signal line 25 away from the power supply connection line 62, that is, the light emitting signal line 25 may be located between the power supply connection line 62 and the first connection line 81.

In an exemplary implementation mode, in at least one repeating unit row of the first region, the first connection line 81 and the first power supply trace 91 may be disposed at a side of the second initial signal line 42 away from the power supply connection line 62, and in at least one repeating unit row of the second region, the first power supply trace 91 may be disposed at a side of the second initial signal line 42 away from the power supply connection line 62.

In an exemplary implementation mode, an orthographic projection of the first connection line 81 or the first power supply trace 91 on the base substrate is at least partially overlapped with an orthographic projection of the third initial signal line 43 on the base substrate, so that the third initial signal line 43 with a constant voltage may effectively shield an influence of data voltage jump in the first connection line 81 on a pixel drive circuit, and decrease crosstalk.

In an exemplary implementation mode, at least one repeating unit row of the first region may be further provided with a data connection block 84, the data connection block 84 may be in a shape of a block (such as a rectangle), may be disposed at a side of the first connection line 81 away from the second initial signal line 42, and may be connected with the first connection line 81. The data signal line 70 may be connected with the data connection block 84 through a via, thus realizing a connection between the first connection line 81 in the M-th unit row and the data signal line 70 in the (N+1)-th unit column.

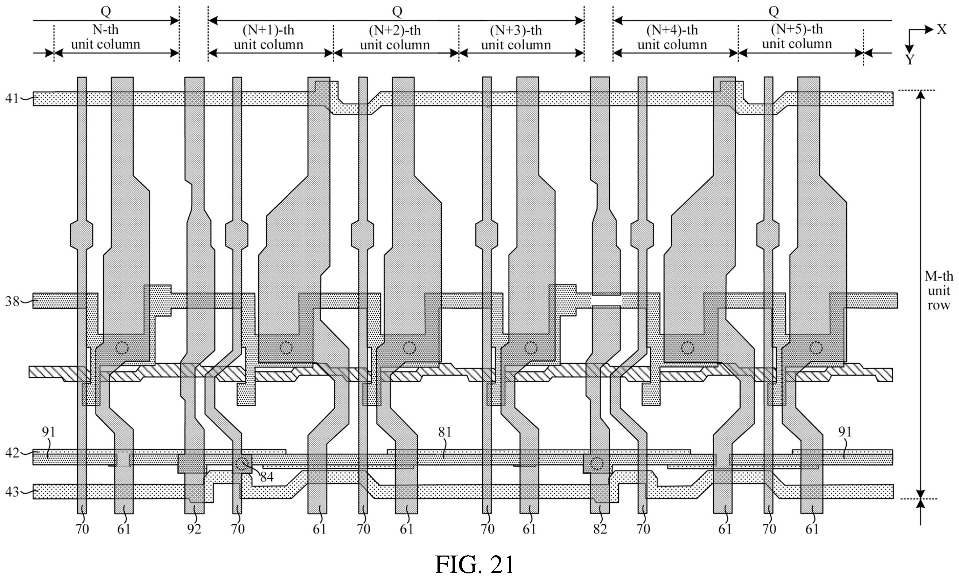

FIG. 21 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that the first connection line 81 and the first power supply trace 91 may be disposed at a side of the light emitting signal line 25 away from the power supply connection line 62, and the second initial signal line 42 may be disposed in the second conductive layer.

In an exemplary implementation mode, in at least one repeating unit row of the first region, the first connection line 81 and the first power supply trace 91 may be disposed between the light emitting signal line 25 and the third initial signal line 43, and in at least one repeating unit row of the second region, the first power supply trace 91 may be disposed between the light emitting signal line 25 and the third initial signal line 43.

In an exemplary implementation mode, an orthographic projection of the first connection line 81 or the first power supply trace 91 on the base substrate is at least partially overlapped with an orthographic projection of the second initial signal line 42 on the base substrate, so that not only the second initial signal line 42 having a constant voltage may effectively shield an influence of data voltage jump in the first connection line 81 on the pixel drive circuit and reduce crosstalk, but also wiring space may be saved as much as possible, which is beneficial to achieve a higher resolution (Pixel Per Inch (PPI)).

In an exemplary implementation mode, at least one repeating unit row of the first region may be further provided with a data connection block 84, the data connection block 84 may be in a shape of a block (such as a rectangle), may be disposed at a side of the first connection line 81 close to the third initial signal line 43, and may be connected with the first connection line 81. The data signal line 70 may be connected with the data connection block 84 through a via, thus realizing a connection between the first connection line 81 in the M-th unit row and the data signal line 70 in the (N+1)-th unit column.

In an exemplary implementation mode, a preparing process of the display substrate of the present embodiment is substantially the same as that of the embodiment shown in FIG. 9A to FIG. 9D, except that the formed second conductive layer further includes a second initial signal line, and the second initial signal line 42 may be disposed between the third scan signal line 33 and the third initial signal line 43.

In an exemplary implementation mode, positions of the third scan signal line 33 and the scan connection line 36 of the present embodiment may be appropriately moved up according to a situation of layout space. For example, space for disposing the second initial signal line 42 may be left by canceling a repair line or the like.

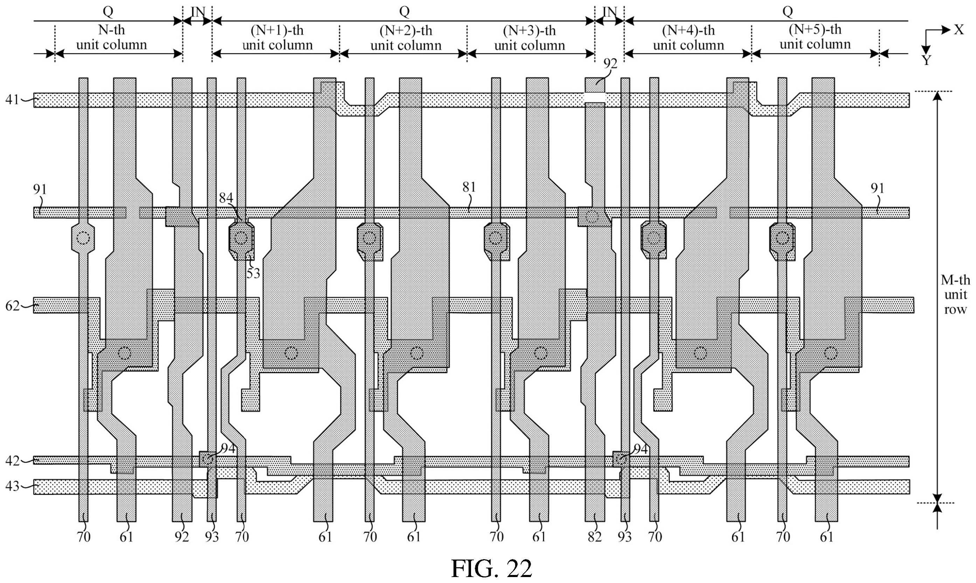

FIG. 22 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that an insertion column is further provided with a constant voltage connection line 93.

In an exemplary implementation mode, at least one insertion column may be provided with two vertical lines, and the two vertical lines may be a second connection line 82 and a constant voltage connection line 93, or may be a second power supply trace 92 and a constant voltage connection line 93.

In an exemplary implementation mode, the constant voltage connection line 93 may be in a shape of a straight line or a polyline in which a main body portion extends along the second direction Y, and the constant voltage connection line 93 may be disposed between the second connection line 82 and an adjacent data signal line 70, or may be disposed between the second power supply trace 92 and an adjacent data signal line 70. In the present disclosure, crosstalk between data signals may be effectively avoided by disposing the constant voltage connection line 93 between the second connection line 82 and the data signal line 70.

In an exemplary implementation mode, the second connection line 82, the second power supply trace 92, and the constant voltage connection line 93 may be disposed in a same conductive layer and formed synchronously through a same patterning process.

In an exemplary implementation mode, at least one fourth connection block 94 may be disposed on the constant voltage connection line 93. The fourth connection block 94 may be in a shape of a block (such as a rectangle), may be disposed at a side of the constant voltage connection line 93 in the first direction X or in an opposite direction of the first direction X, and may be connected with the constant voltage connection line 93. The fourth connection block 94 may be connected with the second initial signal line 42 through a via, therefore it is achieved that the second initial signal line 42 extending along the first direction X and the constant voltage connection line 93 extending along the second direction Y are connected with each other, and the second initial signal line 42 and the constant voltage connection line 93 form a mesh-like communication structure for transmitting a second initial signal, which may effectively reduce a resistance of the second initial signal line, effectively reduce a voltage drop of the second initial signal, effectively improve uniformity of the second initial signal, effectively improve display uniformity, and improve display attribute and display quality.

In some possible implementation modes, the constant voltage connection line 93 may be connected with the first initial signal line 41, therefore it is achieved that the first initial signal line 41 extending along the first direction X and the constant voltage connection line 93 extending along the second direction Y are connected with each other, and the first initial signal line 41 and the constant voltage connection line 93 form a mesh-like communication structure for transmitting a first initial signal, which may effectively reduce a resistance of the first initial signal line, effectively reduce a voltage drop of the first initial signal, effectively improve uniformity of the first initial signal, effectively improve display uniformity, and improve display attribute and display quality.

In other possible implementation modes, a constant voltage connection line 93 in one insertion column may be connected with the third initial signal line 43, therefore it is achieved that the third initial signal line 43 extending along the first direction X and constant voltage connection line 93 extending along the second direction Y are connected with each other, and the third initial signal line 43 and the constant voltage connection line 93 form a mesh-like communication structure for transmitting a third initial signal, which may effectively reduce a resistance of the third initial signal line, effectively reduce a voltage drop of the third initial signal, effectively improve uniformity of the third initial signal, effectively improve display uniformity, and improve display attribute and display quality.

In still other possible implementation modes, a constant voltage connection line 93 in one insertion column may be connected with the first initial signal line 41, a constant voltage connection line 93 in another insertion column may be connected with the second initial signal line 42, and a constant voltage connection line 93 in yet another insertion column may be connected with the third initial signal line 43, thus simultaneously forming a mesh-like communication structure for transmitting a first initial signal, a mesh-like communication structure for transmitting a second initial signal, and a mesh-like communication structure for transmitting a third initial signal on the display substrate. For example, in the first direction X, the constant voltage connection line 93 connected with the first initial signal line 41, the constant voltage connection line 93 connected with the second initial signal line 42, and the constant voltage connection line 93 connected with the third initial signal line 43 may be periodically arranged.

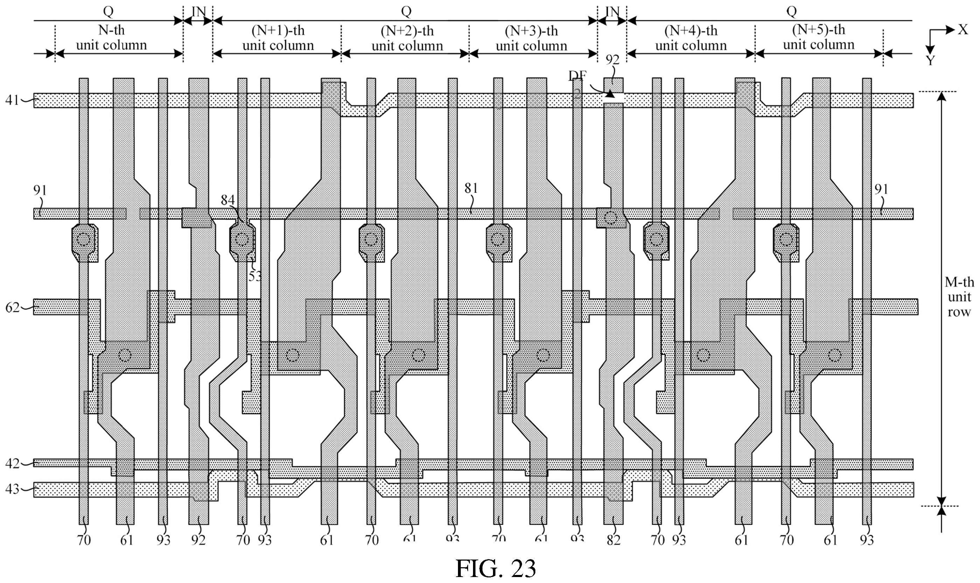

FIG. 23 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that a unit column is further provided with a constant voltage connection line 93.

In an exemplary implementation mode, at least one unit column may be provided with three vertical lines which may be a first power supply line 61, a data signal line 70, and a constant voltage connection line 93.

In an exemplary implementation mode, the second connection line 82, the second power supply trace 92, and the constant voltage connection line 93 may be disposed in a same conductive layer and formed synchronously through a same patterning process.

In an exemplary implementation mode, at least one connection block may be connected with the constant voltage connection line 93, and the connection block is configured to be connected with the first initial signal line 41, the second initial signal line 42, or the third initial signal line 43 through a via to form a mesh-like communication structure for transmitting a first initial signal, a second initial signal, or a third initial signal.

In some possible implementation modes, a constant voltage connection line 93 in one unit column may be connected with the first initial signal line 41, a constant voltage connection line 93 in another unit column may be connected with the second initial signal line 42, and a constant voltage connection line 93 in yet another unit column may be connected with the third initial signal line 43, thus simultaneously forming a mesh-like communication structure for transmitting a first initial signal, a mesh-like communication structure for transmitting a second initial signal, and a mesh-like communication structure for transmitting a third initial signal on the display substrate. For example, in the first direction X, the constant voltage connection line 93 connected with the first initial signal line 41, the constant voltage connection line 93 connected with the second initial signal line 42, and the constant voltage connection line 93 connected with the third initial signal line 43 may be periodically arranged.

In other possible implementation modes, the embodiment shown in FIG. 22 and the embodiment shown in FIG. 23 may be combined into a new scheme, in which an insertion column is provided with two vertical lines (a second connection line 82 and a constant voltage connection line 93) , and a unit column is provided with three vertical lines (a first power supply line 61, a data signal line 70, and a constant voltage connection line 93) , that is, the second connection line 82 has a three-inserting-one structure, and the constant voltage connection line has a one-inserting-one structure, which may further stabilize a constant voltage signal and further reduce power consumption.

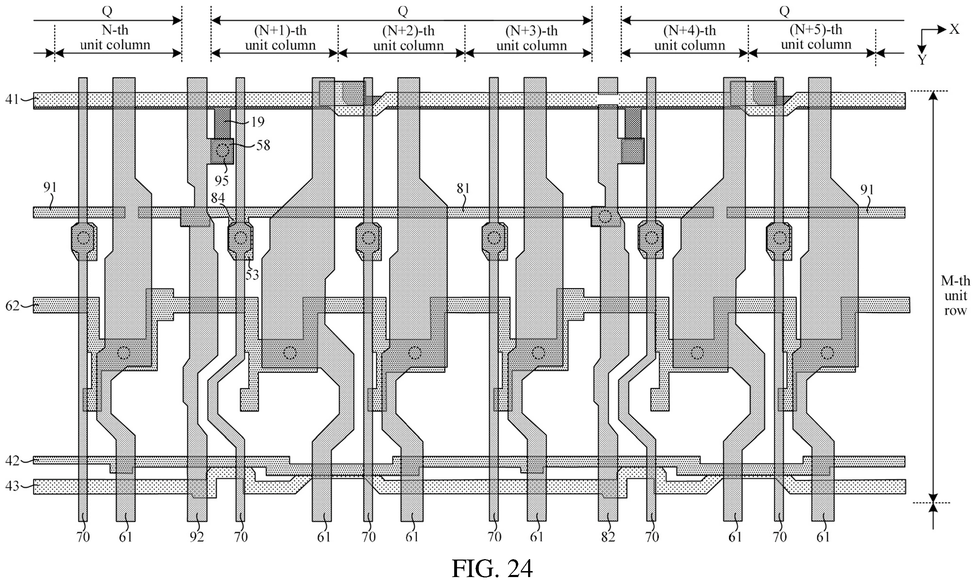

FIG. 24 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that the second constant voltage trace 92 is connected with the first initial signal line 41.

In an exemplary implementation mode, at least one circuit unit may further include an active connection strip 19 and an eighth connection electrode 58. The active connection strip 19 may be in a shape of a strip extending along the second direction Y, and may be disposed at a side of the first active connection line 10 close to the power supply connection line 62. A first end of the active connection strip 19 is connected with the first active connection line 10, and a second end of the active connection strip 19 extends toward a direction close to the power supply connection line 62. The eighth connection electrode 58 may be in a shape of a block (such as a rectangle), may be disposed at a side of the first active connection line 10 close to the power supply connection line 62, and may be connected with the second end of the active connection strip 19 through a via.

In an exemplary implementation mode, in at least one circuit unit, the first active connection line 10 and the active connection strip 19 may be disposed in a same layer, and may be of an interconnected integral structure.

In an exemplary implementation mode, the eighth connection electrode 58 may be disposed in the third conductive layer.

In an exemplary implementation mode, at least one second constant voltage trace 92 may be further provided with at least one fifth connection block 95. The fifth connection block 95 may be in a shape of a block (such as a rectangle), may be disposed at a side of the second constant voltage trace 92 in the first direction X, and may be connected with the second constant voltage trace 92, and the fifth connection block 95 may be connected with the sixth connection electrode 56 through a via. Since the first active connection line 10 is connected with the first initial signal line 41, it is achieved that the first initial signal line 41 extending along the first direction X and the second constant voltage trace 92 extending along the second direction Y are connected with each other, and the first initial signal line 41 and the second constant voltage trace 92 form a mesh-like communication structure for transmitting a first initial signal.

In some possible implementation modes, the first constant voltage trace 91 or the second constant voltage trace 92 may extend to a bezel region to be connected with a lead line for transmitting a first initial signal, and the present disclosure is not limited thereto.

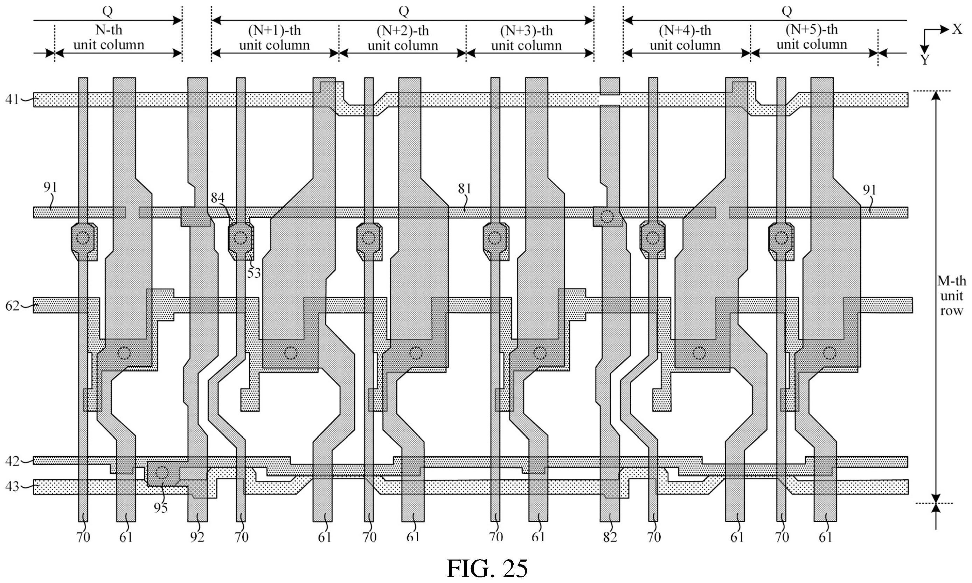

FIG. 25 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that the second constant voltage trace 92 is connected with the second initial signal line 42.

In an exemplary implementation mode, at least one second constant voltage trace 92 may be further provided with at least one fifth connection block 95. The fifth connection block 95 may be in a shape of a block (such as a rectangle), may be disposed at a side of the second constant voltage trace 92 in an opposite direction of the first direction X, and may be connected with the second constant voltage trace 92. The fifth connection block 95 may be connected with the second initial signal line 42 through a via, therefore it is achieved that the second initial signal line 42 extending along the first direction X and the second constant voltage trace 92 extending along the second direction Y are connected with each other, and the second initial signal line 42 and the second constant voltage trace 92 form a mesh-like communication structure for transmitting a second initial signal.

In some possible implementation modes, the first constant voltage trace 91 or the second constant voltage trace 92 may extend to a bezel region to be connected with a lead line for transmitting a second initial signal, and the present disclosure is not limited thereto.

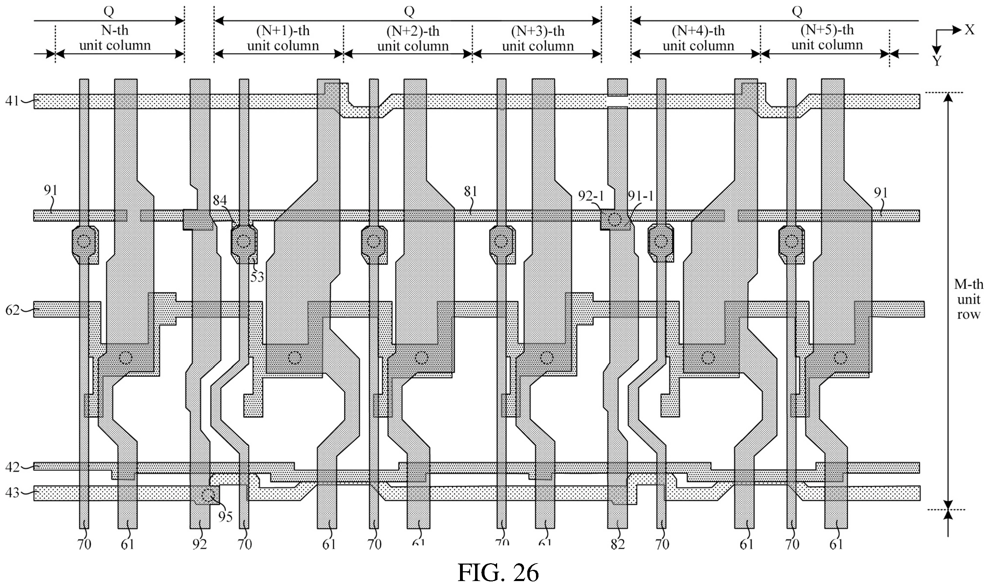

FIG. 26 is a schematic diagram of a structure of yet another display substrate according to an exemplary embodiment of the present disclosure, and is a schematic diagram of a structure of a region A in FIG. 8. In an exemplary implementation mode, a main body structure of the display substrate of the present embodiment is substantially the same as that of the embodiment shown in FIG. 9A to FIG. 9D, except that the second constant voltage trace 92 is connected with the third initial signal line 43.

In an exemplary implementation mode, at least one second constant voltage trace 92 may be further provided with at least one fifth connection block 95. The fifth connection block 95 may be in a shape of a block (such as a rectangle), may be disposed at a side of the second constant voltage trace 92 in an opposite direction of the first direction X, and may be connected with the second constant voltage trace 92. The fifth connection block 95 may be connected with the third initial signal line 43 through a via, therefore it is achieved that the third initial signal line 43 extending along the first direction X and the second constant voltage trace 92 extending along the second direction Y are connected with each other, and the third initial signal line 43 and the second constant voltage trace 92 form a mesh-like communication structure for transmitting a third initial signal.

In some possible implementation modes, the first constant voltage trace 91 or the second constant voltage trace 92 may extend to a bezel region to be connected with a lead line for transmitting a third initial signal, and the present disclosure is not limited thereto.

In some possible implementation modes, in embodiments shown in FIG. 24 to FIG. 26, it may be disposed that the second constant voltage trace 92 is connected with the first constant voltage trace 91 through a via, and an initial signal line (the first initial signal line 41, the second initial signal line 42, or the third initial signal line 43) and the first constant voltage trace 91 that extend along the first direction X and the second constant voltage trace 92 extending along the second direction Y form a mesh-like communication structure for transmitting an initial signal.

In other possible implementation modes, in the embodiments shown in FIG. 24 to FIG. 26, it may be disposed that the first constant voltage trace 91 and the second constant voltage trace 92 are not connected, and the first constant voltage trace 91 and the second constant voltage trace 92 respectively transmit different constant voltage signals. For example, the first constant voltage trace 91 may transmit a first power supply signal or a second power supply signal, and the second constant voltage trace 92 connected with the initial signal line (the first initial signal line 41, the second initial signal line 42, or the third initial signal line 43) may transmit an initial signal.

In still other possible implementation modes, in the embodiments shown in FIG. 24 to FIG. 26, it may be disposed that one part of second constant voltage traces 92 are connected with one part of first constant voltage traces 91 through vias, while the other part of the first constant voltage traces 91 and the other part of the second constant voltage traces 92 are not connected, wherein the two parts of the second constant voltage traces 92 respectively transmit different constant voltage signals.

For example, a second constant voltage trace 92 located in a same insertion column as a second connection line 82 may be connected with a first power supply line or a second power supply line, and may be connected with a first constant voltage trace 91 disposed separately in a repeating unit row through a via, thus forming a mesh-like communication structure for transmitting a first power supply signal or a second power supply signal. A second constant voltage trace 92 disposed separately in an insertion column may be connected with an initial signal line (the first initial signal line 41, the second initial signal line 42, or the third initial signal line 43) to form a mesh-like communication structure for transmitting an initial signal. Such connection mode can realize different constant potential traces to present a network, can make full use of wiring space, and significantly reduce power consumption.

For another example, a first constant voltage trace 91 disposed in a same layer as a first connection line 81 may transmit a first power supply signal or a second power supply signal. One part of second constant voltage traces 92 disposed in a same layer as a second connection line 82 may be connected with the first constant voltage trace 91, the other part of the second constant voltage traces 92 may be connected with the first initial signal line 41 or the third initial signal line 43 located in the second conductive layer, and the two parts of the second constant voltage traces 92 may be alternately disposed in the first direction X. Such connection mode can realize traces in different film layers, has larger available space, can realize more potentials to present a network, and reduce power consumption.

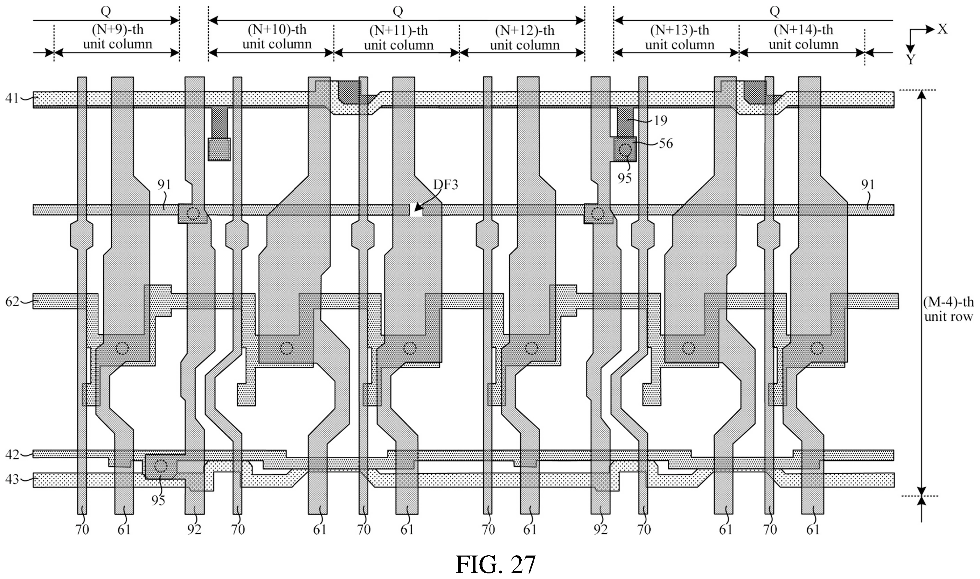

FIG. 27 is a schematic diagram of a structure of yet another display substrate according to an exemplary embodiment of the present disclosure, and is a schematic diagram of a structure of a region B in FIG. 8. In an exemplary implementation mode, a main body structure of the display substrate of the present embodiment is substantially the same as that of the embodiment shown in FIG. 9A to FIG. 9D, except that the second constant voltage trace 92 is connected with the first initial signal line 41 and the second initial signal line 42, respectively.

In an exemplary implementation mode, one second constant voltage trace 92 may be connected with the first initial signal line 41 to form a mesh-like communication structure for transmitting a first initial signal, and another second constant voltage trace 92 may be connected with the second initial signal line 42 to form a mesh-like communication structure for transmitting a second initial signal. Herein, a connection structure of the second constant voltage trace 92 and the first initial signal line 41 may be substantially the same as that in the embodiment shown in FIG. 24, and a connection structure of the second constant voltage trace 92 and the second initial signal line 42 may be substantially the same as that in the embodiment shown in FIG. 25, and will not be repeated here.

In an exemplary implementation mode, at least one first constant voltage trace 91 may be provided with a third fracture DF3, and the first constant voltage trace 91 located at two sides of the third fracture DF3 are insulated from each other, thereby cutting off interconnection between the mesh-like communication structure for transmitting the first initial signal and the mesh-like communication structure for transmitting the second initial signal.

In some possible implementation modes, the display substrate may be divided into a plurality of sub-regions, a plurality of second constant voltage traces 92 in one sub-region may be connected with the first initial signal line 41, a plurality of second constant voltage traces 92 in another sub-region may be connected with the second initial signal line 42, and a plurality of second constant voltage traces 92 in yet another sub-region may be connected with the third initial signal line 43, so that a mesh-like communication structure for transmitting a first initial signal, a mesh-like communication structure for transmitting a second initial signal, and a mesh-like communication structure for transmitting a third initial signal are simultaneously formed on the display substrate. For example, the mesh-like communication structure for transmitting the first initial signal, the mesh-like communication structure for transmitting the second initial signal, and the mesh-like communication structure for transmitting the third initial signal may be periodically arranged in the first direction X or the second direction Y.

In other possible implementation modes, a plurality of second constant voltage traces 92 in the second region may be connected with the first initial signal line 41, the second initial signal line 42, the third initial signal line 43, and the second power supply line, respectively. For example, a second constant voltage trace 92 connected with the first initial signal line 41, a second constant voltage trace 92 connected with the second power supply line, a second constant voltage trace 92 connected with the second initial signal line 42, a second constant voltage trace 92 connected with the second power supply line, a second constant voltage trace 92 connected with the third initial signal line 43, and a second constant voltage trace 92 connected with the second power supply line may be periodically arranged.

In still other possible implementation modes, a plurality of second constant voltage traces 92 in the first region may be connected with a first power supply line or a second power supply line to form a mesh-like communication structure for transmitting a first power supply signal or a second power supply signal, and a plurality of second constant voltage traces 92 in the second region may be connected with the first initial signal line 41, the second initial signal line 42, or the third initial signal line 43 to form a mesh-like communication structure for transmitting a first initial signal, a second initial signal, or a third initial signal.

In still other possible implementation modes, a second constant voltage trace 92 located in a same insertion column as a second connection line 82 may be connected with the first initial signal line 41, the second initial signal line 42, or the third initial signal line 43, and a second constant voltage trace 92 separately disposed in an insertion column may be connected with a first power supply line or a second power supply line, and the present disclosure is not limited thereto.

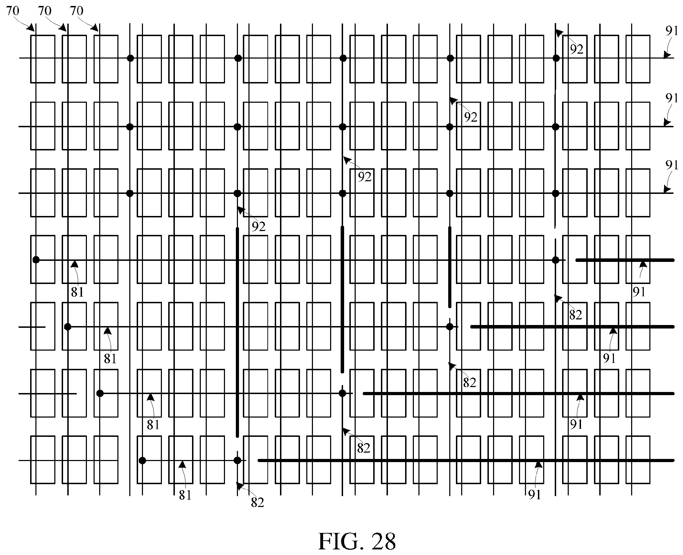

FIG. 28 is a schematic diagram of another structure of a data connection line and a constant voltage trace according to an exemplary embodiment of the present disclosure. As shown in FIG. 28, a main body structure of the data connection line and the constant voltage trace of the present embodiment is substantially the same as that of the embodiment shown in FIG. 8, except that a line width of a constant voltage trace in the first region (FIP region) and a line width of a constant voltage trace in the second region (non-FIP region) are different.

In an exemplary implementation mode, a width of a first constant voltage trace 91 in the first region may be greater than a width of a first constant voltage trace 91 in the second region, or a width of a second constant voltage trace 92 in the first region may be greater than a width of a second constant voltage trace 92 in the second region; or the width of the first constant voltage trace 91 in the first region may be greater than the width of the first constant voltage trace 91 in the second region, and the width of the second constant voltage trace 92 in the first region may be greater than the width of the second constant voltage trace 92 in the second region. The width of the first constant voltage trace 91 may be a dimension in the second direction Y, and the width of the second constant voltage trace 92 may be a dimension in the first direction X.

In an exemplary implementation mode, first constant voltage traces 91 and second constant voltage traces 92 may be disposed in the first region and the second region, respectively. Herein, a first constant voltage trace 91 disposed in the first region is disposed in a same repeating unit row as a first connection line 81, a second constant voltage trace 92 disposed in the first region is disposed in a same insertion column as a second connection line 82, and the second region is provided with only a first constant voltage trace 91 and a second constant voltage trace 92, and a first connection line 81 or a second connection line 82 is not disposed in the second region. Thus, a density of a grid formed by the first constant voltage trace 91 and the second constant voltage trace 92 in the first region is lower than a density of a grid formed by the first constant voltage trace 91 and the second constant voltage trace 92 in the second region. In the present disclosure, a line width of a constant voltage trace in the first region is greater than a line width of a constant voltage trace in the second region, which not only may improve display uniformity of the two regions, but also may reduce a resistance of the constant voltage trace in the first region.

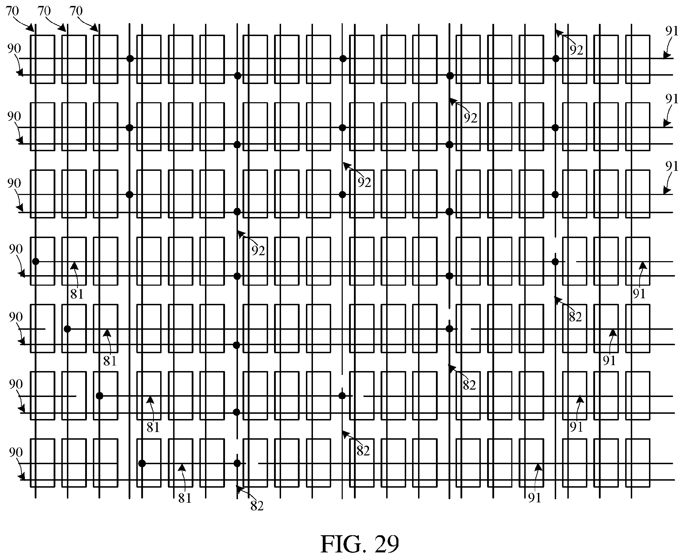

FIG. 29 is a schematic diagram of yet another structure of a data connection line and a constant voltage trace according to an exemplary embodiment of the present disclosure. As shown in FIG. 29, a main body structure of the data connection line and the constant voltage trace of the present embodiment is substantially the same as that of the embodiment shown in FIG. 8, except that second constant voltage traces 92 may transmit different constant voltage signals.

In an exemplary implementation mode, a plurality of second constant voltage traces 92 may be divided into two groups, wherein a second constant voltage trace 92 in a first group may be connected with a first constant voltage trace 91 through a via, and a second constant voltage trace 92 in a second group may be connected with a lateral trace 90 through a via. In the first direction X, the second constant voltage trace 92 in the first group and the second constant voltage trace 92 in the second group may be alternately disposed to form a structure in which second constant voltage traces 92 alternately transmit different constant voltage signals.

In an exemplary implementation mode, the lateral trace 90 may be a first initial signal line 41, a second initial signal line 42, a third initial signal line 43, or a power supply connection line 62, and the present disclosure is not limited thereto.

In an exemplary implementation mode, the lateral trace 90 and the second constant voltage trace 92 may be disposed in a same layer, or the lateral trace 90 and the second constant voltage trace 92 may be disposed in different layers.

In an exemplary implementation mode, as the lateral trace 90 and the second constant voltage trace 92 are disposed in different conductive layers, it may be disposed that an orthographic projection of the lateral trace 90 on the base substrate is at least partially overlapped with an orthographic projection of the second constant voltage trace 92 on the base substrate.

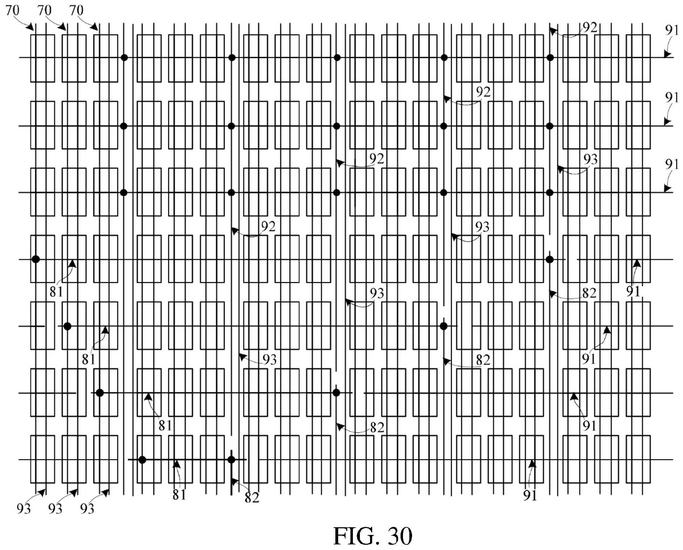

FIG. 30 is a schematic diagram of yet another structure of a data connection line and a constant voltage trace according to an exemplary embodiment of the present disclosure. As shown in FIG. 30, a main body structure of the data connection line and the constant voltage trace of the present embodiment is substantially the same as that of the embodiment shown in FIG. 8, except that an insertion column is provided with a second connection line 82 and a constant voltage connection line 93 respectively, and a unit column is provided with a constant voltage connection line 93.

In an exemplary implementation mode, at least one unit column may be provided with a constant voltage connection line 93, and at least one insertion column may be provided with two vertical lines, the two vertical lines may be a second connection line 82 and a constant voltage connection line 93, or may be a second power supply trace 92 and a constant voltage connection line 93. That is, the second connection line 82 (second power supply trace 92) has a three-inserting-one structure, and the constant voltage connection line has a one-inserting-one structure, which may further stabilize a constant voltage signal and further reduce power consumption.

In an exemplary implementation mode, the constant voltage connection line 93 may be connected with a first initial signal line, a second initial signal line, or a third initial signal line to form a mesh-like communication structure for transmitting an initial signal, and the present disclosure is not limited thereto.

In an exemplary implementation mode, the constant voltage connection line 93 may be disposed between the second connection line 82 and the data signal line 70, which may effectively avoid crosstalk between data signals.

In an exemplary implementation mode, for a case that the constant voltage connection line 93 is not disposed between the second connection line 82 and the data signal line 70, it may be disposed that a pitch between the constant voltage connection line 93 and the data signal line 70 is less than a pitch between the constant voltage connection line 93 and the second connection line 82, wherein the pitch may be a dimension in the first direction X.

The aforementioned structure shown in the present disclosure and the preparation process thereof are merely exemplary description. In an exemplary implementation mode, corresponding structures may be changed and patterning processes may be added or reduced according to actual needs, which is not limited here in the present disclosure.

In an exemplary implementation mode, the display substrate according to the present disclosure may be applied to a display apparatus with a pixel drive circuit, such as an OLED, quantum dot display (QLED), light emitting diode display (Micro LED or Mini LED), or Quantum Dot Light Emitting Diode display (QDLED), which is not limited here in the present disclosure.

The present disclosure further provides a preparation method of a display substrate for preparing the aforementioned display substrates. In an exemplary implementation mode, the preparation method of the display substrate may include: forming a drive structure layer on a base substrate; wherein the drive structure layer includes a plurality of repeating units forming a plurality of repeating unit rows and a plurality of repeating unit columns, and an insertion column is disposed between adjacent repeating unit columns; at least one repeating unit includes a plurality of circuit units disposed sequentially along a first direction, and at least one circuit unit includes a pixel drive circuit and a data signal line extending along a second direction, the data signal line is connected with the pixel drive circuit and is configured to supply a data signal to the pixel drive circuit, the first direction intersecting with the second direction; the drive structure layer further includes at least one first connection line and at least one first constant voltage trace that extend along the first direction, and at least one second connection line and at least one second constant voltage trace that extend along the second direction, a first end of the first connection line is connected with the data signal line, a second end of the first connection line is connected with the second connection line, and at least one second constant voltage trace is connected with at least one first constant voltage trace to form a mesh-like communication structure for transmitting a constant voltage signal; and the second connection line and the second constant voltage trace are disposed in the insertion column.

The present disclosure further provides a display apparatus which includes the aforementioned display substrate. The display apparatus may be any product or component with a display function, such as a mobile phone, a tablet computer, a television, a display, a laptop computer, a digital photo frame, and a navigator, which is not limited in the embodiments of the present invention.

Although implementation modes disclosed in the present disclosure are as above, it should be noted that the above implementation modes are exemplary only rather than restrictive. Therefore, the present disclosure is not limited to what is specifically shown and described here. Various modifications, substitutions, or omissions may be made in forms and details of implementation modes without departing from the scope of the present disclosure.

## Claims

1. A display substrate, comprising a drive structure layer disposed on a base substrate; wherein the drive structure layer comprises a plurality of repeating units forming a plurality of repeating unit rows and a plurality of repeating unit columns, an insertion column is disposed between adjacent repeating unit columns; at least one repeating unit of the plurality of repeating units comprises a plurality of circuit units disposed sequentially along a first direction, and at least one circuit unit of the plurality of circuit units comprises a pixel drive circuit and a data signal line extending along a second direction, the data signal line is connected with the pixel drive circuit and is configured to supply a data signal to the pixel drive circuit, and the first direction intersects with the second direction; the drive structure layer further comprises at least one first connection line and at least one first constant voltage trace that extend along the first direction, and at least one second connection line and at least one second constant voltage trace that extend along the second direction, a first end of the first connection line is connected with the data signal line, a second end of the first connection line is connected with the second connection line, and at least one second constant voltage trace is connected with at least one first constant voltage trace to form a mesh-like communication structure for transmitting a constant voltage signal; and the second connection line and the second constant voltage trace are disposed in the insertion column.

2. The display substrate according to claim 1, wherein the at least one repeating unit comprises three circuit units.

3. The display substrate according to claim 1, wherein the pixel drive circuit at least comprises: a storage capacitor, a first transistor serving as a first initialization transistor, and a second transistor serving as a compensation transistor, the first transistor at least comprises a first gate electrode and a first active layer, the second transistor at least comprises a second gate electrode and a second active layer, and the storage capacitor comprises a first electrode plate and a second electrode plate, an orthographic projection of the second electrode plate on the base substrate is at least partially overlapped with an orthographic projection of the first electrode plate on the base substrate, the first electrode plate is connected with a second region of the first active layer and a first region of the second active layer, and the second electrode plate is connected with a first power supply line; the at least one circuit unit further comprises a shield electrode connected with the second electrode plate, an orthographic projection of the shield electrode on the base substrate is at least partially overlapped with an orthographic projection of the first active layer between two gate electrodes of the first transistor on the base substrate, and is at least partially overlapped with an orthographic projection of the second active layer between two gate electrodes of the second transistor on the base substrate; and an orthographic projection of the at least one second connection line on the base substrate is at least partially overlapped with the orthographic projection of the shield electrode on the base substrate.

4. The display substrate according to claim 3, wherein the pixel drive circuit further comprises a third transistor serving as a drive transistor and a fourth transistor serving as a data writing transistor, the third transistor at least comprises a third active layer, and the fourth transistor at least comprises a fourth active layer, and a first region of the third active layer is connected with a second region of the fourth active layer; the at least one circuit unit further comprises a compensation electrode connected with the second electrode plate, and an orthographic projection of the compensation electrode on the base substrate is at least partially overlapped with an orthographic projection of a connection region between the first region of the third active layer and the second region of the fourth active layer on the base substrate.

5. The display substrate according to claim 3, wherein the pixel drive circuit further comprises a fourth transistor serving as a data writing transistor, the second gate electrode is connected with a first scan signal line extending along the first direction, a gate electrode of the fourth transistor is connected with a second scan signal line extending along the first direction, a first electrode of the fourth transistor is connected with the data signal line, and the second scan signal line is disposed at a side of the first scan signal line away from the second electrode plate; and in the second direction, the first connection line and the first constant voltage trace are disposed between the first scan signal line and the second electrode plate, or the first connection line and the first constant voltage trace are disposed between the first scan signal line and the second scan signal line.

6. The display substrate according to claim 5, wherein the at least one circuit unit further comprises a data connection electrode, the data signal line is connected with the data connection electrode through a via, and the data connection electrode is connected with the first electrode of the fourth transistor through a via; and the at least one repeating unit further comprises a data connection block, the data connection block is connected with the first connection line and the data connection electrode in one circuit unit, respectively, and the data connection block is disposed at a side of the first scan signal line close to the second electrode plate.

7. The display substrate according to claim 5, wherein the at least one repeating unit further comprises a data connection block connected with the first connection line, the data connection block is connected with the first electrode of the fourth transistor in one circuit unit through a via, the data signal line is connected with the data connection block through a via, and the data connection block is disposed at a side of the first scan signal line away from the second electrode plate.

8. The display substrate according to claim 3, wherein the pixel drive circuit further comprises a fifth transistor serving as a first light emitting control transistor, a gate electrode of the fifth transistor is connected with a light emitting signal line, and a first electrode of the fifth transistor is connected with the first power supply line, the light emitting signal line is disposed at a side of the second electrode plate in the second direction; and in the second direction, the first connection line and the first constant voltage trace are disposed at a side of the light emitting signal line away from the second electrode plate.

9. The display substrate according to claim 1, wherein the display substrate further comprises a light emitting structure layer disposed at a side of the drive structure layer away from the base substrate, and the light emitting structure layer at least comprises a red light emitting unit, a green light emitting unit, and a blue light emitting unit, the red light emitting unit at least comprises a first anode, the green light emitting unit at least comprises a second anode, and the blue light emitting unit at least comprises a third anode; orthographic projections of at least one first anode and at least one second anode on the base substrate are at least partially overlapped with an orthographic projection of the second connection line or the second constant voltage trace on the base substrate, and an orthographic projection of at least one third anode on the base substrate is at least partially overlapped with an orthographic projection of the data signal line on the base substrate.

10. The display substrate according to claim 9, wherein at least one third anode is provided with an anode groove, a shape of the anode groove is a strip portion extending along the second direction, and an orthographic projection of the anode groove on the base substrate is at least partially overlapped with an orthographic projection of the data signal line on the base substrate.

11. The display substrate according to claim 1, wherein at least one insertion column is further provided with at least one constant voltage connection line extending along the second direction; and in the first direction, the constant voltage connection line is disposed between the second connection line and the data signal line, or the constant voltage connection line is disposed between the second constant voltage trace and the data signal line.

12. The display substrate according to claim 11, wherein the at least one circuit unit further comprises a first initial signal line, a second initial signal line, and a third initial signal line that extend along the first direction, and the pixel drive circuit is connected with the first initial signal line, the second initial signal line, and the third initial signal line, respectively, the first initial signal line, the second initial signal line, and the third initial signal line are configured to supply a first initial signal, a second initial signal, and a third initial signal to the pixel drive circuit, respectively; and the at least one constant voltage connection line is connected with the first initial signal line, the second initial signal line, or the third initial signal line.

13. The display substrate according to any one of claims 1 to 12, wherein the display substrate further comprises a light emitting structure layer disposed at a side of the drive structure layer away from the base substrate, the light emitting structure layer comprises a plurality of light emitting units, and at least one light emitting unit of the plurality of light emitting units comprises a light emitting device connected with a second power supply line, the second power supply line is configured to supply a second power supply signal to the light emitting device; the at least one circuit unit further comprises a first initial signal line, a second initial signal line, and a third initial signal line that extend along the first direction, and a first power supply line extending along the second direction, the pixel drive circuit is connected with the first initial signal line, the second initial signal line, the third initial signal line, and the first power supply line respectively, the first initial signal line, the second initial signal line, and the third initial signal line are configured to supply a first initial signal, a second initial signal, and a third initial signal to the pixel drive circuit respectively, and the first power supply line is configured to supply a first power supply signal to the pixel drive circuit; and the second constant voltage trace is connected with any one or more of following: the first initial signal line, the second initial signal line, the third initial signal line, the first power supply line, or the second power supply line.

14. The display substrate according to claim 13, wherein the display substrate is divided into a plurality of sub-regions, the second constant voltage trace in one sub-region of the sub-regions is connected with the first initial signal line, the second constant voltage trace in another sub-region of the sub-regions is connected with the second initial signal line, and the second constant voltage trace in yet another sub-region of the sub-regions is connected with the third initial signal line, simultaneously forming a mesh-like communication structure for transmitting a first initial signal, a mesh-like communication structure for transmitting a second initial signal, and a mesh-like communication structure for transmitting a third initial signal.

15. The display substrate according to claim 13, wherein a plurality of second constant voltage traces are connected with the first initial signal line, the second initial signal line, and the third initial signal line, respectively, and in the first direction, the second constant voltage trace connected with the first initial signal line, the second constant voltage trace connected with the second initial signal line, and the second constant voltage trace connected with the third initial signal line are arranged periodically.

16. The display substrate according to claim 13, wherein a plurality of second constant voltage traces are connected with the first initial signal line, the second initial signal line, the third initial signal line, and the second power supply line respectively, and in the first direction, the second constant voltage trace connected with the first initial signal line, the second constant voltage trace connected with the second power supply line, the second constant voltage trace connected with the second initial signal line, the second constant voltage trace connected with the second power supply line, the second constant voltage trace connected with the third initial signal line, and the second constant voltage trace connected with the second power supply line are arranged periodically.

17. The display substrate according to claim 13, wherein the second constant voltage trace located in a same insertion column as the second connection line is connected with the first power supply line or the second power supply line, and the second constant voltage trace separately disposed in the insertion column is connected with the first initial signal line, the second initial signal line, or the third initial signal line.

18. The display substrate according to claim 13, wherein in a direction perpendicular to the base substrate, the display substrate comprises a plurality of conductive layers, the second constant voltage trace, the first constant voltage trace, and at least one initial signal line are disposed in different conductive layers, one part of second constant voltage traces is connected with the first constant voltage trace, and the other part of the second constant voltage traces is connected with the initial signal line.

19. A display apparatus, comprising a display substrate according to any one of claims 1 to 18.

20. A preparation method of a display substrate, comprising: forming a drive structure layer on a base substrate, wherein
the drive structure layer comprises a plurality of repeating units forming a plurality of repeating unit rows and a plurality of repeating unit columns, and an insertion column is disposed between adjacent repeating unit columns; at least one repeating unit of the plurality of repeating units comprises a plurality of circuit units disposed sequentially along a first direction, and at least one circuit unit of the plurality of circuit units comprises a pixel drive circuit and a data signal line extending along a second direction, the data signal line is connected with the pixel drive circuit and is configured to supply a data signal to the pixel drive circuit, and the first direction intersects with the second direction; the drive structure layer further comprises at least one first connection line and at least one first constant voltage trace that extend along the first direction, and at least one second connection line and at least one second constant voltage trace that extend along the second direction, a first end of the first connection line is connected with the data signal line, a second end of the first connection line is connected with the second connection line, and at least one second constant voltage trace is connected with at least one first constant voltage trace to form a mesh-like communication structure for transmitting a constant voltage signal; and the second connection line and the second constant voltage trace are disposed in the insertion column.
